(19) Europäisches Patentamt
European Patent Office
Office européen des brevets

(11) EP 4 459 006 A1

(12) EUROPEAN PATENT APPLICATION
published in accordance with Art. 153(4) EPC

(43) Date of publication:
**06.11.2024 Bulletin 2024/45**

(21) Application number: **22915902.5**

(22) Date of filing: **22.12.2022**

(51) International Patent Classification (IPC):
***C23C 26/00*** (2006.01) ***B32B 15/04*** (2006.01)
***B32B 15/08*** (2006.01) ***C09D 5/00*** (2006.01)
***C09D 7/61*** (2018.01) ***C09D 7/63*** (2018.01)
***C09D 201/00*** (2006.01) ***H05K 3/38*** (2006.01)

(52) Cooperative Patent Classification (CPC):
**B32B 15/04; B32B 15/08; C09D 5/00; C09D 7/61; C09D 7/63; C09D 201/00; C23C 26/00; H05K 3/38**

(86) International application number:
**PCT/JP2022/047292**

(87) International publication number:
**WO 2023/127679 (06.07.2023 Gazette 2023/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2021 JP 2021214947**
**28.12.2021 JP 2021214973**
**26.07.2022 JP 2022118876**

(71) Applicant: **SHIKOKU CHEMICALS CORPORATION**
**Kagawa 7638504 (JP)**

(72) Inventors:
- **YAMAJI, Noriaki**
  **Ayauta-gun, Kagawa 769-0202 (JP)**
- **TANIOKA, Miya**
  **Ayauta-gun, Kagawa 769-0202 (JP)**
- **KOGA, Tatsuya**
  **Ayauta-gun, Kagawa 769-0202 (JP)**
- **IIDA, Shusaku**
  **Ayauta-gun, Kagawa 769-0202 (JP)**
- **NAGAMORI, Tatsuya**
  **Ayauta-gun, Kagawa 769-0202 (JP)**
- **KATSUMURA, Masato**
  **Ayauta-gun, Kagawa 769-0202 (JP)**

(74) Representative: **Murgitroyd & Company**
**165-169 Scotland Street**
**Glasgow G5 8PL (GB)**

# (54) SURFACE TREATMENT LIQUID FOR METAL

(57) The present invention provides a surface treatment liquid that can form an organic film sufficiently excellent in adhesive properties between metal and resin and is also excellent in chemical resistance properties, the surface treatment liquid being excellent in storage stability. The present invention relates to a metal surface treatment liquid for forming an organic film on a metal surface, wherein the surface treatment liquid contains a silane coupling agent and an acid and has a pH of 1.9 or less.



Processed by Luminess, 75001 PARIS (FR)

## Description

### TECHNICAL FIELD

The present invention relates to a metal surface treatment liquid. The present invention particularly relates to a metal surface treatment liquid that can produce an organic film disposed on a metal surface for improving adhesive properties between metal and resin.

### BACKGROUND ART

In recent years, when a surface of a metal circuit (for example, a copper circuit) of a printed wiring board and an insulating resin layer are brought into close contact with each other, it is required to bring a smooth copper surface and an insulating resin into close contact with each other in order to cope with high-speed transmission. In such a printed wiring board, securing adhesive properties between the metal circuit and the insulating resin layer is becoming an issue.
For this reason, attempts have been made to improve the adhesive properties between the metal circuit and the insulating resin layer with an anchor effect by roughening the metal circuit surface. However, when the adhesive properties between the metal circuit and the insulating resin layer is secured only by such an anchor effect, deterioration of electrical characteristics (transmission loss) is observed due to a skin effect.
Thus, for example, Patent Document 1 describes a film-forming composition for forming a film for improving adhesive properties with a resin on a surface of copper or a copper alloy in a printed wiring board. Specifically, attempts have been made to improve the adhesive properties between copper and a resin by adjusting the type of the silane coupling agent contained in the film-forming composition, the copper ion concentration, the Cu/Si molar ratio, and the pH.
In addition, for example, Patent Document 2 describes a copper surface treatment agent containing a tin compound, a complexing agent, and a silane coupling agent. Specifically, attempts have been made to improve the adhesive properties between a metal and a resin with the surface treatment agent by adding a tin compound or a complexing agent or adjusting the pH of the solution.
Further, for example, Patent Document 3 describes a surface treatment liquid containing a specific silane coupling agent, a specific organic acid ion, an inorganic acid ion, an alkali metal ion and/or an ammonium ion, and a copper ion. Specifically, attempts have been made to improve the adhesive properties between a metal and a resin by including the above-described components in combination in the surface treatment liquid.

### PRIOR ART DOCUMENTS

### PATENT DOCUMENTS

Patent Document 1: JP-B-6779557
Patent Document 2: WO 2009/110364 A1
Patent Document 3: WO 2021/045055 A1

### SUMMARY OF THE INVENTION

### PROBLEMS TO BE SOLVED BY THE INVENTION

The inventors of the present invention have found that adhesive properties between a metal and a resin cannot be sufficiently obtained yet by the conventional technique as described above. For example, when a resin layer was formed on the surface of an organic film and the resin was thermally cured, or when a HAST treatment (high temperature and high humidity treatment) was further performed after thermal curing, the adhesive properties between the metal and the resin was not sufficient. The inventors of the present invention have also found that the chemical resistance properties of an organic film when a resin layer formed on a metal with an organic film interposed therebetween is immersed in a chemical (for example, a basic solution, an acidic solution, or an organic solvent) are not sufficient. Specifically, when the organic film is dissolved in a chemical, a space may be observed between the metal and the resin, and/or peeling may be observed at an adhesion portion between the metal and the resin. Further, it has also been found that, for example, when a surface treatment liquid is left to stand during or after preparation of the surface treatment liquid, a precipitate is generated in the surface treatment liquid, and an organic film having a sufficient film thickness cannot be obtained.
In the present specification, the term "adhesive properties" refers to properties that a metal and a resin (layer)

adhere to each other with sufficiently high strength even when the resin (layer) is subjected to a thermal curing treatment or a HAST treatment after a thermal curing treatment on a surface of an organic film formed on a metal surface.

The "chemical resistance properties" refer to properties that an organic film is hardly dissolved even when it comes into contact with a basic solution (in particular, a strongly basic solution such as a desmear solution), an acidic solution, or an organic solvent.

The "storage stability" refers to a property that it is difficult to generate a precipitate due to the silane coupling agent in the surface treatment liquid even when the surface treatment liquid is stored after being prepared.

An object of the present invention is to provide a surface treatment liquid that can form an organic film sufficiently excellent in adhesive properties between metal and resin and is also excellent in chemical resistance properties, the surface treatment liquid being excellent in storage stability.

In detail, an object of the present invention is to provide a surface treatment liquid that can form an organic film capable of sufficiently obtaining adhesive properties between metal and resin even after full curing of a resin or even after HAST (high temperature and high humidity treatment) on an adhesion structure of metal and resin, and that is excellent in chemical resistance properties to a basic solution (in particular, a strongly basic solution such as a desmear solution), an acidic solution, or an organic solvent, the surface treatment liquid being excellent in storage stability.

## SOLUTIONS TO THE PROBLEMS

The present invention relates to a metal surface treatment liquid for forming an organic film on a metal surface, wherein the metal surface treatment liquid contains a silane coupling agent and an acid and has a pH of 1.9 or less.

## EFFECTS OF THE INVENTION

The metal surface treatment liquid according to the present invention can form an organic film that is sufficiently excellent in adhesive properties between metal and resin and is also excellent in chemical resistance properties.

The surface treatment liquid of the present invention is excellent in storage stability.

## BRIEF DESCRIPTION OF THE DRAWINGS

Fig. 1 is a schematic cross-sectional view of an example of an organic film produced using a metal surface treatment liquid of the present invention.

Fig. 2 is a schematic cross-sectional view of an example of the organic film produced using the metal surface treatment liquid of the present invention, which is a partially enlarged view showing the vicinity of a protrusion in an enlarged manner.

Fig. 3A is a micrograph (SEM photograph) based on a cross-sectional view of a test piece in Example 1, which is an example of an SEM photograph (secondary electron image) showing protrusions of an organic film on a surface opposite to a metal.

Fig. 3B is a micrograph (SEM photograph) based on a plan view of the test piece in Example 1, which is an example (30,000 times) of an SEM photograph (secondary electron image) showing protrusions of an organic film on a surface opposite to a metal.

Fig. 3C is a micrograph (SEM photograph) based on a plan view of the test piece in Example 1, which is an example (5,000 times) of an SEM photograph (secondary electron image) showing protrusions of an organic film on a surface opposite to a metal.

Fig. 3D is a micrograph (SEM photograph) based on a plan view of the test piece in Example 1, which is an example (5,000 times) of an SEM photograph (reflected electron image) showing protrusions of an organic film on a surface opposite to a metal.

Fig. 4A is a micrograph (SEM photograph) based on a cross-sectional view of a test piece in Example 2, which is an example of an SEM photograph (secondary electron image) showing protrusions of an organic film on a surface opposite to a metal.

Fig. 4B is a micrograph (SEM photograph) based on a plan view of the test piece in Example 2, which is an example (50,000 times) of an SEM photograph (secondary electron image) showing protrusions of an organic film on a surface opposite to a metal.

Fig. 4C is a micrograph (SEM photograph) based on a plan view of the test piece in Example 2, which is an example (30,000 times) of an SEM photograph (secondary electron image) showing protrusions of an organic film on a surface opposite to a metal.

Fig. 4D is a micrograph (SEM photograph) based on a plan view of the test piece in Example 2, which is an example

(5,000 times) of an SEM photograph (secondary electron image) showing protrusions of an organic film on a surface opposite to a metal.

Fig. 4E is a micrograph (SEM photograph) based on a plan view of the test piece in Example 2, which is an example (5,000 times) of an SEM photograph (reflected electron image) showing protrusions of an organic film on a surface opposite to a metal.

DETAILED DESCRIPTION

[Metal Surface Treatment Liquid]

The metal surface treatment liquid according to the present invention is a metal surface treatment liquid for forming an organic film on a metal surface, and the surface treatment liquid is an aqueous solution containing a silane coupling agent and an acid and having a pH of 1.9 or less. Bringing such a surface treatment liquid into contact with the surface of the metal causes the silane coupling agent to be precipitated and aggregated on the surface of the metal, and as a result, an organic film having protrusions is formed. Thus, the organic film is formed of a precipitate or aggregate containing the silane coupling agent, and contributes to improvement of adhesive properties between metal and resin. When the pH of the surface treatment liquid is more than 1.9, an organic film having protrusions cannot be obtained.

The pH of the surface treatment liquid is 1.9 or less (in particular, -1.0 or more and 1.9 or less), and is, for example, a range obtained by combining a range of - 1.0 or more and less than 1.0 (hereinafter, may be referred to as a "range A") and a range of 1.0 or more and 1.9 or less (hereinafter, may be referred to as a "range B"). "Less than 1.0" means a numerical range smaller than 1.0 without including 1.0. The pH of the surface treatment liquid is preferably -1.0 or more and 1.5 or less, more preferably in the range A, still more preferably -0.7 or more and less than 1.0, particularly preferably -0.7 or more and 0.55 or less, sufficiently preferably -0.5 or more and 0.5 or less, more sufficiently preferably -0.4 or more and 0.5 or less, and most preferably -0.35 or more and -0.05 or less from the viewpoint of further improving the adhesive properties between metal and resin, chemical resistance properties, storage stability, and forming property of the protrusion. The pH range "-1.0 or more and 1.5 or less" is a range obtained by combining a range of -1.0 or more and less than 1.0 (that is, the "range A") and a range of 1.0 or more and 1.5 or less (hereinafter, may be referred to as a "range B'").

A preferred embodiment when the surface treatment liquid contains tosylic acid or sulfuric acid described later is as follows:

For example, when the surface treatment liquid contains tosylic acid (in particular, only tosylic acid) as the acid, the pH of the surface treatment liquid is preferably -1.0 or more, more preferably -0.5 or more, still more preferably -0.4 or more, particularly preferably -0.2 or more, sufficiently preferably -0.1 or more, and most preferably 0.1 or more from the viewpoint of further improving the adhesive properties between metal and resin, chemical resistance properties, and storage stability. The upper limit of the pH in this case is usually 1.9, and the pH is preferably 1.5 or less, more preferably less than 1.0, still more preferably 0.6 or less, particularly preferably 0.55 or less, sufficiently preferably 0.48 or less, and more sufficiently preferably 0.42 or less from the viewpoint of further improving the adhesive properties between metal and resin, the chemical resistance properties, and the storage stability.

For example, when the surface treatment liquid contains sulfuric acid (in particular, only sulfuric acid) as an acid, the pH of the surface treatment liquid is preferably -1.0 or more, more preferably -0.8 or more, and still more preferably -0.4 or more from the viewpoint of further improving the adhesive properties between metal and resin, chemical resistance properties, and storage stability. The upper limit of the pH in this case is usually 1.9, and the pH is preferably 1.5 or less, more preferably less than 1.0, still more preferably 0.9 or less, particularly preferably 0.6 or less, sufficiently preferably 0.2 or less, and more sufficiently preferably -0.15 or less from the viewpoint of further improving the adhesive properties between metal and resin, chemical resistance properties, and storage stability.

The pH of the surface treatment liquid can be controlled by adjusting the type and content of the acid and the base.

In the present specification, as the pH, a value measured by a pH meter (HM-30R manufactured by DKK-TOA CORPORATION) is used. When the pH of the surface treatment liquid was measured, a pH meter was calibrated at 20°C ± 0.2°C using three types of pH standard solutions (pH 1.68 standard solution, pH 4.01 standard solution, pH 6.86 standard solution) in advance. The pH of the surface treatment liquid was measured at 20°C ± 0.2°C.

The metal to be subjected to the surface treatment using the surface treatment liquid of the present invention not particularly limited, and examples thereof include copper, aluminum, titanium, nickel, tin, iron, silver, gold, and alloys thereof. Examples of the alloy are not particularly limited as long as it is an alloy containing copper, and examples thereof include alloys of Cu-Ag type, Cu-Te type, Cu-Mg type, Cu-Sn type, Cu-Si type, Cu-Mn type, Cu-Be-Co type, Cu-Ti type, Cu-Ni-Si type, Cu-Zn-Ni type, Cu-Cr type, Cu-Zr type, Cu-Fe type, Cu-Al type, Cu-Zn type, Cu-Co type, and Cu-Fe-P type (KFC material). Examples of other alloys include an aluminum alloy (Al-Si alloy), a nickel alloy (Ni-Cr alloy), and an iron alloy (Fe-Ni alloy, stainless steel, steel). Among these metals, copper and a copper alloy are preferable. The metal may in particular be a metal circuit (in particular, a copper circuit) of a printed wiring board.

The metal is usually also referred to as a "metal substrate", and it may have any shape.

The surface roughness of the surface of the metal to be in contact with the surface treatment liquid of the present invention is not particularly limited. For example, Ra (arithmetic average roughness) may be 0.20 μm or less, and is preferably 0.10 μm or less, and more preferably 0.05 μm or less from the viewpoint of preventing deterioration (transmission loss) of electrical characteristics due to the skin effect of metal. In addition, for example, Rz (maximum height roughness) may be 1.00 μm or less, and is preferably 0.50 μm or less, and more preferably 0.20 μm or less, from the viewpoint of preventing deterioration (transmission loss) of electrical characteristics due to the skin effect of metal.

As the surface roughness (Ra and Rz) of the metal surface, an average value of values measured at any five points by the following method is used.

Apparatus: Laser microscope VK-8710 (manufactured by KEYENCE CORPORATION)
Conditions: Cutoff wavelength: 0.8 mm, magnification: 1000 times

The range of the surface roughness (plane roughness) represented by the parameter of the surface property based on ISO 25178 of the metal to be in contact with the surface treatment liquid of the present invention is not particularly limited. The following parameters related to the surface roughness of the metal 1 are each usually within the following ranges.

- Sa (arithmetic average height) may be 0.16 μm or less, and is preferably 0.08 μm or less, and more preferably 0.04 μm or less from a viewpoint of preventing deterioration (transmission loss) of electrical characteristics due to the skin effect of metal. Sa is usually 0.001 μm or more.
- Sq (root mean square height) may be 0.2 μm or less, and is preferably 0.1 μm or less, and more preferably 0.05 μm or less from a viewpoint of preventing deterioration (transmission loss) of electrical characteristics due to the skin effect of metal. Sq is usually 0.001 μm or more.
- Sz (maximum height) may be preferably 2 μm or less, and is preferably 1 μm or less, and more preferably 0.2 μm or less, from the viewpoint of preventing deterioration of electrical characteristics (transmission loss) due to the skin effect of metal. Sz is usually 0.01 μm or more.
- Sp (maximum peak height) may be preferably 1.5 μm or less, and is preferably 0.7 μm or less, and more preferably 0.1 μm or less, from the viewpoint of preventing deterioration of electrical characteristics (transmission loss) due to the skin effect of metal. Sp is usually 0.01 μm or more.
- Sv (maximum valley depth) may be preferably 1.5 μm or less, and is preferably 0.7 μm or less, and more preferably 0.1 μm or less, from the viewpoint of preventing deterioration of electrical characteristics (transmission loss) due to the skin effect of metal. Sv is usually 0.01 μm or more.
- Ssk (skewness (tendentiousness degree)) is preferably -0.5 or more and 0.5 or less, and is preferably -0.3 or more and 0.3 or less, and more preferably -0.2 or more and 0.2 or less from the viewpoint of preventing deterioration (transmission loss) of electrical characteristics due to the skin effect of metal.
- Sku (kurtosis (sharpening degree)) is preferably 2 or more and 10 or less, and more preferably 2.5 or more and 8 or less.
- Sal (minimum autocorrelation length (s = 0.2)) is preferably 0.2 μm or more and 10 μm or less, more preferably 0.3 μm or more and 5 μm or less, and still more preferably 0.5 μm or more and 3 μm or less.
- Str (aspect ratio of surface shape (s = 0.2)) is preferably 0.4 or more and 1 or less, and more preferably 0.5 or more and 1 or less.
- Std (direction of the surface shape) is preferably an unbiased distribution.
- Sdq (root mean square slope) may be 0.5 μm or less, and is preferably 0.2 μm or less, and more preferably 0.05 μm or less from a viewpoint of preventing deterioration (transmission loss) of electrical characteristics due to the skin effect of metal. Sdq is usually 0.01 μm or more.
- Sdr (developed area ratio of the interface) may be 0.5 μm or less, and is preferably 0.2 μm or less, and more preferably 0.05 μm or less from a viewpoint of preventing deterioration (transmission loss) of electrical characteristics due to the skin effect of a metal. Sdr is usually 0.0001 μm or more.
- Sk (level difference of the core part) may be preferably 0.5 μm or less, and is preferably 0.2 μm or less, and more preferably 0.1 μm or less from a viewpoint of preventing deterioration (transmission loss) of electrical characteristics due to the skin effect of metal. Sk is usually 0.01 μm or more.
- Spk (protruding mountain portion height) may be preferably 0.3 μm or less, and is preferably 0.1 μm or less, and more preferably 0.05 μm or less, from the viewpoint of preventing deterioration of electrical characteristics (transmission loss) due to the skin effect of the metal. Spk is usually 0.001 μm or more.
- Svk (protrusion valley height) may be preferably 0.3 μm or less, and is preferably 0.1 μm or less, and more preferably 0.05 μm or less from a viewpoint of preventing deterioration (transmission loss) of electrical characteristics due to the skin effect of metal. Svk is usually 0.001 μm or more.

- Smr1 (load area ratio for separating the protruding mountain portion and the core portion) is preferably 5% or more and 20% or less, and more preferably 7% or more and 15% or less.
- Smr2 (load area ratio for separating the protrusion valley and the core portion) is preferably 80% or more and 95% or less, and more preferably 85% or more and 93% or less.
- Sxp (extreme point height (difference in height between 2.5% loading area ratio and 50% loading area ratio)) is preferably 0.002 μm or more and 10 μm or less, more preferably 0.005 μm or more and 5 μm or less, and still more preferably 0.010 μm or more and 3 μm or less.
- Vvv (the void volume of the valley portion) may be preferably 20 μL/m$^2$ or less, and is more preferably 15 μL/m$^2$ or less, still more preferably 2 μL/m$^2$ or less from the viewpoint of preventing deterioration in electrical characteristics (transmission loss) due to the skin effect of metal. Vvv is usually 0.1 μL/m$^2$ or more.
- Vvc (void volume of the core portion) may be preferably 300 μL/m$^2$ or less, and is more preferably 50 μL/m$^2$ or less, still more preferably 20 μL/m$^2$ or less from the viewpoint of preventing deterioration (transmission loss) of electrical characteristics due to the skin effect of metal. Vvc is usually 1 μL/m$^2$ or more.
- The Vmp (actual volume of the mountain portion) may be preferably 10 μL/m$^2$ or less, and is more preferably 3 μL/m$^2$ or less, still more preferably 1 μL/m$^2$ or less from the viewpoint of preventing deterioration in electrical characteristics (transmission loss) due to the skin effect of metal. Vmp is usually 0.1 μL/m$^2$ or more.
- Vmc (actual volume of the core portion) may be preferably 200 μL/m$^2$ or less, and is more preferably 100 μL/m$^2$ or less, still more preferably 20 μL/m$^2$ or less from the viewpoint of preventing deterioration in electrical characteristics (transmission loss) due to the skin effect of metal. Vmc is usually 1 μL/m$^2$ or more.
- Spd (peak density of mountain (mountains higher than 5% of the maximum amplitude are counted)) may be preferably $5 \times 10^6$/mm$^2$ or less, and is preferably $4 \times 10^6$/mm$^2$ or less, and more preferably $3.5 \times 10^6$/mm$^2$ or less, from the viewpoint of preventing deterioration of electrical characteristics (transmission loss) due to the skin effect of metal. Spd is usually $0.5 \times 10^6$/mm$^2$ or more.
- Spc (arithmetic mean curvature of mountain peak (only curvature of mountain peak higher than 5% of the maximum amplitude)) may be preferably $20 \times 10^3$/m or less, and is preferably $10 \times 10^3$/m or less, and more preferably $5 \times 10^3$/m or less, from the viewpoint of preventing deterioration of electrical characteristics (transmission loss) due to the skin effect of metal. Spc is usually $0.1 \times 10^3$/m or more.

As the parameter of the surface roughness (plane roughness) of the metal, that is, the parameter related to the surface roughness, an average value measured at any five points by the following method is used.

Apparatus: Laser microscope VK-X3000 (manufactured by KEYENCE CORPORATION)
Measurement magnification: Objective lens 50 times/zoom 3 times
Measurement area: 6800 μm$^2$
Surface filter treatment: Surface filter treatment with a Gaussian filter and an L filter (cutoff wavelength: 0.01 mm) was performed as necessary for noise removal and base copper surface shape removal, and the surface roughness was measured.

<Silane Coupling Agent>

The silane coupling agent is an organic silane compound having a silyl group containing at least one hydroxyl group or alkoxy group. Such a silane coupling agent is preferably a silane coupling agent containing a nitrogen atom in the molecule from the viewpoint of further improving the adhesive properties between metal and resin (in particular, the adhesive properties between metal and the organic film), chemical resistance properties, and storage stability. In the silane coupling agent containing a nitrogen atom in the molecule, the nitrogen atom is contained in at least one of a substituent and a heterocyclic skeleton. Specifically, in such a silane coupling agent, the nitrogen atom may be contained only in the substituent (for example, an amino group), may be contained only in the heterocyclic skeleton, or may be contained in both the substituent (for example, an amino group) and the heterocyclic skeleton. From the viewpoint of further improving the adhesive properties between the metal and the resin (in particular, the adhesive properties between the metal and the organic film), the nitrogen atom is preferably contained in at least the heterocyclic skeleton, and more preferably contained in both the substituent (for example, an amino group) and the heterocyclic skeleton.

Examples of the substituent containing a nitrogen atom include an amino group, an amide group, a cyano group, a nitro group, an azo group, a diazo group, a carbamide group, a ureido group, an azido group, and a guanidino group. Examples of the amino group include an unsubstituted amino group, a monosubstituted amino group, and a disubstituted amino group. Examples of the unsubstituted amino group include - $NH_2$. Examples of the mono-substituted amino group include a methylamino group, an ethylamino group, an n-propylamino group, an n-aminohexylamino group, a 2-aminoethylamino group, and a phenylamino group. Examples of the disubstituted amino group include a dimethylamino group, a diethylamino group, an ethylmethylamino group, and a diphenylamino group. The substituent containing

a nitrogen atom is preferably an amino group, more preferably an unsubstituted amino group or a monosubstituted amino group, and still more preferably an unsubstituted amino group, from the viewpoint of further improving the adhesive properties between the metal and the resin (in particular, adhesive properties between the metal and the organic film).

Examples of the heterocyclic skeleton containing a nitrogen atom include monocyclic rings such as pyrrole, pyrazole, diazole (imidazole), triazole, tetrazole, oxazole, oxadiazole, isoxazole, thiazole, isothiazole, furazan, pyridine, pyridazine, pyrimidine, pyrazine, triazine, tetrazine, pentazine, azepine, diazepine, and triazepine; fused bicyclic rings such as indole, isoindole, thienoindole, indazole, purine, quinoline, isoquinoline, benzodiazole, and benzotriazole; fused tricyclic rings such as carbazole, acridine, β-carboline, acridone, perimidine, phenazine, phenanthridine, phenothiazine, phenoxazine, and phenanthroline. The heterocyclic skeleton containing a nitrogen atom is preferably an aromatic ring, more preferably diazole, triazole, tetrazole, benzotriazole, or triazine, still more preferably triazole, benzotriazole, or tetrazole, particularly preferably benzotriazole or tetrazole.

Examples of the silane coupling agent in which a nitrogen atom is contained only in a substituent (for example, an amino group) include 3-aminopropyldimethylmethoxysilane, 3-aminopropyldimethoxymethylsilane, 3-aminopropylmethyldiethoxysilane, 3-aminopropyltrimethoxysilane, 3-aminopropyltriethoxysilane, 3-(2-aminoethylamino)propylmethyldimethoxysilane, 3-(2-aminoethylamino)propylmethyldiethoxysilane, 3-(2-aminoethylamino)propyltrimethoxysilane, 3-(2-aminoethylamino)propyltriethoxysilane, 3 - [2-(2-aminoethylamino)ethylamino]propyltrimethoxysilane, [3 -(6-aminohexylamino)propyl]trimethoxysilane, bis[3-(trimethoxysilyl) propyl]amine, and bis[3-(triethoxysilyl)propyl]amine.

Examples of the silane coupling agent containing a nitrogen atom in at least a heterocyclic skeleton include an azole silane coupling agent and a triazine silane coupling agent. In the present invention, the silane coupling agent preferably contains an azole silane coupling agent, more preferably one or more azolesilane compounds selected from the group consisting of a triazolesilane compound and a tetrazolesilane compound, and still more preferably a tetrazolesilane compound, from the viewpoint of further improving the adhesive properties between metal and resin, chemical resistance properties, and storage stability.

Examples of the silane coupling agent in which a nitrogen atom is contained in both a substituent (for example, an amino group) and a heterocyclic skeleton include an amino group-containing azole silane coupling agent and an amino group-containing triazine silane coupling agent.

The azole silane coupling agent is one or more azole silane compounds selected from the group consisting of a monoazole silane compound, a diazole silane compound, a triazole silane compound, and a tetrazole silane compound. In the present invention, from the viewpoint of further improving the adhesive properties between metal and resin, chemical resistance properties, and storage stability, the azole silane coupling agent preferably contains one or more azole silane compounds selected from the group consisting of a triazole silane compound and a tetrazole silane compound, and more preferably contains a tetrazole silane compound.

(Triazolesilane Compound)

The triazolesilane compound is a compound having one silyl group-containing alkyl group (for example, a $-(CH_2)_m-Si(OR)_{3-n}(OH)_n$ group in General Formula (Ia) described later) in one molecule as a substituent in a heterocyclic 5-membered ring compound containing three nitrogen atoms (that is, a triazole compound). The atom to which the silyl group-containing alkyl group is bonded is an atom constituting a triazole ring, and may be, for example, a nitrogen atom or a carbon atom. The atom to which the silyl group-containing alkyl group is bonded is preferably a nitrogen atom from the viewpoint of further improving the adhesive properties between metal and resin, chemical resistance properties, and storage stability. The triazole ring constituting the triazolesilane compound may be a 1,2,4-triazole ring or a 1,2,3-triazole ring. The triazole ring is preferably a 1,2,4-triazole ring from the viewpoint of further improving the adhesive properties between metal and resin, chemical resistance properties, and storage stability.

Examples of the triazolesilane compound include triazolesilane compounds represented by General Formulas (Ia) and (Ib). The compounds represented by General Formulas (Ia) and (Ib) may be referred to as a triazolesilane compound (Ia) and a triazolesilane compound (Ib), respectively.

[Chemical Formula 1]

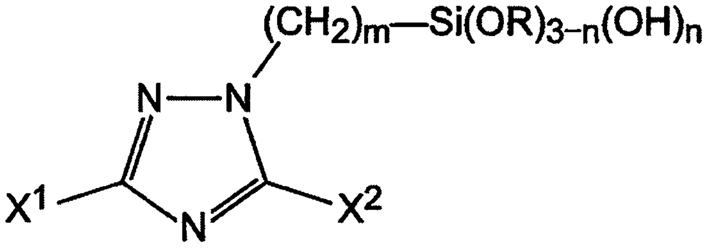

(Ia)

In Formula (Ia), $X^1$ and $X^2$ each independently represent a hydrogen atom, a linear or branched alkyl group having 1 to 12 carbon atoms, a phenyl group, a benzyl group, an amino group, or an alkylthio group having 1 to 6 carbon atoms. Examples of the alkyl group include a methyl group, an ethyl group, a n-propyl group, an isopropyl group, a n-butyl group, an isobutyl group, a sec-butyl group, a tert-butyl group, an n-pentyl group, an n-hexyl group, an n-heptyl group, an n-octyl group, an n-nonyl group, an n-decyl group, an n-undecyl group, and an n-dodecyl group. Examples of the alkylthio group include a methylthio group, an ethylthio group, an n-propylthio group, an isopropylthio group, an n-butylthio group, an isobutylthio group, a sec-butylthio group, a tert-butylthio group, an n-pentylthio group, and an n-hexylthio group. $X^1$ and $X^2$ may be the same or different and are preferably the same. $X^1$ and $X^2$ each independently preferably represent a hydrogen atom, a linear or branched alkyl group having 1 to 12 carbon atoms (in particular, a linear or branched alkyl group having 1 to 8 carbon atoms), a phenyl group, or an amino group, more preferably represent a hydrogen atom, a linear or branched alkyl group having 1 to 5 carbon atoms, or an amino group, and still more preferably represent an amino group, from the viewpoint of further improving the adhesive properties between metal and resin, chemical resistance properties, and storage stability.

In Formula (Ia), m represents an integer of 1 to 12. From the viewpoint of improving the solubility of the azolesilane compound and further improving the adhesive properties between metal and resin, chemical resistance properties, and storage stability, m represents an integer of preferably 1 to 10, more preferably 1 to 5, and still more preferably 2 to 5.

In Formula (Ia), n represents an integer of 0 to 3.

In Formula (Ia), R represents a methyl group or an ethyl group. R preferably represents an ethyl group from the viewpoint of improving the working environment.

The triazolesilane compound (Ia) in which at least one of $X^1$ and $X^2$ is an amino group in Formula (Ia) is included in the amino group-containing azole silane coupling agent. At this time, m, n, and R are the same as m, n, and R in Formula (Ia), respectively. When one of $X^1$ or $X^2$ is an amino group, the other group may be selected from groups within similar ranges as $X^1$ and $X^2$ in Formula (Ia).

[Chemical Formula 2]

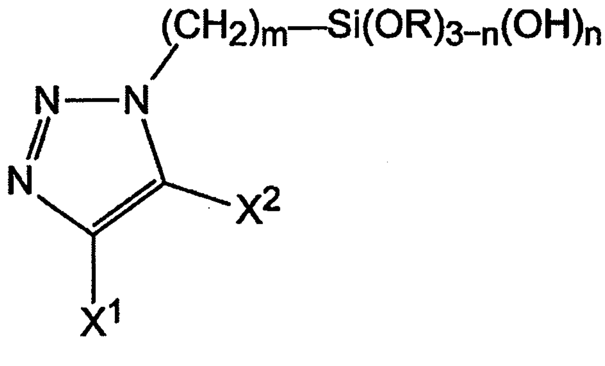

(Ib)

In Formula (Ib), $X^1$, $X^2$, m, n, and R are the same as $X^1$, $X^2$, m, n, and R in Formula (Ia), respectively.

In Formula (Ib), $X^1$ and $X^2$ each independently preferably represent a hydrogen atom, a linear or branched alkyl group having 1 to 12 carbon atoms (in particular, a linear or branched alkyl group having 1 to 8 carbon atoms), a phenyl group, or an amino group, more preferably represent a hydrogen atom, a linear or branched alkyl group having 1 to 5 carbon atoms, or an amino group, and still more preferably represent an amino group, from the viewpoint of further improving the adhesive properties between metal and resin, chemical resistance properties, and storage stability. In particular, when both $X^1$ and $X^2$ are an alkyl group in Formula (Ib), $X^1$ and $X^2$ may be bonded to each other to form a carbocyclic ring having 6 to 10 carbon atoms (in particular, a benzene ring or a naphthalene ring (preferably a benzene

ring)) that is condensed with the triazole ring in Formula (Ib). The number of carbon atoms of the carbocyclic ring also includes the number of carbon atoms shared with the triazole ring condensed with the carbocyclic ring.

In Formula (Ib), m represents an integer of preferably 1 to 10, more preferably 1 to 5, and still more preferably 2 to 5 from the viewpoint of improving the solubility of the azolesilane compound and further improving the adhesive properties between metal and resin, chemical resistance properties, and storage stability.

In Formula (Ib), n represents an integer of 0 to 3.

In Formula (Ib), R represents a methyl group or an ethyl group. R preferably represents an ethyl group from the viewpoint of improving the working environment.

In Formula (Ib), the silyl group-containing alkyl group (that is, $-(CH_2)_m-Si(OR)_{3-n}(OH)_n$) is bonded to the nitrogen atom at the 1-position, but may be bonded to the nitrogen atom at the 2-position. Specifically, the triazolesilane compound (Ib) represented by General Formula (Ib) includes a triazolesilane compound in which a silyl group-containing alkyl group is bonded to a nitrogen atom at the 2-position instead of the nitrogen atom at the 1-position in General Formula (Ib). Hereinafter, regarding Formula (Ib), the triazolesilane compounds in which the silyl group-containing alkyl group is bonded to the nitrogen atom at the 1-position or the 2-position are referred to as "triazolesilane compound (Ib) 1-position conjugate" or "triazolesilane compound (Ib) 2-position conjugate", respectively.

The triazolesilane compound (Ib) in which at least one of $X^1$ and $X^2$ is an amino group in Formula (Ib) is included in the amino group-containing azole silane coupling agent. At this time, m, n, and R are the same as m, n, and R in Formula (Ib), respectively. When one of $X^1$ or $X^2$ is an amino group, the other group may be selected from groups within similar ranges as $X^1$ and $X^2$ in Formula (Ib).

The triazolesilane compound (Ia) includes triazolesilane compounds represented by General Formulas (Ia-1) to (Ia-4). The compounds represented by General Formulas (Ia-1) to (Ia-4) may be referred to as a triazolesilane compound (Ia-1), a triazolesilane compound (Ia-2), a triazolesilane compound (Ia-3), and a triazolesilane compound (Ia-4), respectively.

[Chemical Formula 3]

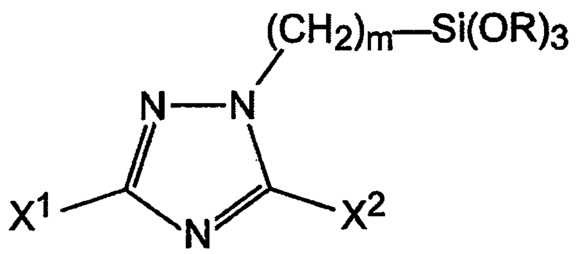

(Ia-1)

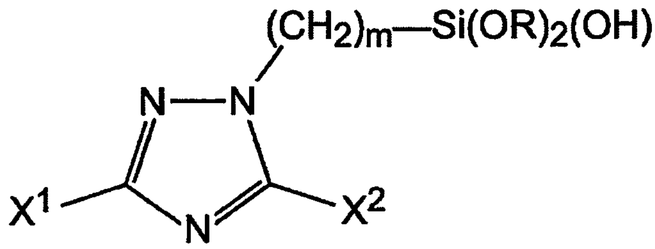

(Ia-2)

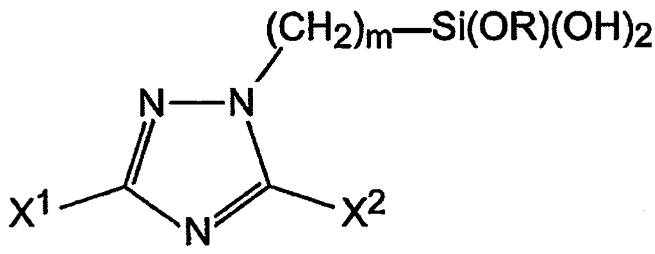

(Ia-3)

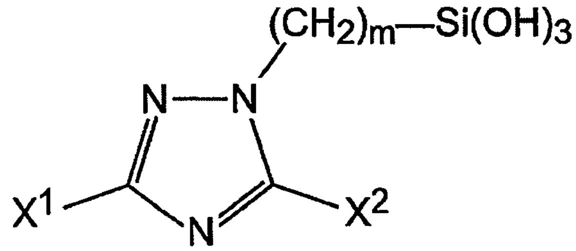

(Ia-4)

In Formulas (Ia-1) to (Ia-4), $X^1$, $X^2$, m, and R are the same as $X^1$, $X^2$, m, and R in Formula (Ia), respectively. Preferred $X^1$, $X^2$, m, and R in Formulas (Ia-1) to (Ia-4) are also the same as preferred $X^1$, $X^2$, m, and R in Formula (Ia), respectively.

The triazolesilane compounds (Ia-1) to (Ia-4) in which at least one of $X^1$ and $X^2$ is an amino group in Formulas (Ia-1) to (Ia-4) are included in the amino group-containing azole silane coupling agent. At this time, m and R are the same as m and R in Formulas (Ia-1) to (Ia-4), respectively. When one of $X^1$ or $X^2$ is an amino group, the other group may be selected from groups within similar ranges as $X^1$ and $X^2$ in Formulas (Ia-1) to (Ia-4).

The triazolesilane compound (Ia-1) is a triazolesilane compound (trialkoxy form) when n is 0 in General Formula (Ia).

Similarly, the triazole silane compound (Ia-2) is a triazole silane compound when n is 1, the triazole silane compound (Ia-3) is a triazole silane compound when n is 2, and the triazole silane compound (Ia-4) is a triazole silane compound when n is 3.

Examples of the triazolesilane compound (Ia) include triazolesilane compounds (Ia-1) exemplified below, and triazolesilane compounds (Ia-2) to (Ia-4) obtained by hydrolyzing (or converting) one to three alkoxy groups (for example, a methoxy group and/or an ethoxy group) to a hydroxyl group in the triazolesilane compound (Ia-1):

1-[3-(trimethoxysilyl)propyl]-1,2,4-triazole,
1-[3-(triethoxysilyl)propyl]-1,2,4-triazole,
3-methyl-1-[2-(triethoxysilyl)ethyl]-1,2,4-triazole,
5-methyl-1-[4-(trimethoxysilyl)butyl]-1,2,4-triazole,
3-ethyl-1-[3-(trimethoxysilyl)propyl]-1,2,4-triazole,
3-propyl-1-[3-(trimethoxysilyl)propyl]-1,2,4-triazole,
3-isopropyl-1-[10-(trimethoxysilyl)decyl]-1,2,4-triazole,
3-butyl-1-[3-(trimethoxysilyl)propyl]-1,2,4-triazole,
3-hexyl-1-[3-(trimethoxysilyl)propyl]-1,2,4-triazole,
5-methyl-3-octyl-1-[3-(trimethoxysilyl)propyl]-1,2,4-triazole,
3-dodecyl-1-[6-(triethoxysilyl)hexyl]-1,2,4-triazole,
3,5-dimethyl-1-[3-(trimethoxysilyl)propyl]-1,2,4-triazole,
3,5-diisopropyl-1-[3-(triethoxysilyl)propyl]-1,2,4-triazole,
3-phenyl-1-[3-(trimethoxysilyl)propyl]-1,2,4-triazole,
3-methyl-5-phenyl-1-[3-(trimethoxysilyl)propyl]-1,2,4-triazole,
3-ethyl-5-phenyl-1-[3-(trimethoxysilyl)propyl]-1,2,4-triazole,
3,5-diphenyl-1-[3-(triethoxysilyl)propyl]-1,2,4-triazole,
3-benzyl-1-[4-(triethoxysilyl)butyl]-1,2,4-triazole,
3-benzyl-5-phenyl-1-[3-(triethoxysilyl)propyl]-1,2,4-triazole,
3-hexylthio-1-[3-(triethoxysilyl)propyl]-1,2,4-triazole,
3-benzyl-5-propyl-1 - [6-(triethoxysilyl)hexyl]-1 ,2,4-triazole,
3-amino-1-(triethoxysilyl)methyl-1,2,4-triazole,
3-amino-1-[2-(trimethoxysilyl)ethyl]-1,2,4-triazole,
3-amino-1-[3-(trimethoxysilyl)propyl]-1,2,4-triazole,
5 -amino-1 - [3 -(triethoxysilyl)propyl] -1,2,4-triazole,
5-amino-3 -ethyl-1-[6-(trimethoxysilyl)hexyl]-1,2,4-triazole,
3-amino-5-phenyl-1-[3-(triethoxysilyl)propyl]-1,2,4-triazole,
3-amino-5-benzyl-1-[3-(triethoxysilyl)propyl]-1,2,4-triazole,
3-amino-1-[6-(trimethoxysilyl)hexyl]-1,2,4-triazole,
3-amino-1- [6-(triethoxysilyl)hexyl]-1 ,2,4-triazole,
3-amino-1-[12-(trimethoxysilyl)dodecyl]-1,2,4-triazole,

3,5-diamino-1-[1-(trimethoxysilyl)methyl]-1,2,4-triazole,
3,5-diamino-1-[1-(triethoxysilyl)methyl]-1,2,4-triazole,
3,5-diamino-1-[3-(trimethoxysilyl)propyl]-1,2,4-triazole,
3,5-diamino-1 - [3-(triethoxysilyl)propyl]-1 ,2,4-triazole,
3,5-diamino-1-[6-(trimethoxysilyl)hexyl]-1,2,4-triazole,
3,5-diamino-1-[12-(trimethoxysilyl)dodecyl]-1,2,4-triazole,
3-methylthio-1-[3-(trimethoxysilyl)propyl]-1,2,4-triazole,
3-isopropylthio-1-[3-(trimethoxysilyl)propyl]-1,2,4-triazole,
3-hexylthio-1-[10-(triethoxysilyl)decyl]-1,2,4-triazole,
3-ethylthio-5-isopropyl-1-[3-(triethoxysilyl)propyl]-1,2,4-triazole,
3,5-bis(methylthio)-1-[3-(trimethoxysilyl)propyl]-1,2,4-triazole,
5-hexylthio-3-methylthio-1-[3-(trimethoxysilyl)propyl]-1,2,4-triazole,
3-amino-5-methylthio-1-[3-(triethoxysilyl)propyl]-1,2,4-triazole,
5-amino-3-methylthio-1-[3-(trimethoxysilyl)propyl]-1,2,4-triazole,
5-amino-3-methylthio-1-[3-(triethoxysilyl)propyl]-1,2,4-triazole,
5-amino-3-isopropylthio-1-[6-(triethoxysilyl)hexyl]-1,2,4-triazole,
3-amino-5-hexylthio-1-[3-(triethoxysilyl)propyl]-1,2,4-triazole, and the like.

Among the triazolesilane compounds (Ia), the triazolesilane compound (Ia-1) can be synthesized in accordance with WO 2018/186476, US 2012/0021232, and WO 2019/058773. Specifically, as shown in the following reaction scheme (E), a triazole compound (in the present specification, it may be referred to as a triazole compound (Ia-x)) represented by General Formula (Ia-x) and a halogenated alkylsilane compound (in the present specification, it may be referred to as a halogenated alkylsilane compound (Ia-y)) represented by General Formula (Ia-y) are reacted in an appropriate amount of a reaction solvent in the presence of a dehydrohalogenating agent at an appropriate reaction temperature and reaction time, whereby synthesis can be performed in a generally high yield.
[Chemical Formula 4]

Reaction scheme (E)

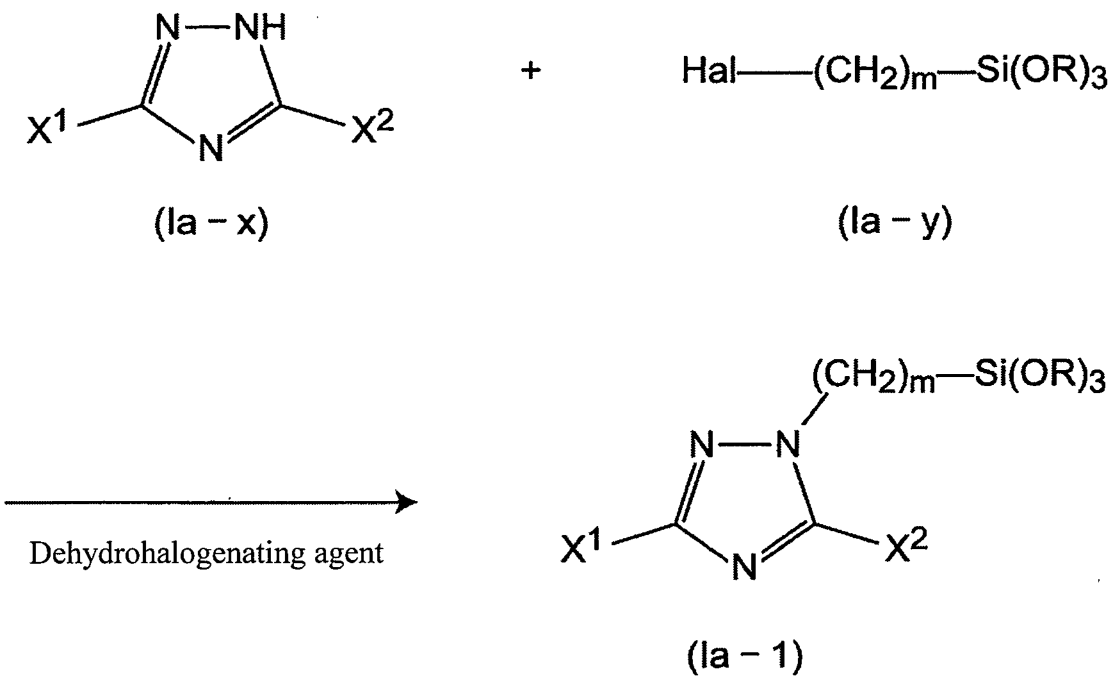


(Ia - x)

(Ia - y)

(Ia - 1)

In the reaction scheme (E), $X^1$, $X^2$, m, and R are the same as $X^1$, $X^2$, m, and R in Formula (Ia), respectively.

Among the triazolesilane compounds (Ia), the triazolesilane compounds (Ia-2) to (Ia-4) can be synthesized by bringing a trialkoxy triazolesilane compound (Ia-1) into contact with an appropriate amount of water and hydrolyzing the compound.

The triazolesilane compound (Ia) may be a mixture of triazolesilane compounds (Ia-1) to (Ia-4).

The triazolesilane compound (Ib) includes triazolesilane compounds represented by General Formulas (Ib-1) to (Ib 4). The compounds represented by General Formulas (Ib-1) to (Ib-4) may be referred to as a triazolesilane compound (Ib-1), a triazolesilane compound (Ib-2), a triazolesilane compound (Ib-3), and a triazolesilane compound (Ib-4), respectively.

[Chemical Formula 5]

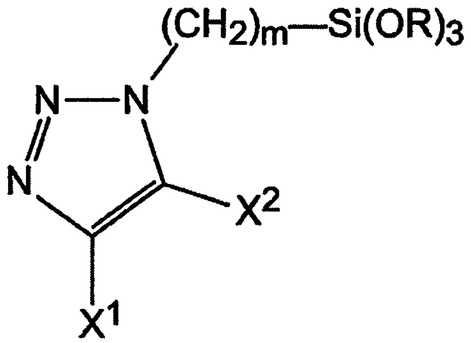

(Ib-1)

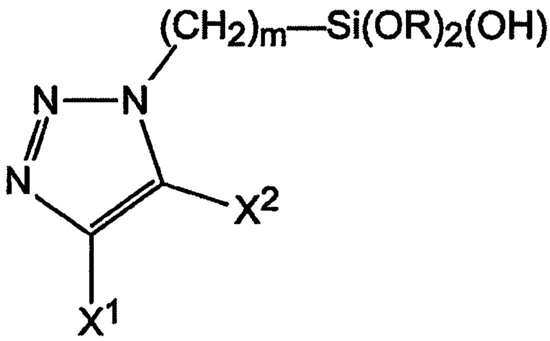

(Ib-2)

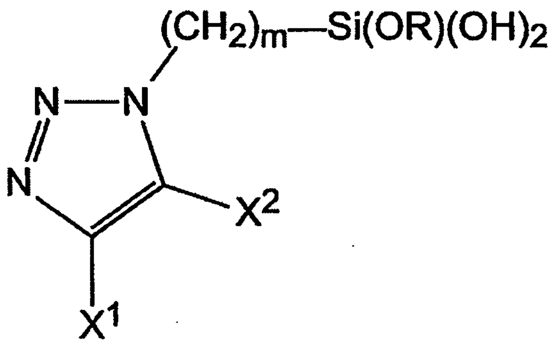

(Ib-3)

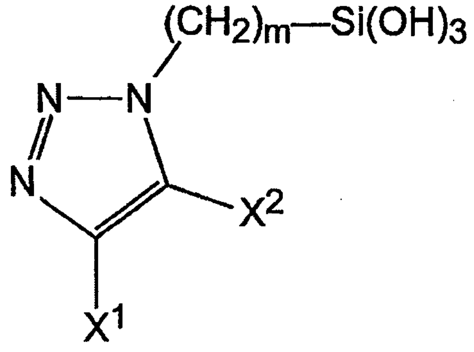

(Ib-4)

In Formulas (Ib-1) to (Ib-4), $X^1$, $X^2$, m, and R are the same as $X^1$, $X^2$, m, and R in Formula (Ib), respectively. In Formulas (Ib-1) to (Ib-4), preferred $X^1$, $X^2$, m, and R are the same as preferred $X^1$, $X^2$, m, and R in Formula (Ib), respectively.

In Formulas (Ib-1) to (Ib-4), the silyl group-containing alkyl group (that is, - $(CH2)_m$-$Si(OR)_{3-n}(OH)_n$) is bonded to the nitrogen atom at the 1-position, but may be bonded to the nitrogen atom at the 2-position. Specifically, the triazolesilane compounds (Ib-1) to (Ib-4) represented by General Formulas (Ib-1) to (Ib-4) include triazolesilane compounds in which a silyl group-containing alkyl group is bonded to a nitrogen atom at the 2-position instead of the nitrogen atom at the 1-position in General Formulas (Ib-1) to (Ib-4), respectively.

The triazolesilane compounds (Ib-1) to (Ib-4) in which at least one of $X^1$ and $X^2$ is an amino group in Formulas (Ib-1) to (Ib-4) are included in the amino group-containing azole silane coupling agent. At this time, m and R are the same as m and R in Formulas (Ib-1) to (Ib-4), respectively. When one of $X^1$ or $X^2$ is an amino group, the other group may be selected from groups within similar ranges as $X^1$ and $X^2$ in Formulas (Ib-1) to (Ib-4).

The triazolesilane compound (Ib-1) is a triazolesilane compound (trialkoxy form) when n is 0 in General Formula (Ib).

Similarly, the triazole silane compound (Ib-2) is a triazole silane compound when n is 1, the triazole silane compound (Ib-3) is a triazole silane compound when n is 2, and the triazole silane compound (Ib-4) is a triazole silane compound when n is 3.

Examples of the triazolesilane compound (Ib) include triazolesilane compounds (Ib-1) exemplified below, and triazolesilane compounds (Ib-2) to (Ib-4) obtained by hydrolyzing (or converting) one to three alkoxy groups (for example, a methoxy group and/or an ethoxy group) to a hydroxyl group in the triazolesilane compound (Ib-1):

1-[3-(trimethoxysilyl)propyl]-1,2,3-triazole,
1-[3-(triethoxysilyl)propyl]-1,2,3-triazole,
4-methyl-1-[3-(triethoxysilyl)propyl]-1,2,3-triazole,
4-ethyl-1-[3-(triethoxysilyl)propyl]-1,2,3-triazole,
4-propyl-1-[3-(triethoxysilyl)propyl]-1,2,3-triazole,
4-isopropyl-1-[3-(triethoxysilyl)propyl]-1,2,3-triazole,
4-butyl-1-[3-(triethoxysilyl)propyl]-1,2,3-triazole,
4-hexyl-1-[3-(triethoxysilyl)propyl]-1,2,3-triazole,
4-dodecyl-1-[3-(triethoxysilyl)propyl]-1,2,3-triazole,
4,5-dimethyl-1-[3-(triethoxysilyl)propyl]-1,2,3-triazole,
4-benzyl-1-[3-(triethoxysilyl)propyl]-1,2,3-triazole,
4-phenyl-1-[3-(triethoxysilyl)propyl]-1,2,3-triazole,
4,5-diphenyl-1-[3-(triethoxysilyl)propyl]-1,2,3-triazole,
4-amino-1-[3-(triethoxysilyl)propyl]-1,2,3-triazole,
4-methylthio-1-[3-(triethoxysilyl)propyl]-1,2,3-triazole,
4-isopropylthio-1-[3-(triethoxysilyl)propyl]-1,2,3-triazole,
4-hexylthio-1-[3-(triethoxysilyl)propyl]-1,2,3-triazole,
4-methyl-2-[3-(triethoxysilyl)propyl]-1,2,3-triazole,
4-hexyl-2-[3-(triethoxysilyl)propyl]-1,2,3-triazole,
4-methylthio-2-[3-(triethoxysilyl)propyl]-1,2,3-triazole,
4-amino-2-[3-(triethoxysilyl)propyl]-1,2,3-triazole,
4-methyl-3-[3-(triethoxysilyl)propyl]-1,2,3-triazole,
4-hexyl-3-[3-(triethoxysilyl)propyl]-1,2,3-triazole,
4-methylthio-3-[3-(triethoxysilyl)propyl]-1,2,3-triazole,

4-amino-3-[3-(triethoxysilyl)propyl]-1,2,3-triazole,
4-propyl-1-[3-(trimethoxysilyl)propyl]-1,2,3-triazole,
4-amino-1-[3-(trimethoxysilyl)propyl]-1,2,3-triazole,
4-amino-1- [6-(triethoxysilyl)hexyl] -1,2,3 -triazole,
4-amino-1-[10-(triethoxysilyl)decyl]-1,2,3-triazole,
4-amino-1 - [12-(triethoxysilyl)dodecyl]-1,2,3-triazole,
1-[3-(trimethoxysilyl)propyl]-1H-benzotriazole,
1-[3-(triethoxysilyl)propyl]-1H-benzotriazole,
2- [3 -(trimethoxysilyl)propyl] -2H-benzotriazole,
2- [3 -(triethoxysilyl)propyl] -2H-benzotriazole.

The triazolesilane compound (Ib-1) among the triazolesilane compounds (Ib) can be synthesized in a substantially high yield by the same method as the reaction scheme (E) except that the triazole compound (in the present specification, it may be referred to as a triazole compound (Ib-x)) represented by General Formula (Ib-x) is used instead of the triazole compound (Ia-x).

[Chemical Formula 6]

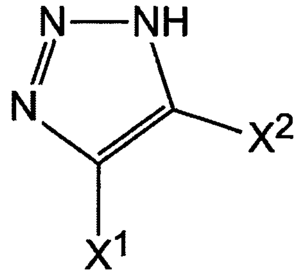

(Ib−x)

In Formula (Ib-x), $X^1$ and $X^2$ are the same as $X^1$ and $X^2$ in Formula (Ib), respectively.

Among the triazolesilane compounds (Ib), the triazolesilane compounds (Ib-2) to (Ib-4) can be synthesized by bringing a trialkoxy triazolesilane compound (Ib-1) into contact with an appropriate amount of water and hydrolyzing the compound.

The triazolesilane compound (Ib) may be a mixture of triazolesilane compounds (Ib-1) to (Ib-4). The triazolesilane compound (Ib) may be particularly a mixture of the "triazolesilane compound (Ib) 1-position conjugate" and the "triazolesilane compound (Ib) 2-position conjugate". The ratio of the mixture is not particularly limited, and may be, for example, 10 : 90 to 90 : 10, preferably 20 : 80 to 80 : 20, and more preferably 30 : 70 to 70 : 30 in terms of a molar ratio of "triazolesilane compound (Ib) 1-position conjugate" : "triazolesilane compound (Ib) 2-position conjugate".

(Monoazolesilane Compound)

The monoazolesilane compound is a compound having one silyl group-containing alkyl group (for example, the same group as $-(CH_2)_m-Si(OR)_{3-n}(OH)_n$ group in General Formula (Ia)) in one molecule as a substituent in a heterocyclic 5-membered ring compound containing one nitrogen atom (that is, a monoazolesilane compound). The atom to which the silyl group-containing alkyl group is bonded is an atom constituting a monoazole ring, and may be, for example, a nitrogen atom or a carbon atom. The monoazolesilane compound may further have a substituent (for example, groups similar to $X^1$ and $X^2$ in General Formula (Ia)). The atom to which the substituent is bonded is an atom constituting a monoazole ring, and may be, for example, a nitrogen atom or a carbon atom.

When the monoazolesilane compound has an amino group as a substituent, the monoazolesilane compound is included in the amino group-containing azole silane coupling agent.

(Diazolesilane Compound)

The diazolesilane compound is a compound having one silyl group-containing alkyl group (for example, the same group as $-(CH_2)_m-Si(OR)_{3-n}(OH)_n$ group in General Formula (Ia)) in one molecule as a substituent in a heterocyclic 5-membered ring compound containing two nitrogen atoms (that is, a diazolesilane compound). The atom to which the silyl group-containing alkyl group is bonded is an atom constituting a diazole ring, and may be, for example, a nitrogen atom or a carbon atom. The atom to which the silyl group-containing alkyl group is bonded is preferably a nitrogen atom from the viewpoint of further improving the adhesive properties between metal and resin, chemical resistance properties,

and storage stability. The diazolesilane compound may further have a substituent (for example, groups similar to $X^1$ and $X^2$ in General Formula (Ia)). The atom to which the substituent is bonded is an atom constituting a diazole ring, and may be, for example, a nitrogen atom or a carbon atom.

When the diazolesilane compound has an amino group as a substituent, the diazolesilane compound is included in the amino group-containing azole silane coupling agent.

(Tetrazolesilane Compound)

The tetrazolesilane compound is a compound having one silyl group-containing alkyl group (for example, the same group as $-(CH_2)_m-Si(OR)_{3-n}(OH)_n$ group in General Formula (Ic) described later) in one molecule as a substituent in a heterocyclic 5-membered ring compound containing four nitrogen atoms (that is, a tetrazolesilane compound). The atom to which the silyl group-containing alkyl group is bonded is an atom constituting a tetrazole ring, and may be, for example, a nitrogen atom or a carbon atom. The atom to which the silyl group-containing alkyl group is bonded is preferably a nitrogen atom from the viewpoint of further improving the adhesive properties between metal and resin, chemical resistance properties, and storage stability. The tetrazolesilane compound may further have a substituent (for example, a group similar to $X^1$ in General Formula (Ia)). The atom to which the substituent (for example, the same group as $X^1$ in General Formula (Ia)) is bonded is an atom constituting a tetrazole ring, and may be, for example, a nitrogen atom or a carbon atom. The atom to which the substituent (for example, the same group as $X^1$ in General Formula (Ia)) is bonded is preferably a carbon atom from the viewpoint of further improving adhesive properties between metal and resin, chemical resistance properties, and storage stability.

Examples of the tetrazolesilane compound include a tetrazolesilane compound represented by General Formula (Ic). The compound represented by General Formula (Ic) may be referred to as a tetrazolesilane compound (Ic).

[Chemical Formula 7]

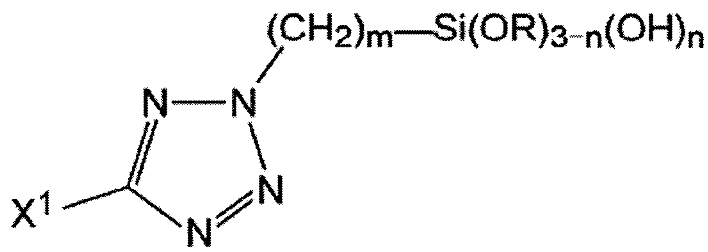

(Ic)

In Formula (Ic), $X^1$, m, n, and R are the same as $X^1$, m, n, and R in Formula (Ia), respectively.

In Formula (Ic), $X^1$ preferably represents a hydrogen atom, a linear or branched alkyl group having 1 to 12 carbon atoms (in particular, a linear or branched alkyl group having 1 to 8 carbon atoms), a phenyl group or an amino group, more preferably a phenyl group or an amino group, and still more preferably an amino group, from the viewpoint of further improving the adhesive properties between metal and resin, chemical resistance properties, and storage stability.

In Formula (Ic), m represents an integer of preferably 1 to 10, more preferably 1 to 5, and still more preferably 2 to 5, from the viewpoint of improving the solubility of the azolesilane compound.

In Formula (Ic), n represents an integer of 0 to 3.

In Formula (Ic), R represents a methyl group or an ethyl group. R preferably represents an ethyl group from the viewpoint of improving the working environment.

In Formula (Ic), the silyl group-containing alkyl group (that is, $-(CH_2)_m-Si(OR)_{3-n}(OH)_n$) is bonded to the nitrogen atom at the 2-position, but may be bonded to the nitrogen atom at the 1-position. Specifically, the tetrazolesilane compound (Ic) represented by General Formula (Ic) includes a tetrazolesilane compound in which a silyl group-containing alkyl group is bonded to a nitrogen atom at the 1-position instead of the nitrogen atom at the 2-position in General Formula (Ic). Hereinafter, regarding Formula (Ic), the tetrazolesilane compounds in which the silyl group-containing alkyl group is bonded to the nitrogen atom at the 1-position or the 2-position are referred to as "tetrazolesilane compound (Ic) 1-position conjugate" or "tetrazolesilane compound (Ic) 2-position conjugate", respectively.

The tetrazolesilane compound (Ic) in which $X^1$ is an amino group in Formula (Ic) is included in the amino group-containing azole silane coupling agent. At this time, m, n, and R are the same as m, n, and R in Formula (Ic), respectively.

The tetrazolesilane compound (Ic) includes tetrazolesilane compounds represented by General Formulas (Ic-1) to (Ic-4). The compounds represented by General Formulas (Ic-1) to (Ic-4) may be referred to as a tetrazolesilane compound (Ic-1), a tetrazolesilane compound (Ic-2), a tetrazolesilane compound (Ic-3), and a tetrazolesilane compound

(Ic-4), respectively. In General Formulas (Ic-1) to (Ic-4), the silyl group-containing alkyl group is bonded to the nitrogen atom at the 2-position, but may be bonded to the nitrogen atom at the 1-position as in Formula (Ic).

[Chemical Formula 8]

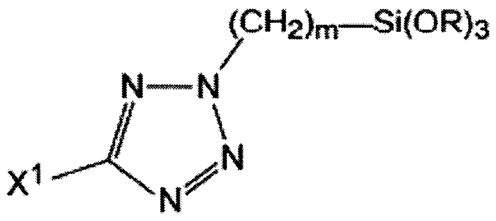

(Ic-1)

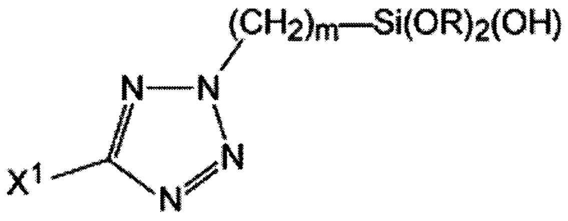

(Ic-2)

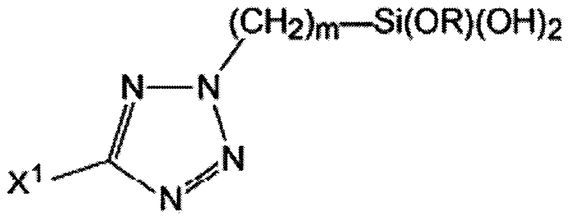

(Ic-3)

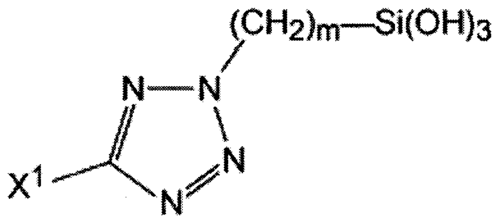

(Ic-4)

In Formulas (Ic-1) to (Ic-4), $X^1$, m, and R are the same as $X^1$, m, and R in Formula (Ia), respectively. In Formulas (Ic-1) to (Ic-4), preferred $X^1$, m, and R are the same as preferred $X^1$, m, and R in Formula (Ic), respectively.

In Formulas (Ic-1) to (Ic-4), the silyl group-containing alkyl group (that is, - $(CH_2)_m$-$Si(OR)_{3-n}(OH)_n$) is bonded to the nitrogen atom at the 2-position, but may be bonded to the nitrogen atom at the 1-position. Specifically, the tetrazolesilane compounds (Ic-1) to (Ic-4) represented by General Formulas (Ic-1) to (Ic-4) includes a tetrazolesilane compound in which a silyl group-containing alkyl group is bonded to a nitrogen atom at the 1-position instead of a nitrogen atom at the 2-position in General Formulas (Ic-1) to (Ic-4), respectively.

The tetrazolesilane compounds (Ic-1) to (Ic-4) in which $X^1$ is an amino group in Formulas (Ic-1) to (Ic-4) are included in the amino group-containing azole silane coupling agent. At this time, m and R are the same as m and R in Formulas (Ic-1) to (Ic-4), respectively.

The tetrazolesilane compound (Ic-1) is a tetrazolesilane compound (trialkoxy form) when n is 0 in General Formula (Ic).

Similarly, the tetrazolesilane compound (Ic-2) is a tetrazolesilane compound when n is 1, the tetrazolesilane compound (Ic-3) is a tetrazolesilane compound when n is 2, and the tetrazolesilane compound (Ic-4) is a tetrazolesilane compound when n is 3.

Examples of the tetrazolesilane compound (Ic) include tetrazolesilane compounds (Ic-1) exemplified below, and tetrazolesilane compounds (Ic-2) to (Ic-4) obtained by hydrolyzing (or converting) one to three alkoxy groups (for example, a methoxy group and/or an ethoxy group) to a hydroxyl group in the tetrazolesilane compound (Ic-1):

5-amino-2-[3-(trimethoxysilyl)propyl]-2H-tetrazole,
5-amino-1-[3-(trimethoxysilyl)propyl]-1H-tetrazole,
5-amino-2-[3-(triethoxysilyl)propyl]-2H-tetrazole,
5-amino-1-[3-(triethoxysilyl)propyl]-1H-tetrazole,
5-phenyl-2-[3-(trimethoxysilyl)propyl]-2H-tetrazole,
5-phenyl-1-[3-(trimethoxysilyl)propyl]-1H-tetrazole,
5-phenyl-2-[3-(triethoxysilyl)propyl]-2H-tetrazole,
5-phenyl-1-[3-(triethoxysilyl)propyl]-1H-tetrazole.

The tetrazolesilane compound (Ic-1) among the tetrazolesilane compounds (Ic) can be synthesized in a substantially high yield by the same method as the above-described reaction scheme (E) except that the tetrazole compound (in the present specification, it may be referred to as a tetrazole compound (Ic-x)) represented by General Formula (Ic-x) is used instead of the triazole compound (Ia-x).

[Chemical Formula 9]

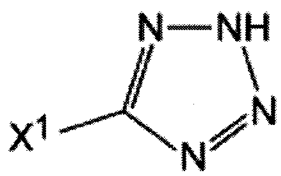

(Ic − x)

In Formula (Ic-x), $X^1$ is the same as $X^1$ in Formula (Ia).

Tetrazolesilane compounds (Ic-2) to (Ic-4) among tetrazolesilane compounds (Ic) can be synthesized by bringing the trialkoxy tetrazolesilane compound (Ic-1) into contact with an appropriate amount of water and hydrolyzing the compound.

The tetrazolesilane compound (Ic) may be a mixture of tetrazolesilane compounds (Ic-1) to (Ic-4). The tetrazolesilane compound (Ic) may be particularly a mixture of a "tetrazolesilane compound (Ic) 1-position conjugate" and a "tetrazolesilane compound (Ic) 2-position conjugate". The ratio of the mixture is not particularly limited, and may be, for example, 10 : 90 to 90 : 10 in terms of a molar ratio of "tetrazolesilane compound (Ic) 1-position conjugate" : "tetrazolesilane compound (Ic) 2-position conjugate", and is preferably 20 : 80 to 80 : 20, more preferably 30 : 70 to 70 : 30, and still more preferably 35 : 65 to 45 : 55 from the viewpoint of further improving the adhesive properties between metal and resin, chemical resistance properties, and storage stability.

(Hydrolysis and Concentration of Azole Silane Coupling Agent)

As described above, the azole silane coupling agent is hydrolyzed when brought into contact with water. An aspect of this hydrolysis is shown in Scheme (F). In this Scheme (F), it is shown that the silyl group of the azole silane coupling agent is hydrolyzed, that is, the trialkoxysilyl group (a) gradually changes to a dialkoxyhydroxysilyl group (b), a dihydroxyalkoxysilyl group (c), and a trihydroxysilyl group (d). X of the group represented by Chemical Formula (e) is an integer representing the number of repeating units. Specifically, a part of the azole silane compound (for example, the above-described triazolesilane compounds (Ia-2) to (Ia-4), triazolesilane compounds (Ib-2) to (Ib-4), and tetrazolesilane compounds (Ic-2) to (Ic-4)) having a hydroxysilyl group generated in the surface treatment liquid gradually reacts

with each other in the surface treatment liquid to undergo dehydration condensation, and the hydroxysilyl group may form a siloxane bond (Si-O-Si) (see Chemical Formula (e) in Scheme (F)) to be converted into a silane oligomer hardly soluble in water. When the amount of the silane oligomer generated in the surface treatment liquid increases, an insoluble matter is precipitated, the surface treatment liquid becomes cloudy, and the treated product may be contaminated. Thus, it is preferable that the amount of silane oligomer generated in the surface treatment liquid is suppressed and the surface treatment liquid has transparency.

[Chemical Formula 10]

Scheme (F)

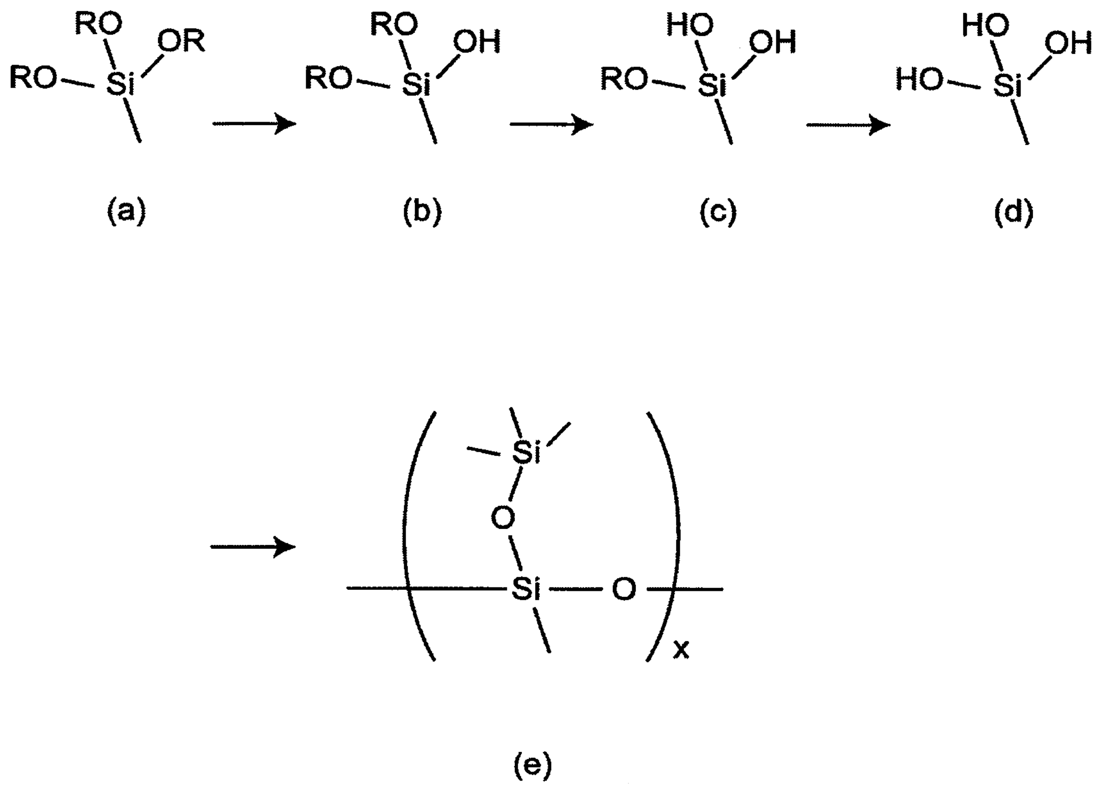

(a) (b) (c) (d)

(e)

(Triazinesilane Coupling Agent)

The triazinesilane coupling agent is a compound having a triazine ring, and has one silyl group-containing alkylamino group (for example, a $-NH-(CH_2)_m-Si(OR)_{3-n}(OH)_n$ group in one molecule as a substituent, and m and n are the same as m and n in Formula (1a)). The atom to which the silyl group-containing alkylamino group is bonded is a carbon atom constituting a triazine ring. The triazinesilane coupling agent may further have a substituent (for example, groups similar to $X^1$ and $X^2$ in General Formula (Ia)). The atom to which the substituent is bonded is a carbon atom constituting a triazine ring.

When the triazinesilane coupling agent has an amino group as a substituent, the triazinesilane coupling agent is included in the amino group-containing triazinesilane coupling agent described above.

Examples of the triazinesilane coupling agent include the following triazinesilane coupling agents:

N-trimethoxysilanylmethyl-[1,3,5]triazine-2,4,6-triamine,
N-(2-trimethoxysilanyl-ethyl)-[1,3,5]triazine-2,4,6-triamine,
N-(3-trimethoxysilanyl-propyl)-[1,3,5]triazine-2,4,6-triamine,
N-(4-trimethoxysilanyl-butyl)-[1,3,5]triazine-2,4,6-triamine,
N-(6-trimethoxysilanyl-hexyl)-[1,3,5]triazine-2,4,6-triamine,
N-(8-trimethoxysilanyl-octyl)-[1,3,5]triazine-2,4,6-triamine,

N-(10-trimethoxysilanyl-decyl)-[1,3,5]triazine-2,4,6-triamine,
N-(12-trimethoxysilanyl-dodecyl)-[1,3,5]triazine-2,4,6-triamine,
N-triethoxysilanylmethyl-[1,3,5]triazine-2,4,6-triamine,
N-(2-triethoxysilanyl-ethyl)-[1,3,5]triazine-2,4,6-triamine,
N-(3-triethoxysilanyl-propyl)-[1,3,5]triazine-2,4,6-triamine,
N-(4-triethoxysilanyl-butyl)-[1,3,5]triazine-2,4,6-triamine,
N-(6-triethoxysilanyl-hexyl)-[1,3,5]triazine-2,4,6-triamine,
N-(8-triethoxysilanyl-octyl)-[1,3,5]triazine-2,4,6-triamine,
N-(10-triethoxysilanyl-decyl)-[1,3,5]triazine-2,4,6-triamine,
N-(12-triethoxysilanyl-dodecyl)-[1,3,5]triazine-2,4,6-triamine.

A substance having an alkoxysilyl group in a molecule is known to act as a silane coupling agent. Thus, it is considered that the silane coupling agent containing a nitrogen atom in the molecule exerts the following action in producing the organic film:
For example, when adhesion between copper and a resin material is taken as an example, the silane coupling agent has a nitrogen atom and an alkoxysilyl group (-Si-OR) in the molecule, and the nitrogen atom interacts with a resin and a metal (in particular, copper) to form a chemical bond.
The alkoxysilyl group undergoes hydrolysis and is converted into a hydroxysilyl group (-Si-OH), which chemically bonds with metal oxides (in particular, a copper oxide) interspersed on the surface of the resin and metal (in particular, copper).
Therefore, by bringing a metal (in particular, copper) into contact with a surface treatment liquid containing the silane coupling agent, an organic film derived from the silane coupling agent is formed on the surface of the metal (in particular, copper) by bonding with a nitrogen atom or a hydroxysilyl group. Thereafter, when an insulating resin layer made of a resin material is formed on the surface of the organic film, the adhesive properties between the metal (in particular, copper) and the resin material can be enhanced as compared with the case where the insulating resin layer is directly formed on the surface of the metal (in particular, copper).
In addition, it is considered that the azole silane coupling agent or the triazine silane coupling agent exhibits the following action in the production of the organic film:
For example, when adhesion between copper and a resin material is taken as an example, an azole silane coupling agent or a triazine silane coupling agent has an azole ring or a triazine ring and an alkoxysilyl group (-Si-OR) in a molecule, and the azole ring or the triazine ring interacts with a resin and a metal (in particular, copper) to form a chemical bond.
The alkoxysilyl group undergoes hydrolysis and is converted into a hydroxysilyl group (-Si-OH), which chemically bonds with metal oxides (in particular, a copper oxide) interspersed on the surface of the resin and metal (in particular, copper).
Therefore, by bringing a metal (in particular, copper) into contact with a surface treatment liquid containing an azole silane coupling agent or a triazine silane coupling agent, an organic film derived from the azole silane coupling agent or the triazine silane coupling agent is formed on the surface of the metal (in particular, copper) by bonding with an azole ring, a triazine ring, or a hydroxysilyl group. Thereafter, when an insulating resin layer made of a resin material is formed on the surface of the organic film, the adhesive properties between the metal (in particular, copper) and the resin material can be enhanced as compared with the case where the insulating resin layer is directly formed on the surface of the metal (in particular, copper).
The content of the silane coupling agent in the surface treatment liquid is not particularly limited as long as the organic film is formed, and may be, for example, 0.001 to 1.000 mol/L, and is preferably 0.005 to 0.500 mol/L, more preferably 0.005 to 0.100 mol/L, still more preferably 0.005 to 0.030 mol/L, and particularly preferably 0.020 to 0.030 mol/L from the viewpoint of further improving the adhesive properties between metal and resin, chemical resistance properties, and storage stability. Two or more silane coupling agents may be contained in combination, and in such a case, the total content thereof may be within the above range.

<Acid>

The acid contained in the surface treatment liquid is a compound that exhibits acidity when dissolved in water. By adding an acid to form a surface treatment liquid having a strongly acidic composition in which the pH is within the above range, the elution amount of metal ions (in particular, copper ions) from the metal (in particular, copper) surface can be dramatically increased. As a result, the formation of a complex of the silane coupling agent and a metal ion (in particular, a copper ion) is promoted, and the strength of the organic film can be increased or the formation rate of the organic film can be dramatically increased. In particular, the formation rate of the organic film is dramatically increased, and thus a protrusion can be formed as an aggregate containing a silane coupling agent on the organic film. In addition,

the addition of an acid promotes the dissolution of the silane coupling agent in the surface treatment liquid.

The acid contained in the surface treatment liquid is not particularly limited as long as the specific organic film to be described later is formed, and from the viewpoint that the surface treatment liquid has the above-described pH, one acid may be used alone, or two or more acids may be used in combination. When one acid is used alone, the acid may be, for example, an acid having an acid dissociation constant (pKa) of 4.8 or less (in particular, -9 to 4.8), and from the viewpoint of further improving adhesive properties between metal and resin, chemical resistance properties, and storage stability, examples of the acid include an acid having an acid dissociation constant (pKa) of preferably 3.0 or less (in particular, -5 to 3.0), more preferably 1.5 or less (in particular, -5 to 1.5), still more preferably 0.0 or less (in particular, -5 to 0.0), particularly preferably -1.5 or less (in particular, -5 to -1.5), and sufficiently preferably - 2.5 or less (in particular, -5 to -2.5). When two or more acids are used in combination, two or more acids selected from the acids when one acid is used alone may be used as the acid, or one or more acids having an acid dissociation constant of more than 4.8 may be used together with one or more acids selected from the acids when one acid is used alone. When only an acid having an excessively large acid dissociation constant (for example, only an acid having a pKa of 4.9 or more) is used, an organic film having a protrusion cannot be obtained. In either case where one acid is used alone or two or more acids are used in combination, such an acid may be an organic acid or an inorganic acid. As the acid contained in the surface treatment liquid, one or more acids selected from acids having an acid dissociation constant (pKa) of more sufficiently preferably -5 to 0.0, particularly sufficiently preferably -5 to -1.5, and most preferably -5 to -2.5 are used from the viewpoint of further improving the adhesive properties between metal and resin, chemical resistance properties, and storage stability.

Examples of the organic acid include monocarboxylic acids such as formic acid (pKa: 3.8), acetic acid (pKa: 4.7), propionic acid, butyric acid (pKa: 4.8), valeric acid (pKa: 4.8), 2-ethylbutyric acid (pKa: 4.8), caproic acid, heptanoic acid, caprylic acid, pelargonic acid, capric acid, lauric acid, mystiphosphoric acid, palmitic acid, margaric acid, oleic acid, stearic acid, levulinic acid (pKa: 4.7), glycolic acid (pKa: 3.8), lactic acid (pKa: 3.8), gluconic acid (pKa: 3.9), glyceric acid (pKa: 3.6), glycine (pKa: 2.4 (COOH)), benzoic acid (pKa: 4.2), isobutyric acid (pKa: 4.8), 2-ethylbutyric acid (pKa: 4.8), 2-hydroxybutyric acid (pKa1: 3.7), 3-hydroxybutyric acid (pKa1: 4.4), chloroacetic acid (pKa: 2.9), dichloroacetic acid (pKa: 1.5), trichloroacetic acid (pKa: 0.7), bromoacetic acid (pKa: 2.7), iodoacetic acid (pKa: 3.1), methoxyacetic acid (pKa: 3.7), ethoxyacetic acid (pKa: 3.6), propoxyacetic acid (pKa: 3.6), butoxyacetic acid (pKa: 3.6), 2-(2-methoxyethoxy)acetic acid (pKa: 3.4), 2-[2-(2-ethoxyethoxy)ethoxy]acetic acid, 2-{2-[2-(2-ethoxyethoxy)ethoxy]ethoxy}acetic acid, 3-methoxypropionic acid (pKa: 4.3), 3-ethoxypropionic acid (pKa: 4.3), 3-propoxypropionic acid, 3-butoxypropionic acid, glyoxylic acid (pKa: 3.2), pyruvic acid (pKa: 2.4), acetoacetic acid (pKa: 3.6), acrylic acid (pKa: 4.3), crotonic acid (pKa: 4.8), p-nitrobenzoic acid (pKa: 3.4), and salicylic acid (pKa: 3.0); dicarboxylic acids such as oxalic acid (pKa1: 1.2), malonic acid (pKa1: 2.8), succinic acid (pKa1: 4.2), tartaric acid (pKa1: 3.2), phthalic acid (pKa1: 2.9), malic acid (pKa1: 3.8), glutaric acid (pKa1: 4.3), adipic acid (pKa1: 4.4), maleic acid (pKa1: 1.8), and fumaric acid (pKa1: 3.0); tricarboxylic acids such as propane-1,2,3-tricarboxylic acid (pKa1: 3.5) and citric acid (pKa1: 3.1); sulfonic acids such as benzenesulfonic acid (pKa: -2.8), tosylic acid (pKa: - 2.8), methanesulfonic acid (pKa: -1.9), 5-sulfosalicylic acid (pKa: -0.6), 4-hydroxybenzenesulfonic acid (pKa: -1.1), 3-methyl-4-hydroxybenzenesulfonic acid (pKa: -0.2), 4-aminobenzenesulfonic acid (pKa: 3.0), camphorsulfonic acid (pKa: 1.2), benzenedisulfonic acid (pKa1: -1.4), benzenetrisulfonic acid (pKa1: -2.1), and sulfamic acid (pKa: -8.5); and picric acid (pKa: 0.4).

The organic acid ion contained in the organic acid has an action of promoting dissolution of the silane coupling agent in the surface treatment liquid, for example, an action of promoting hydrolysis of the silane coupling agent.

Examples of the inorganic acid include sulfuric acid (pKa1: -3.0), nitric acid (pKa: -1.8), phosphoric acid (pKa1: 2.1), and hydrochloric acid (pKa: -3.7).

The inorganic acid ion contained in the inorganic acid has an effect of improving the film formation rate of the organic film by the salting-out effect.

From the viewpoint of further improving the adhesive properties between metal and resin, chemical resistance properties, and storage stability, the acid is preferably selected from the group consisting of the organic acid such as the monocarboxylic acids and the sulfonic acids; and the inorganic acid such as sulfuric acid and nitric acid, more preferably selected from the group consisting of sulfonic acids and sulfuric acid, even more preferably selected from the group consisting of tosylic acid and sulfuric acid, and sufficiently preferably sulfuric acid is used.

The content of the acid in the surface treatment liquid is not particularly limited as long as the surface treatment liquid has the pH described above, and may be, for example, 0.010 to 10.0 mol/L, and is preferably 0.10 to 8.0 mol/L, more preferably 0.10 to 5.0 mol/L, still more preferably 0.20 to 3.5 mol/L, and particularly preferably 0.50 to 2.5 mol/L from the viewpoint of further improving the adhesive properties between metal and resin, chemical resistance properties, and storage stability. Two or more acids may be contained in combination, and in such a case, the total content thereof may be within the above range.

The total content of the organic acid ion and the inorganic acid ion contained in the surface treatment liquid is not particularly limited as long as the surface treatment liquid has the pH described above, and may be, for example, 0.010 to 10.0 mol/L, and is preferably 0.10 to 8.0 mol/L, more preferably 0.10 to 5.0 mol/L, still more preferably 0.20 to

3.5 mol/L, and particularly preferably 0.50 to 2.5 mol/L from the viewpoint of further improving the adhesive properties between metal and resin, chemical resistance properties, and storage stability.

To further obtain the effect of increasing the formation rate of the organic film by the acid, it is preferable to adjust the ratio of the concentration of the acid to the concentration of the silane coupling agent (in particular, the ratio of the concentration of sulfonic acids or sulfuric acid to the concentration of the silane coupling agent) in addition to the fact that the concentrations of the silane coupling agent and the acid in the surface treatment liquid are within the above ranges. The ratio (acid concentration/Si) of the total molar concentration of the organic acid ion and the inorganic acid ion to the molar concentration of Si derived from the silane coupling agent in the surface treatment liquid may be, for example, 1 to 1000, and is preferably 5 to 500, more preferably 10 to 250, and still more preferably 20 to 150 from the viewpoint of further improving the formation rate of the organic film. The ratio (S/Si) of the total molar concentration of S derived from the sulfonic acids and the sulfuric acid to the molar concentration of Si derived from the silane coupling agent in the surface treatment liquid may be, for example, 1 to 1000, and is preferably 5 to 500, more preferably 10 to 250, and still more preferably 20 to 150 from the viewpoint of further improving the formation rate of the organic film.

<Other Components>

The surface treatment liquid may contain other components such as a base, a copper-based compound, a halogen compound, a salt, an organic solvent, and filler particles in addition to the silane coupling agent and the acid described above.

The surface treatment liquid may contain a base. A base is a compound that exhibits basicity when dissolved in water. The base is useful for adjusting the pH of the surface treatment liquid to the above-described range, and the addition of the base increases the amount of ions in the surface treatment liquid, and thus the base has an effect of improving the film formation rate of the organic film by the salting-out effect and an effect of improving the storage stability of the surface treatment liquid.

Examples of the base include one or more compounds selected from the group consisting of hydrides, hydroxides, and alkoxides of alkali metals or alkaline earth metals, and ammonia or amine compounds (primary, secondary, tertiary or quaternary ammonium salts). The base is preferably an alkali metal hydroxide or ammonia, and more preferably sodium hydroxide or ammonia, from the viewpoint of further improving adhesive properties between metal and resin, chemical resistance properties, and storage stability.

Examples of the "hydrides, hydroxides and alkoxides of alkali metals or alkaline earth metals" include alkali metal hydrides such as lithium hydride, sodium hydride, and potassium hydride; alkali metal hydroxides such as lithium hydroxide, sodium hydroxide, and potassium hydroxide; alkaline earth metal hydroxides such as magnesium hydroxide and calcium hydroxide; and alkoxides such as sodium alkoxide and potassium alkoxide.

Examples of the "ammonia or amine compound (primary, secondary, tertiary or quaternary ammonium salts)" include ammonia, methylamine, dimethylamine, trimethylamine, ethylamine, diethylamine, triethylamine, propylamine, isopropylamine, butylamine, pentylamine, hexylamine, heptylamine, octylamine, nonylamine, allylamine, ethylenediamine, diethylenetriamine, triethylenetetramine, monoethanolamine, diethanolamine, triethanolamine, monopropanolamine, dipropanolamine, tripropanolamine, monoisopropanolamine, diisopropanolamine, triisopropanolamine, 3-amino-1-propanol, 2-amino-1-propanol, N,N-dimethylethanolamine, cyclohexylamine, aniline, pyrrolidine, piperidine, piperazine, pyridine, tetramethylammonium hydroxide, tetraethylammonium hydroxide, tetrapropylammonium hydroxide, tetrabutylammonium hydroxide, choline hydroxide, benzyltrimethylammonium chloride, tetrabutylammonium chloride, tetrabutylammonium bromide, tetrabutylammonium iodide, benzyltriethylammonium chloride, hexadecyltrimethylammonium bromide, benzetonium chloride, benzalkonium chloride, and cetylpyridinium chloride.

Among cations generated from the base, an alkali metal ion, an alkaline earth metal ion, an ammonium ion, a primary ammonium ion, a secondary ammonium ion, and a tertiary ammonium ion have an effect of improving the film formation rate of the organic film by the salting-out effect. Among cations generated from the base, quaternary ammonium cations have an effect of improving the storage stability of the surface treatment liquid.

The content of the base in the surface treatment liquid is not particularly limited as long as the surface treatment liquid has the pH described above, and may be, for example, 5.0 mol/L or less (in particular, 0 to 5.0 mol/L). From the viewpoint of further improving adhesive properties between metal and resin, chemical resistance properties, and storage stability, the content is preferably 3.0 mol/L or less (in particular, 0 to 3.0 mol/L), more preferably 1.0 mol/L or less (in particular, 0 to 1.0 mol/L), and still more preferably 0.50 mol/L or less (in particular, 0 to 0.50 mol/L). Two or more bases may be contained in combination, and in such a case, the total content thereof may be within the above range.

The total content of alkali metal ions, alkaline earth metal ions, ammonium ions, primary ammonium ions, secondary ammonium ions, tertiary ammonium ions, and quaternary ammonium cations contained in the surface treatment liquid is not particularly limited as long as the surface treatment liquid has the pH described above, and may be, for example, 5.0 mol/L or less (in particular, 0 to 5.0 mol/L), and is preferably 3.0 mol/L or less (in particular, 0 to 3.0 mol/L), more preferably 1.0 mol/L or less (in particular, 0 to 1.0 mol/L), still more preferably 0.50 mol/L or less (in particular,

0 to 0.50 mol/L) from the viewpoint of further improving adhesive properties between metal and resin, chemical resistance properties, and storage stability.

In the copper-based compound, a copper ion generated by dissolving the copper-based compound in the surface treatment liquid forms a complex with the silane coupling agent, and the strength of the organic film can be increased or the adhesion strength between the metal and the resin can be increased. The valency of the copper ion generated from the copper-based compound may be monovalent or divalent. Examples of the copper-based compound include metal copper, copper sulfate (and hydrates thereof (in particular, pentahydrate)), copper formate (and hydrates thereof (in particular, tetrahydrate)), copper nitrate, cuprous chloride, cupric chloride, copper acetate (and hydrates thereof (in particular, monohydrate)), copper hydroxide, copper oxide, copper sulfide, copper carbonate, cuprous bromide, cupric bromide, copper phosphate, and copper benzoate. From the viewpoint of promoting the formation of the organic film, the copper-based compound is preferably copper sulfate (and hydrates thereof (in particular, pentahydrate)), copper formate (and hydrates thereof (in particular, tetrahydrate)), copper acetate (and hydrates thereof (in particular, monohydrate)), cuprous chloride, or cupric chloride, and more preferably selected from the group consisting of copper sulfate (and hydrates thereof (in particular, pentahydrate)), copper formate (and hydrates thereof (in particular, tetrahydrate)), and copper acetate (and hydrates thereof (in particular, monohydrate)). The copper-based compound may also include compounds that act as acids or bases in water. The cuprous chloride, the cupric chloride, the cuprous bromide, and the cupric bromide are also useful as halogen compounds described later. The copper ions in the surface treatment liquid may contain copper ions eluted from metal copper or copper oxide contained in the copper circuit at the time of treatment of the copper circuit with the surface treatment liquid.

The content of the copper-based compound in the surface treatment liquid is not particularly limited, and may be, for example, 1.00 mol/L or less (in particular, 0 mol/L or more and 1.00 mol/L or less), and is preferably 0.50 mol/L or less (in particular, 0 mol/L or more and 0.50 mol/L or less), more preferably 0.10 mol/L or less (in particular, 0 mol/L or more and 0.10 mol/L or less), still more preferably 0.010 mol/L or less (in particular, 0 mol/L or more and 0.010 mol/L or less) from the viewpoint of further improving the adhesive properties between metal and resin, chemical resistance properties, and storage stability. Two or more copper-based compounds may be contained in combination, and in such a case, the total content thereof may be within the above range. The surface treatment liquid preferably contains a copper-based compound. In such a case, the content of the copper-based compound may be more than 0 mol/L and 1.00 mol/L or less, and from the viewpoint of further improving the adhesive properties between metal and resin, chemical resistance properties, and storage stability, the content is preferably more than 0 mol/L and 0.50 mol/L or less, more preferably more than 0 mol/L and 0.10 mol/L or less, and still more preferably more than 0 mol/L and 0.010 mol/L or less.

The content of copper ions produced by dissolving the copper-based compound in the surface treatment liquid is not particularly limited, and may be, for example, 1.00 mol/L or less (in particular, 0 to 1.00 mol/L). From the viewpoint of further improving the adhesive properties between metal and resin, chemical resistance properties, and storage stability, the content is preferably 0.50 mol/L or less (in particular, 0 to 0.50 mol/L), more preferably 0.10 mol/L or less (in particular, 0 to 0.10 mol/L), and still more preferably 0.010 mol/L or less (in particular, 0 to 0.010 mol/L). The surface treatment liquid preferably contains copper ions. The content of copper ions in such a case may be more than 0 mol/L and 1.00 mol/L or less, and is preferably more than 0 mol/L and 0.50 mol/L or less, more preferably more than 0 mol/L and 0.10 mol/L or less, still more preferably more than 0 mol/L and 0.010 mol/L or less from the viewpoint of further improving the adhesive properties between the metal and the resin, the chemical resistance properties, and the storage stability of the surface treatment liquid.

To further obtain the effect of enhancing the adhesive properties between the metal and the resin with copper, in addition to the fact that the concentrations of the silane coupling agent and the copper ion in the surface treatment liquid are within the above ranges, the ratio of the concentration of the copper ion to the concentration of the silane coupling agent may be adjusted. The ratio of the molar concentration of Cu ions to the molar concentration of Si derived from the silane coupling agent in the surface treatment liquid (Cu/Si) may be, for example, 0 to 10, and is preferably 0 to 5.0, more preferably 0 to 1.0, and still more preferably 0 to 0.50 from the viewpoint of further improving the adhesive properties between metal and resin, chemical resistance properties, and storage stability.

The halogen compound is a salt containing a halide ion, and the halide ion contained in the halogen compound exhibits an effect of uniformly forming the flat portion of the organic film. Examples of the halide ion include a fluoride ion, a chloride ion, a bromide ion, and an iodide ion. Examples of the halogen compound include lithium fluoride, sodium fluoride, potassium fluoride, magnesium fluoride, calcium fluoride, lithium chloride, sodium chloride, potassium chloride, magnesium chloride, calcium chloride, lithium bromide, sodium bromide, potassium bromide, magnesium bromide, calcium bromide, lithium iodide, sodium iodide, potassium iodide, magnesium iodide, calcium iodide, ammonium fluoride, ammonium chloride, ammonium bromide, ammonium iodide, cuprous chloride, cupric chloride, cuprous bromide, and cupric bromide. The halogen compound may be contained as impurities of other components. The halogen compound may also include compounds that act as acids or bases in water. As described above, cuprous chloride, cupric chloride, cuprous bromide, and cupric bromide are also useful as copper-based compounds.

The content of the halogen compound in the surface treatment liquid is not particularly limited, and may be, for

example, 0.10 mol/L or less (in particular, 0 to 0.10 mol/L), and is preferably 0.050 mol/L or less (in particular, 0 to 0.050 mol/L), more preferably 0.020 mol/L or less (in particular, 0 to 0.020 mol/L), still more preferably 0.010 mol/L or less (in particular, 0 to 0.010 mol/L) from the viewpoint of further improving the adhesive properties between metal and resin, chemical resistance properties, and storage stability. Two or more halogen compounds may be contained in combination, and in such a case, the total content thereof may be within the above range.

The content of the halide ion derived from the halogen compound in the surface treatment liquid is not particularly limited, and may be, for example, 0.10 mol/L or less (in particular, 0 to 0.10 mol/L), and is preferably 0.050 mol/L or less (in particular, 0 to 0.050 mol/L), more preferably 0.020 mol/L or less (in particular, 0 to 0.020 mol/L), still more preferably 0.010 mol/L or less (in particular, 0 to 0.010 mol/L) from the viewpoint of further improving the adhesive properties between metal and resin, chemical resistance properties, and storage stability.

To further obtain the effect of enhancing the adhesive properties between the metal and the resin with the halogen compound, in addition to the concentration of the silane coupling agent and the "halogen compound or halide ion" in the surface treatment liquid being within the above ranges, the ratio of the concentration of the halide ion to the concentration of the silane coupling agent may be adjusted. The ratio (Hal/Si) of the molar concentration of halide ions to the molar concentration of Si derived from the silane coupling agent in the surface treatment liquid may be, for example, 0 to 20, and is preferably 0 to 10, more preferably 0 to 5.0, and still more preferably 0 to 1.0 from the viewpoint of further improving the adhesive properties between metal and resin, chemical resistance properties, and storage stability.

The salt is a salt other than the copper-based compound and the halogen compound, and cations and/or anions contained in the salt are dissolved in the surface treatment liquid to increase the amount of ions in the surface treatment liquid, and thus there is an effect of improving the film formation rate of the organic film by the salting-out effect. Examples of the cation contained in the salt include alkali metal ions such as lithium ion, sodium ion, and potassium ion; alkaline earth metal ions such as magnesium ions and calcium ions; transition metal ions such as zinc ion, manganese ion, cobalt ion, nickel ion, and iron ion; and ammonium ions. Examples of the anion contained in the salt include a sulfate ion, a sulfite ion, a nitrate ion, a phosphate ion, a monohydrogen phosphate ion, a dihydrogen phosphate ion, a carbonate ion, a bicarbonate ion, a formate ion, and an acetate ion. Examples of the salt include watersoluble salts such as sodium sulfate, sodium nitrate, potassium sulfate, sodium carbonate, sodium hydrogen carbonate, potassium carbonate, potassium hydrogen carbonate, sodium formate, potassium formate, sodium acetate, potassium acetate, sodium phosphate, disodium monohydrogen phosphate, sodium dihydrogen phosphate, ammonium sulfate, ammonium formate, ammonium acetate, ammonium carbonate, and ammonium nitrate.

The content of the salt in the surface treatment liquid is not particularly limited, and may be, for example, 1.0 mol/L or less (in particular, 0 to 1.0 mol/L). From the viewpoint of further improving storage stability, the content is preferably 0.80 mol/L or less (in particular, 0 to 0.80 mol/L), more preferably 0.50 mol/L or less (in particular, 0 to 0.50 mol/L), and still more preferably 0.30 mol/L or less (in particular, 0 to 0.30 mol/L). Two or more salts may be contained in combination, and in such a case, the total content thereof may be within the above range.

Examples of the organic solvent include methanol, ethanol, 1-propanol, 2-propanol, butanol, tert-butyl alcohol, 1-methoxy -2 propanol, 1-ethoxy -2 propanol, 1-butoxy -2 propanol, ethylene glycol, propylene glycol, glycerin, diethylene glycol, triethylene glycol, ethylene glycol monomethyl ether, ethylene glycol dimethyl ether, ethylene glycol monoethyl ether, ethylene glycol diethyl ether, ethylene glycol monobutyl ether, propylene glycol monomethyl ether, propylene glycol monoethyl ether, propylene glycol monobutyl ether, diethylene glycol monomethyl ether, diethylene glycol dimethyl ether, diethylene glycol monoethyl ether, diethylene glycol diethyl ether, diethylene glycol monobutyl ether, triethylene glycol dimethyl ether, triethylene glycol diethyl ether, tetrahydrofurfuryl alcohol, furfuryl alcohol, acetone, tetrahydrofuran, dioxane, acetonitrile, 2-pyrrolidone, formamide, dimethylformamide, dimethylacetamide, dimethylsulfoxide, sulfolane, dimethyl carbonate, ethylene carbonate, N-methylpyrrolidone, γ-butyrolactone, and 1,3-dimethyl -2 imidazolidinone. These organic solvents may be used singly or in combination of two or more thereof.

The content of the organic solvent in the surface treatment liquid is not particularly limited, and may be, for example, 5.0 mol/L or less (in particular, 0 to 5.0 mol/L), and is preferably 3.0 mol/L or less (in particular, 0 to 3.0 mol/L), more preferably 2.0 mol/L or less (in particular, 0 to 2.0 mol/L), still more preferably 1.0 mol/L or less (in particular, 0 to 1.0 mol/L) from the viewpoint of further improving the adhesive properties between metal and resin, chemical resistance properties, and storage stability. Two or more organic solvents may be contained in combination, and in such a case, the total content thereof may be within the above range.

The surface treatment liquid may further contain filler particles. When the surface treatment liquid contains filler particles, the organic film also contains filler particles. In this case, in the organic film, it is preferable that a silane coupling agent is present on the surface of the filler particles, and it is more preferable that the surface of the filler particles is covered with the silane coupling agent. The filler particles may be one or more particles selected from the group consisting of inorganic particles made of an inorganic substance and organic particles made of an organic substance. The filler particles form an organic film (in particular, a precipitate or an aggregate) on the surface of the metal together with the silane coupling agent, and can increase the adhesion strength between the metal (in particular, copper) and the resin. Examples of the filler particles include inorganic particles such as silica, alumina, magnesia, titania, and zirconia; and

melamine-based and acryl-based organic particles. The filler particles preferably include inorganic particles.

The average particle size of the filler particles is, for example, 1 nm to 20 μm, preferably 5 nm to 15 μm, and more preferably 10 nm to 15 μm. In the organic film (in particular, a precipitate or aggregate containing a silane coupling agent and filler particles), it is preferable that the silane coupling agent is present on the surface of the filler particles, and it is more preferable that the surface of the filler particles is covered with the silane coupling agent. The silane coupling agent on the filler particle surface is not particularly limited, and may be a silane coupling agent included in the silane coupling agent constituting the organic film and the surface treatment liquid in the present invention, may be a silane coupling agent other than the silane coupling agent, or may be a mixture thereof.

The content of the filler particles in the surface treatment liquid is not particularly limited, and may be, for example, 10.0 wt% or less (in particular, 0 to 10.0 wt% or less), preferably 5.0 wt% or less (in particular, 0 to 5.0 wt% or less), more preferably 3.0 wt% or less (in particular, 0 to 3.0 wt%), still more preferably 2.0 wt% or less (in particular, 0 to 2.0 wt%), and particularly preferably 1.0 wt% or less (in particular, 0 to 1.0 wt%). Two or more filler particles may be contained in combination, and in such a case, the total content thereof may be within the above range.

[Method for Producing Metal Surface Treatment Liquid]

The present invention also provides a method for producing the above-described surface treatment liquid.

The method for producing a surface treatment liquid of the present invention is characterized by combining a silane coupling agent, an acid, and optionally other components, and water. "Combining" means that all the components may be mixed in any combination as long as the obtained surface treatment liquid finally contains all the components at a predetermined concentration. For example, all the components may be mixed at once (batch mixing method), or some of all the components may be mixed in advance, and then the remaining components may be further mixed (split mixing method). In the split mixing method, for example, the silane coupling agent may be dissolved in an organic solvent in advance and then mixed with the remaining components.

The surface treatment liquid can be easily produced in a relatively short stirring time even at room temperature of 10 to 30°C. The stirring time is usually 10 minutes to 30 minutes. Examples of the water used for producing the surface treatment liquid include pure water such as ion-exchanged water, distilled water, and purified water.

[Method for Using Metal Surface Treatment Liquid (Method For Producing Organic Film)]

An organic film having a protrusion can be produced on a metal surface by bringing the surface treatment liquid of the present invention into contact with the metal surface. Specifically, bringing such the surface treatment liquid of the present invention into contact with the surface of the metal causes the silane coupling agent to be precipitated and aggregated on the surface of the metal, and as a result, an organic film having protrusions is formed. Thus, the organic film is formed of a precipitate or aggregate containing the silane coupling agent, and contributes to improvement of adhesive properties between metal and resin.

The method for bringing the surface treatment liquid into contact with the surface of the metal is not particularly limited as long as direct contact between the surface treatment liquid and the metal surface is achieved, and for example, a method such as a spraying method, an immersion method, or a coating method can be adopted.

The time (treatment time) for bringing the surface treatment liquid into contact with the metal surface may be appropriately determined according to the desired thickness of the flat portion of the organic film, the desired protrusion length of the protrusion 20, and the composition of the surface treatment liquid. Since the surface treatment liquid has a sufficiently high film-forming speed, a protrusion having a desired protrusion length can be formed within a predetermined time.

The time for bringing the surface treatment liquid into contact with the surface of the metal (treatment time) is not particularly limited, and is preferably 1 second to 10 minutes, more preferably 5 seconds to 3 minutes, and still more preferably 20 seconds to 50 seconds, from the viewpoint of further improving the adhesive properties between the metal and the resin and the chemical resistance properties. When the treatment time is 1 second or more, the organic film having the protrusion 20 on the metal surface can be sufficiently formed. As a result, when a resin layer (for example, an insulating resin layer) is formed on the surface of an organic film, a sufficiently high adhesive force between the metal and the resin layer can be obtained. Even when the treatment time is longer than 10 minutes, an increase in adhesive force cannot be expected since there is no large difference in the film thickness of the flat portion of the organic film and the protrusion length of the protrusion 20, and it is preferable to perform the treatment in 10 minutes or less from the viewpoint of productivity.

The temperature of the surface treatment liquid at the time of causing the surface treatment liquid to adhere to the surface of the metal is not particularly limited, and is preferably 5 to 50°C. However, the temperature may be appropriately set in relation to the treatment time, the desired film thickness of the flat portion of the organic film, and the protrusion length of the protrusion 20.

After the surface treatment liquid is brought into contact with the surface of the metal, it is preferable to perform water washing as necessary, and then dry the surface of the metal. Drying is preferably performed at a temperature of room temperature (for example, 20°C) to 150°C, preferably at a temperature of 60 to 120°C, for a time of about 1 second to 10 minutes, preferably 10 seconds to 3 minutes. Pure water such as ion-exchanged water, distilled water, and purified water is preferable as water used for water washing. The method and time of water washing are not particularly limited, and may be an appropriate time in a method such as a spraying method or an immersion method.

In the present invention, the dried organic film may be subjected to a treatment such as plasma, laser, ion beam, ozone, heating, or humidification to modify the surface of the organic film. Alternatively, before the surface treatment liquid is brought into contact with the metal surface, cleaning for the purpose of removing resin and ion residues on the metal surface may be performed using mechanical polishing such as plasma, laser, ion beam, or pumice brush, or a processing method such as drilling.

Before and/or after bringing the surface treatment liquid into contact with the surface of the metal, an aqueous solution containing copper ions may be brought into contact with the surface of the metal. The aqueous solution containing copper ions has a function of enhancing the film formability of the organic film formed on the surface of copper and a function of enhancing the adhesive properties between the metal and the resin. The valency of the copper ion is not particularly limited, and is a monovalent or divalent copper ion. The copper ion source of the aqueous solution containing copper ions is not particularly limited as long as it is a copper salt dissolved in a solvent used for the surface treatment liquid, and examples thereof include copper salts such as copper sulfate, copper nitrate, cuprous chloride, cupric chloride, copper formate, copper acetate, cuprous bromide, cupric bromide, and copper phosphate. Ammonia and/or hydrochloric acid or the like may be added to solubilize the copper salt in water.

An acidic or basic aqueous solution may be brought into contact with the surface of the metal before and/or after bringing the surface treatment liquid into contact with the surface of the metal. Like the aqueous solution containing copper ions, this acidic aqueous solution or basic aqueous solution also has a function of enhancing the film-forming property of the organic film formed on the surface of copper. The acidic aqueous solution and the basic aqueous solution are not particularly limited. Examples of the acidic aqueous solution include an aqueous solution containing an inorganic acid such as sulfuric acid, nitric acid, or hydrochloric acid, and an aqueous solution containing an organic acid such as formic acid, acetic acid, lactic acid, glycolic acid, or amino acid. Examples of the basic aqueous solution include aqueous solutions containing a hydroxide of an alkali metal such as sodium hydroxide or potassium hydroxide, and an amine such as ammonia, ethanolamine, monopropanolamine, or tetramethylammonium hydroxide.

Performing the treatment as described above makes it possible to form an organic film having a protrusion on the surface of the metal, and it is possible to sufficiently enhance the adhesive properties between the resin layer formed on the organic film and the metal. In addition, the metal oxidation can be suppressed because of the protection by the organic film. Thus, in a printed wiring board or the like including a metal wiring layer and an insulating resin layer, adhesive properties between the metal wiring layer (metal circuit) and the insulating resin layer (resin material) can be enhanced and formation of metal oxide can be reduced without particularly performing roughening treatment on the metal wiring layer.

[Organic Film]

An organic film according to an embodiment of the present invention to be produced with the surface treatment liquid will be specifically described with reference to the drawings. Various elements in the drawings are merely schematically and exemplarily shown for understanding of the present invention, and appearance, dimensional ratios, and the like may be different from actual ones. The term "plan view" as used herein refers to a state in which an object (for example, a metal having an organic film) is allowed to stand on a horizontal plane with its main surface (for example, a surface having a maximum area and on which an organic film is disposed) as an upper surface (top surface), and the object is viewed from the upper side or the lower side (in particular, the upper side) along a direction perpendicular to the horizontal plane. The term "cross-sectional view" as used herein refers to a state when viewed from a direction parallel to the horizontal plane. The term "up-down directions" and "left-right directions" used directly or indirectly in the present specification respectively correspond to the up-down directions and the left-right directions in the drawings. Unless otherwise specified, the same reference numerals or symbols indicate the same members/portions or the same semantic contents. In a preferred aspect, it can be understood that the downward direction in a vertical direction (that is, the direction in which gravity acts) corresponds to the "downward direction", and the opposite direction corresponds to the "upward direction".

In the present invention, the organic film is an organic film disposed on a metal surface, and is a surface-treated film formed by surface treatment of a metal. In the present invention, as shown in Fig. 1, an organic film 2 has an uneven shape on the side opposite to a metal 1, specifically, includes a protrusion 20 protruding to the side opposite to the metal 1. Specifically, in the present invention, the organic film 2 includes the protrusion 20 protruding to the side opposite to the metal 1 and a recess 25 disposed between the protrusions 20. The recess 25 is a portion where no protrusion is

formed in the organic film, and it may be a so-called flat portion. In the present invention, the organic film 2 contains a silane coupling agent and has an uneven shape (in particular, the protrusion 20). From another viewpoint, both the recess (that is, the flat portion) and the protrusion constituting the organic film 2 contain a silane coupling agent, and the protrusion is formed of an aggregate containing the silane coupling agent. As a result, an anchor effect based on the uneven shape (in particular, the protrusion 20) of the organic film 2 and an adhesion effect based on the silane coupling agent work, and the adhesion between the metal and the resin becomes stronger. Specifically, the organic film containing the silane coupling agent causes the adhesion effect of the organic film itself to work, and the adhesive properties between the metal and the resin can be enhanced. Thus, since the protrusion is formed of the aggregate containing the silane coupling agent, the contact area between the silane coupling agent and the resin increases, and the adhesive properties between the metal and the resin can be more sufficiently improved. As a result, even though the metal surface (in particular, the metal circuit surface) is not subjected to roughening treatment, the adhesive properties between the metal circuit and the insulating resin layer can be more sufficiently improved by the anchor effect of the uneven shape (in particular, the protrusion) of the organic film and the adhesion effect of the silane coupling agent (in particular, the effect of increasing the contact area between the silane coupling agent and the resin). In addition, since no uneven shape of the metal surface for enhancing the adhesive properties between the metal and the resin is necessary, it is possible to prevent deterioration of electrical characteristics due to the skin effect. In such an organic film, when the protrusion is formed only of inorganic particles, only an increase in the contact area between the protrusion and the resin is obtained, but the contact area between the silane coupling agent and the resin is not increased, and thus, adhesive properties between the metal and the resin is not sufficiently obtained. In Fig. 1, the protrusion 20 includes protrusions 20A, 20B, and 20C. Fig. 1 is a schematic cross-sectional view of an example of the organic film obtained using the metal surface treatment liquid of the present invention.

The protrusion 20 may have any shape as long as it protrudes to the side opposite to the metal 1. The protrusion 20 may have, for example, a polygonal shape such as a triangular shape, a quadrangular shape and a trapezoidal shape; a circular shape; an elliptical shape; a mountain-like shape; and an irregular shape, or the like in a cross-sectional view, may have a tuft shape in which a plurality of particles are connected as indicated by reference numeral "20A" in Fig. 1, may have an umbrella open shape (for example, a mushroom shape) in which an umbrella is opened as indicated by reference numerals "20B" and "20C", or may have a composite shape thereof. The protrusion 20 may have a porous shape including pores.

The protrusion 20 may be formed of an aggregate containing a silane coupling agent, and in this case, the aggregate may be an aggregate (secondary particle) of particles (primary particles) containing a silane coupling agent. The shape of the particles (primary particles) containing the silane coupling agent may have a spherical shape, a polyhedral shape, an irregular shape, or the like. When the protrusion has the form of an aggregate containing a silane coupling agent, the contact area between the organic film and the resin is more sufficiently increased. Thus, adhesive properties between the metal circuit and the resin layer can be more sufficiently improved.

The particles (primary particles) containing a silane coupling agent may be brought into contact with each other or necked (bonded) to form an aggregate (secondary particle), and the aggregate (secondary particle) may have a porous shape including pores. When the aggregate as the protrusion has a porous shape including pores, not only the contact area between the organic film and the resin is more sufficiently increased, but also the anchor effect due to the entry of the resin into the pores functions more sufficiently. As a result, the adhesive properties between the metal circuit and the resin layer can further sufficiently improve.

The size of the particles (primary particles) containing a silane coupling agent is usually 1 to 1000 nm, and is preferably 5 to 500 nm, more preferably 10 to 250 nm, and still more preferably 20 to 200 nm from the viewpoint of further improving the adhesive properties between metal and resin and chemical resistance properties. The size of the particle (primary particle) containing a silane coupling agent is the average value of the maximum lengths of any 100 primary particles in plan view.

The protrusion 20 may have a width-direction cut shape having a cut 200 in a width direction w in a cross-sectional view. Specifically, the width-direction cut shape is a shape having a cut 200 cut in a direction in which the width is narrowed in the width direction w as shown in Figs. 1 and 2 in a cross-sectional view. As shown in Figs. 1 and 2, the cut 200 is usually formed in a base portion of the protrusion 20. The base portion of the protrusion 20 is a root portion of the protrusion 20, and may be a portion (or a boundary portion) in the vicinity of the recess (flat portion) 25 in the protrusion 20. In Fig. 1, a plurality of protrusions 20 are independently formed on the surface of the organic film 2, but they may be connected to each other at upper portions of the protrusions 20 to partially or entirely have a mesh shape or a porous shape in plan view, for example, as shown in Figs. 3B, 3C, 3D, 4B, 4C, 4D, and 4E. Fig. 2 is a schematic cross-sectional view of an example of the organic film obtained with the surface treatment of the present invention, which is a partially enlarged view showing the vicinity of a protrusion in an enlarged manner. Figs. 3B, 3C, and 3D are micrographs (SEM photographs) (secondary electron image at 30,000 times, secondary electron image at 5,000 times, and reflected electron image at 5,000 times, respectively) based on a plan view of a test piece having the organic film of the present invention, and are examples of SEM photographs showing protrusions of the organic film obtained with the surface

treatment of the present invention on a surface opposite to the metal (Example 1). Figs. 4B, 4C, 4D, and 4E are micrographs (SEM photographs) (secondary electron image at 50,000 times, secondary electron image at 30,000 times, secondary electron image at 5,000 times, and reflected electron image at 5,000 times, respectively) based on a plan view of a test piece having the organic film of the present invention, and are examples of SEM photographs showing protrusions of the organic film obtained with the surface treatment of the present invention on a surface opposite to the metal (Example 2).

Since the protrusion 20 includes the cut 200 at the base portion, the anchor effect functions more effectively, and the adhesion between the metal and the resin further sufficiently improves. When the protrusion 20 includes the cut 200 at the base portion, each protrusion 20 includes the cut 200 on both sides in the width direction w in Figs. 1 and 2, but it may have the cut only on one side.

Since the protrusion 20 has a tuft shape in which a plurality of particles are connected, the anchor effect functions more effectively, and the adhesion between the metal and the resin further sufficiently improves.

Since the protrusion 20 has a porous shape including pores, the anchor effect functions more effectively, and the adhesion between the metal and the resin further sufficiently improves.

The protrusion length of the protrusion 20 is usually 20 to 5000 nm, and is preferably 50 to 800 nm, more preferably 70 to 600 nm, still more preferably 100 to 500 nm, particularly preferably 310 to 460 nm, and sufficiently preferably 350 to 450 nm from the viewpoint of further improving adhesive properties between the metal and the resin and chemical resistance properties.

The protrusion length of the protrusion 20 is a difference between the average height of the protrusion 20 and the average height of the recess 25.

As shown in Fig. 2, the average height of the protrusion 20 is an average value of a length (distance) h1 from a metal-side surface 21 of the organic film 2 to an organic film surface 22 at the highest portion of the protrusion 20 in a cross-sectional view.

Specifically, a value obtained by the following method is used as the average height of the protrusion 20.

Each of secondary electron images (30,000 times) in SEM observation of any three fields based on the cross-sectional view is divided into four regions uniform in the width direction.

When the protrusion 20 is confirmed in each region, a maximum height h1 is measured, and the average of h1 in the measurement region where the protrusion 20 is confirmed is obtained.

The average height of the recess 25 corresponds to the thickness of the flat portion of the organic film 2, and is an average value of a length (distance) h2 from the metal-side surface 21 of the organic film 2 to an any point on the organic film surface 22 of the recess 25 in a cross-sectional view as shown in Fig. 2.

Specifically, a value obtained by the following method is used as the average height of the recess 25.

Each of secondary electron images (100,000 times) in SEM observation of any three fields based on the cross-sectional view is divided into four regions uniform in the width direction.

The height h2 of the recess at any one point in each region is measured, and the average of 12 points in total is obtained.

The average height of the recesses 25 (the thickness of the flat portion of the organic film 2) is not particularly limited, and is usually 10 to 300 nm, and is preferably 10 to 100 nm, more preferably 15 to 80 nm, still more preferably 15 to 60 nm, particularly preferably 15 to 50 nm, sufficiently preferably 15 to 40 nm, and more sufficiently preferably 25 to 40 nm from the viewpoint of further improving the adhesive properties between the metal and the resin and the chemical resistance properties.

The protrusion ratio of the protrusion 20 is usually 10 to 5000%, and is preferably 50 to 3000% (for example, 100 to 3000%), more preferably 100 to 2000% (for example, 200 to 2000%), still more preferably 200 to 1500% (for example, 500 to 1500%), particularly preferably 800 to 1500%, sufficiently preferably 1000 to 1500%, and more sufficiently preferably 1200 to 1500% from the viewpoint of further improving the adhesive properties between metal and resin and chemical resistance properties.

The protrusion ratio of the protrusion 20 is a ratio of the protrusion length of the protrusion 20 to the average height of the recess 25.

The protrusion 20 occupies a certain range in a plan view of the organic film 2. The protrusions 20 are preferably connected to each other at a portion higher than the base portion in plan view in order to have a mesh shape or a porous shape at least in part (that is, partially or entirely), for example, as shown in Figs. 3B, 3C, 3D, 4B, 4C, 4D, and 4E.

The occupation ratio of the protrusion 20 is not particularly limited as long as the effect of improving the adhesive properties between the metal and the resin is obtained, and may be, for example, 10 to 95%, and is preferably 20 to 90%, more preferably 40 to 85%, still more preferably 45 to 80%, and particularly preferably 50 to 80% from the viewpoint of further improving the adhesive properties between metal and resin, chemical resistance properties, and storage stability. In a plan view of the organic film 2, a region not occupied by the protrusion 20 is usually constituted by the recess (that is, the flat portion) 25.

As shown in Figs. 3B, 3C, 3D, 4B, 4C, 4D, and 4E, the occupancy ratio of the protrusion 20 is a ratio of the

protrusion 20 to the entire organic film 2 in plan view.

Specifically, a value obtained by the following method is used as the occupancy ratio of the protrusion 20.

For each of the reflected electron images (5,000 times) in SEM observation of any five fields of view based on a plan view, binarization is performed with reference to a threshold determined by a method of Yen, a percentage of the number of pixels of the protrusion 20 to the number of pixels of the entire image is calculated, and an occupancy ratio of the protrusion is obtained. An average value of the occupancy ratios of the protrusion in the visual fields is used as the occupancy ratio of the protrusion.

The lower limit value of the surface roughness (line roughness) represented by a roughness parameter based on JIS B0633:2001 of the organic film 2 is not particularly limited, and is preferably as follows from the viewpoint of further improving the adhesive properties between metal and resin:

For example, Ra (arithmetic average roughness) is preferably 0.08 μm or more, more preferably 0.09 μm or more, still more preferably 0.10 μm or more, and particularly preferably 0.17 μm or more.
For example, Rz (maximum height roughness) is preferably 0.70 μm or more, more preferably 0.80 μm or more, still more preferably 0.90 μm or more, and particularly preferably 1.00 μm or more.

The upper limit value of the surface roughness (line roughness) is not particularly limited, and is preferably as follows from the viewpoint of further improving the adhesive properties between the metal and the resin and the chemical resistance properties:

For example, Ra is 0.50 μmor less, more preferably 0.30 μm or less, still more preferably 0.25 μm or less, and particularly preferably 0.23 μm or less.
For example, Rz is preferably 15.0 μm or less, more preferably 8.00 μm or less, still more preferably 5.00 μm or less, and particularly preferably 2.00 μm or less.

As the surface roughness (Ra and Rz) of the organic film, an average value of values measured at any five positions by the following method is used.

Apparatus: Laser microscope VK-8710 (manufactured by KEYENCE CORPORATION)
Conditions: Cutoff wavelength: 0.8 mm, magnification: 1000 times

The range of the surface roughness (plane roughness) represented by the parameter of the surface property based on ISO 25178 of the organic film 2 is not particularly limited, but from the viewpoint of further improving the adhesive properties between metal and resin, the following parameters related to the surface roughness of the organic film 2 are each preferably the following ranges:

- Sa (arithmetic average height) is preferably 0.01 μm or more and 0.5 μm or less, more preferably 0.03 μm or more and 0.3 μm or less, and still more preferably 0.05 μm or more and 0.25 μm.
- Sq (root mean square height) is preferably 0.01 μm or more and 0.6 μm or less, more preferably 0.03 μm or more and 0.4 μm or less, still more preferably 0.05 μm or more and 0.3 μm.
- Sz (maximum height) is preferably 0.2 μm or more and 15 μm or less, more preferably 0.3 μm or more and 8 μm or less, and still more preferably 0.5 μm or more and 5 μm or less.
- Sp (maximum peak height) is preferably 0.1 μm or more and 10 μm or less, more preferably 0.15 μm or more and 5 μm or less, and still more preferably 0.2 μm or more and 3 μm or less.
- Sv (maximum valley depth) is preferably 0.1 μm or more and 10 μm or less, more preferably 0.15 μm or more and 5 μm or less, and still more preferably 0.2 μm or more and 3 μm or less.
- Ssk (skewness (tendentiousness degree)) is preferably -1 or more and 1 or less, more preferably -0.6 or more and 0.6 or less, and still more preferably -0.4 or more and 0.4 or less.
- Sku (kurtosis (sharpening degree)) is preferably 2 or more and 5 or less, and more preferably 2.5 or more and 4 or less.
- Sal (minimum autocorrelation length (s = 0.2)) is preferably 0.2 μm or more and 10 μm or less, more preferably 0.3 μm or more and 5 μm or less, and still more preferably 0.35 μm or more and 3 μm or less.
- Str (aspect ratio of surface shape (s = 0.2)) is preferably 0.4 or more and 1 or less, and more preferably 0.5 or more and 1 or less.
- Std (direction of the surface shape) is preferably an unbiased distribution.
- Sdq (root mean square slope) is preferably 0.1 or more and 5 or less, more preferably 0.2 or more and 3 or less, and still more preferably 0.3 or more and 2 or less.
- Sdr (developed area ratio of the interface) is preferably 0.01 or more and 2 or less, more preferably 0.02 or more and 1.5 or less, and still more preferably 0.05 or more and 1 or less.

- Sk (level difference of the core portion) is preferably 0.05 μm or more and 10 μm or less, more preferably 0.1 μm or more and 5 μm or less, and still more preferably 0.15 μm or more and 3 μm or less.
- Spk (protruding mountain portion height) is preferably 0.02 μm or more and 5 μm or less, more preferably 0.04 μm or more and 3 μm or less, and still more preferably 0.05 μm or more and 1 μm or less.
- Svk (protrusion valley height) is preferably 0.02 μm or more and 5 μm or less, more preferably 0.04 μm or more and 3 μm or less, and still more preferably 0.05 μm or more and 1 μm or less.
- Smr1 (load area ratio for separating the protruding mountain portion and the core portion) is preferably 5% or more and 20% or less, and more preferably 7% or more and 15% or less.
- Smr2 (load area ratio for separating the protrusion valley and the core portion) is preferably 80% or more and 95% or less, and more preferably 85% or more and 93% or less.
- Sxp (extreme point height (difference in height between 2.5% loading area ratio and 50% loading area ratio)) is preferably 0.02 μm or more and 10 μm or less, more preferably 0.05 μm or more and 5 μm or less, and still more preferably 0.1 μm or more and 3 μm or less.
- Vvv (void volume of valley) is preferably 2 $\mu L/m^2$ or more and 500 $\mu L/m^2$ or less, more preferably 4 $\mu L/m^2$ or more and 250 $\mu L/m^2$ or less, and still more preferably 5 $\mu L/m^2$ or more and 100 $\mu L/m^2$ or less.
- Vvc (void volume of the core part) is preferably 10 $\mu L/m^2$ or more and 3500 $\mu L/m^2$ or less, more preferably 30 $\mu L/m^2$ or more and 1500 $\mu L/m^2$ or less, still more preferably 50 $\mu L/m^2$ or more and 500 $\mu L/m^2$ or less.
- Vmp (actual volume of the mountain portion) is preferably 1 $\mu L/m^2$ or more and 1000 $\mu L/m^2$ or less, more preferably 2 $\mu L/m^2$ or more and 500 $\mu L/m^2$ or less, still more preferably 2.5 $\mu L/m^2$ or more and 150 $\mu L/m^2$ or less.
- Vmc (actual volume of the core portion) is preferably 10 $\mu L/m^2$ or more and 3500 $\mu L/m^2$ or less, more preferably 30 $\mu L/m^2$ or more and 1500 $\mu L/m^2$ or less, still more preferably 50 $\mu L/m^2$ or more and 500 $\mu L/m^2$ or less.
- Spd (peak density of mountain (mountains higher than 5% of the maximum amplitude are counted)) is preferably 2 $\times 10^6/mm^2$ or more and 10 $\times 10^6/mm^2$ or less, more preferably 3 $\times 10^6/mm^2$ or more and 8 $\times 10^6/mm^2$ or less, and still more preferably 4 $\times 10^6/mm^2$ or more and 6 $\times 10^6/mm^2$ or less.
- Spc (arithmetic mean curvature of mountain peak (only curvature of mountain peak higher than 5% height of maximum amplitude)) is preferably 1 $\times 10^3$/m or more and 50 $\times 10^3$/m or less, more preferably 3 $\times 10^3$/m or more and 30 $\times 10^3$/m or less, and still more preferably 5 $\times 10^3$/m or more and 20 $\times 10^3$/m or less.

As the parameter of the surface roughness (plane roughness) of the organic film, that is, the parameter related to the surface roughness, an average value measured at any five points by the following method is used.

Apparatus: Laser microscope VK-X3000 (manufactured by KEYENCE CORPORATION)
Measurement magnification: Objective lens 50 times/zoom 3 times
Measurement area: 6800 $\mu m^2$
Surface filtering: Surface filtering with a Gaussian filter and an L filter (cutoff wavelength: 0.01 mm) was performed as necessary for noise removal and base copper surface shape removal, and plane roughness of only the organic film was measured.

In the organic film, both the protrusion 20 and the recess (that is, the flat portion) 25 have the same composition in that they contain a silane coupling agent (in particular, the protrusion 20 is formed of an aggregate containing a silane coupling agent). This is apparent from the following points:

- A peak of an element (for example, C, Si, O) constituting a compound of a silane coupling agent is detected from the protrusion 20 and the recess (that is, the flat portion) 25 in elemental analysis by energy dispersive X-ray spectroscopy (SEM-EDX) in a cross-sectional view (in particular, the peaks of these elements are detected sufficiently larger than the peaks of other elements). In particular, when a silane coupling agent containing a nitrogen atom in the molecule is used, a peak of an element (for example, C, Si, O, N) constituting a compound of the silane coupling agent is detected from the protrusion 20 and the recess (that is, the flat portion) 25, and a peak of an element (for example, Cu) of a metal ion constituting a complex with the silane coupling agent containing a nitrogen atom in the molecule is detected (in particular, the peaks of these elements are detected sufficiently larger than the peaks of other elements);
- In a production step of the organic film, the protrusion 20 and the recess (that is, the flat portion) 25 start to be formed almost simultaneously only by bringing a specific surface treatment liquid into contact with the surface of the metal.

The organic film 2 may be disposed in direct or indirect contact with the surface of the metal 1. Specifically, as shown in Figs. 1 and 2, the organic film 2 may be disposed in direct contact with the surface of the metal 1, or may be disposed in indirect contact with the surface of the metal 1 by interposing another film therebetween.

In Figs. 1 and 2, the metal 1 is the above-described "metal to be subjected to surface treatment using the surface treatment liquid of the present invention".

A resin is usually disposed on the side of the organic film 2 opposite to the metal 1. As a result, the organic film 2 is usually present between the metal 1 and the resin. The resin may have any shape, for example, a layer shape.

Examples of such a resin material include nylon, an acrylate resin, an epoxy resin, a polybenzoxazole resin, a silicone resin, a polyimide resin, a bismaleimide resin, a maleimide resin, a cyanate resin, a polyphenylene ether resin, a polyphenylene oxide resin, a polybutadiene resin, an olefin resin, a fluorine-containing resin, a polyetherimide resin, a polyetheretherketone resin, and a liquid crystal resin. The resin material may be a combination of these resin materials mixed or modified with each other. Among these resin materials, a polyphenylene ether resin, a polyphenylene oxide resin, a liquid crystal resin, an acrylate resin, an epoxy resin, an olefin resin, a polybenzoxazole resin, a silicone resin, and a polyimide resin are preferable, and an epoxy resin is particularly preferable. Such a resin material may contain a filler such as silica or alumina for the purpose of, for example, improving heat resistance or reducing the coefficient of thermal expansion (CTE).

[Concentrated Liquid of Metal Surface Treatment Liquid (Metal Surface Treatment Stock Solution)]

The present invention also provides a concentrated liquid of the metal surface treatment liquid.

The concentrated liquid of the surface treatment liquid is a liquid (for example, an aqueous solution) (that is, a liquid before dilution) to be diluted with water (for example, only water) and used, and specifically, is a liquid (that is, a liquid before dilution) from which the surface treatment liquid is obtained by dilution with water (for example, only water). In the present invention, such a concentrated liquid of the surface treatment liquid is also referred to as a "surface treatment stock solution".

The concentrated liquid of the metal surface treatment liquid is a concentrated liquid for producing the metal surface treatment liquid by being diluted with water (for example, only water). The concentration of each of the above-described components in the concentrated liquid of the metal surface treatment liquid of the present invention is not particularly limited as long as the surface treatment liquid obtained by dilution finally contains all the above-described components, but it is preferable that the concentration is such that the surface treatment liquid can finally contain all the above-described components at a predetermined concentration. Thus, the concentration of each component in the concentrated liquid of the surface treatment liquid of the present invention is set to a relatively high concentration according to the assumed dilution rate. The dilution ratio is, for example, 1.1 to 10 times, preferably 1.1 to 8 times, and more preferably 1.1 to 5 times. The dilution ratio is represented by a value obtained by dividing the volume of the surface treatment liquid obtained after dilution by the volume of the concentrated liquid before dilution.

In the concentrated liquid of the surface treatment liquid of the present invention, the pH is not particularly limited, but it is preferable that the pH is such that the surface treatment liquid obtained by dilution with water (for example, only water) finally has the above-described pH.

The water used for dilution is preferably pure water such as ion-exchanged water, distilled water, and purified water. The water used for dilution may be water only.

[Metal Surface Treatment Liquid Set]

The present invention also provides a metal surface treatment liquid set.

The metal surface treatment liquid set of the present invention includes a first liquid and a second liquid. The first liquid and the second liquid are combined and distributed on the market, for example, while being stored in separate containers. The first liquid and the second liquid being combined and distributed on the market includes not only a case where the first liquid and the second liquid are integrally handled in the market, such as a case where the first liquid and the second liquid are sold as a set, but also a case where the first liquid and the second liquid are distributed separately but it is suggested that the first liquid and the second liquid are used in combination with each other with an instruction manual or the like. The first liquid and the second liquid are mixed with each other to produce the metal surface treatment liquid. The metal surface treatment liquid is a metal surface treatment liquid containing a silane coupling agent, an acid, and other components contained as desired.

In one embodiment of the metal surface treatment liquid set of the present invention, the silane coupling agent is contained in the first liquid, and the acid and the other component are each independently contained in the first liquid and/or the second liquid. Specifically, the acid and the other component may be each independently included in one of the first liquid or the second liquid, or may be included in both of them.

The first liquid and the second liquid are usually aqueous solutions. The concentration of each of the above-described components in the first liquid and the second liquid is not particularly limited as long as the surface treatment liquid obtained by mutual mixing finally contains all the above-described components, but it is preferable that the concentration is such that the surface treatment liquid can finally contain all the above-described components at a predetermined concentration.

[Bonding Method]

The present invention also provides a method for bonding a metal and a resin material. The method for bonding a metal and a resin material is not particularly limited as long as the surface treatment liquid of the present invention is used, and can be performed, for example, by the following method. The surface treatment liquid of the present invention is brought into contact with the surface of the metal to form an organic film on the surface of the metal, and then a resin layer (for example, a base material) made of a resin material is formed on the surface of the metal via the organic film. After the organic film formed on the metal surface is dried, a resin layer may be formed on the surface of the organic film. The method for forming the resin layer is not particularly limited as long as the resin layer including the resin material is formed on a part or the whole of the organic film, and examples thereof include a method of applying or pressure-bonding the resin material, a method of bonding the resin material with an adhesive or an adhesive sheet (film), and a method of combining these means. It is preferable that the organic film is disposed in direct contact with the surface of the metal, and the resin layer is disposed in direct contact with the surface of the organic film.

[Printed Wiring Board and Method for Producing Same]

The present invention also provides a printed wiring board and a method for producing the printed wiring board. The printed wiring board of the present invention includes the organic film described above. In the method for producing a printed wiring board of the present invention, the bonding method is used. That is, the method for producing a printed wiring board of the present invention includes a step of bringing the surface treatment liquid of the present invention into contact with the surface of the metal circuit of the printed wiring board to form an organic film. The metal circuit of the printed wiring board is a metal (that is, wiring) constituting a circuit in the printed wiring board.

By forming an organic film on the surface of a metal using the surface treatment liquid of the present invention, adhesive properties to a resin material can be enhanced, and thus, the organic film can be suitably used for various electric and electronic components in which a metal and a resin material are composited, and electronic devices including printed wiring boards and the like. In the printed wiring board, the organic film is disposed between a metal (in particular, a metal circuit) and a resin (insulating resin layer).

In the present invention, the surface treatment liquid of the present invention can be suitably used particularly for a base material formed of copper or a copper alloy. The surface treatment liquid of the present invention is suitable, for example, for surface treatment of copper or a copper alloy for the purpose of improving adhesive properties (close contact properties) between a copper circuit (copper wiring layer) and a prepreg or solder resist (insulating resin layer), and can improve adhesive properties between the copper wiring layer and the insulating resin layer in a printed wiring board having the insulating resin layer in contact with the copper wiring layer.

Specifically, the printed wiring board can be produced by bringing the surface treatment liquid of the present invention into contact with the surface of the copper wiring layer, then washing with water as necessary, subsequently drying, and then forming an insulating resin layer on the surface of the copper wiring layer.

The contact method is as described above, and immersion of the copper wiring layer in a surface treatment liquid, spraying of the treatment liquid onto the copper wiring layer, or the like is simple, reliable, and preferable.

The method of water washing is not particularly limited either, but immersion of the copper wiring layer in cleaning water or spraying of cleaning water onto the surface of the copper wiring layer is simple, reliable, and preferable.

For the formation of the insulating resin layer, a known method, for example, a method of sticking a semi-cured resin material, a method of applying a liquid resin material containing a solvent, or the like can be adopted.

Next, a via hole is formed in order to conduct upper and lower wirings. Repeating this process makes it possible to produce a multilayer printed wiring board.

The copper wiring layer may be produced by a method such as an electroless plating method, an electrolytic plating method, a vapor deposition method, a sputtering method, or a damascene method, or may include an inner via hole, a through hole, a connection terminal, or the like.

The "copper" according to the present invention is used in applications and forms of thin films and grains, needles, fibers, wires, rods, tubes, plates, and the like formed by a foil (electrolytic copper foil, rolled copper foil, resin-attached copper foil, ultra-thin electrolytic copper foil, electroless copper foil, sputtered copper foil, thin copper foil), a plating film (electroless copper plating film, electrolytic copper plating film), a vapor deposition method, a sputtering method, a damascene method, and the like used for electronic devices such as printed wiring boards and lead frames, decorative articles, building materials, and the like. In the case of a copper wiring layer through which a high-frequency electric signal flows in recent years, the surface of copper is preferably a smooth surface having an arithmetic average roughness (Ra) of 0.1 $\mu$m or less. The surface of copper may be plated with nickel, zinc, chromium, tin, or the like as a pretreatment.

The ultra-thin electrolytic copper foil to be treated with the surface treatment solution of the present invention is an ultra-thin electrolytic copper foil to be used in a printed wiring board obtained by a method including a step of forming a circuit by any of a semi-additive method, a subtractive method, a part-additive method, a modified semi-additive method, an advanced modified semi-additive method, and a primer semi-additive method. The ultra-thin electrolytic copper foil may include a copper foil carrier, a release layer stacked on the copper foil carrier, and an ultra-thin copper layer stacked on the release layer. The surface of the copper may be subjected to at least one pretreatment selected from the group consisting of pickling treatment, roughening treatment, heat resistance treatment, rust prevention treatment, and chemical conversion treatment.

(Roughened Layer)

The roughened layer formed by subjecting the surface of the copper foil to a roughening treatment includes fine granular copper particles precipitated on the surface of the copper foil of the copper-clad laminate. Since fine granular copper particles are deposited on the surface of the copper foil, an interval between unevenness formed on the surface of the copper foil (a distance between a top portion and a valley portion of the unevenness) can be increased. Then, the mechanical bonding force between the copper foil layer and the insulating resin layer of the copper-clad laminate can be improved.

The method for stacking the roughened layer is not particularly limited as long as the above effect is exhibited, and a known method can be adopted. For example, fine granular copper particles can be deposited on the surface of the copper foil by appropriately adjusting the voltage applied using an electrolytic copper foil production apparatus, the concentration of the electrolytic solution including the sulfuric acid acidic copper sulfate solution, and the like.

(Heat Resistant Treatment Layer)

When a heat resistant treatment layer formed by subjecting the copper foil surface to a heat resistant treatment is stacked, it is possible to suppress a decrease in adhesive properties between the copper foil and the insulating resin layer due to heat generated by reflow heating or the like. The heat resistant treatment layer can exhibit the above-described function by being formed of at least one selected from a compound containing nitrogen, nickel, zinc, chromium zinc, a nickel alloy, a zinc alloy, and a chromium alloy.

The method for stacking the heat resistant treatment layer is not particularly limited as long as the above-described effect is exhibited, and a known method can be adopted. For example, in the case of a compound containing nitrogen, a method can be adopted in which a treatment liquid is prepared by dissolving the compound in water or an organic solvent, and the treatment liquid is brought into contact with the surface of the copper foil by means such as spraying or immersion. In addition, in the case of the metal and the alloy, electroplating, vapor deposition, or other methods can be adopted.

(Rustproofing Treatment Layer)

When a rustproofing treatment layer formed by subjecting the copper foil surface to a rustproofing treatment is stacked, oxidation and the like of the copper foil can be prevented. The rust prevention treatment layer can exhibit the above-described function by being formed of a compound containing nitrogen or by being formed by zinc-chromate or chromate treatment.

The method for stacking the rustproofing treatment layer is not particularly limited as long as the above-described effect is exhibited, and a known method can be adopted. The case of a compound containing nitrogen is as described above. In addition, for example, by adopting an electric chromate treatment, a chromate film of chromium oxide or the like can be formed.

Another utilization example of the metal surface treatment liquid is shown below. Thus, the organic film described above produced from the surface treatment liquid is also useful in the following utilization examples.

For example, in an application example in a semiconductor wafer, the metal surface treatment liquid is suitable for surface treatment of a semiconductor circuit for the purpose of improving adhesive properties (close contact properties) between the semiconductor circuit formed on the semiconductor wafer and a protective film (for example, an insulating protective film such as a photosensitive positive type, a photosensitive negative type, or a non-photosensitive buffer coat or a bump protective film.).

For example, the metal surface treatment liquid is suitable for surface treatment of a copper circuit rewiring layer for the purpose of improving adhesive properties (close contact properties) between the copper circuit rewiring layer and an insulating material in a package substrate (WL-CSP, FO-WLP, PLP) or a 2.5 dimensional (2.5D) or three-dimensional (3D) interposer substrate for forming a rewiring layer on a semiconductor wafer.

For example, in an application example in a lead frame at the time of wire bonding mounting, the metal surface

treatment liquid is suitable for surface treatment of a lead frame for the purpose of improving adhesive properties (close contact properties) with a sealing resin or an adhesive at the time of mounting a semiconductor chip on a metal surface in a lead frame forming step, a frame metal surface after mounting a semiconductor chip (before and after a die bonding and pre-baking step), a frame metal surface after wire bonding mounting, or a frame metal surface in a step before resin sealing (resin molding, before and after baking step).

For example, in an application example in a lead frame at the time of flip-chip mounting, the metal surface treatment liquid is suitable for surface treatment of a lead frame for the purpose of improving adhesive properties (close contact properties) with a sealing resin or an adhesive at the time of mounting a semiconductor chip on a metal surface in a lead frame forming step, a lead frame metal surface after a bonding material (solder, Au plating, Sn plating, and the like) is temporarily placed, a frame metal surface after a semiconductor chip is mounted (before and after alignment and chip mount baking step), a lead frame metal surface after main curing (before and after steps such as reflow heating, thermocompression bonding, ultrasonic wave, and plasma), and a lead frame metal surface in a step until resin sealing.

For example, in an application example in a fine wiring substrate in which an integration technology for closely disposing semiconductor chips is enhanced, the metal surface treatment liquid is also suitable for surface treatment of a copper circuit wiring layer for the purpose of improving adhesive properties (close contact properties) between the copper circuit wiring layer and an insulating material in a 2.1 dimensional (2.1 D) organic substrate or glass substrate, a component built-in substrate (EPS substrate) in which a semiconductor is built in a substrate, and a coreless substrate.

For example, the metal surface treatment liquid is suitable for surface treatment of a copper circuit wiring layer for the purpose of improving adhesive properties (close contact properties) between a copper circuit wiring layer and an insulating material in a case where pattern wiring is built in, upper and lower layers are subjected to laser via processing, and via fill plating is performed, or a copper pillar formed by plating is used for conduction between the upper and lower layers, and a circuit embedded substrate (ETS substrate) using MIS using a mold resin is used for the insulating layer.

## EXAMPLES

Hereinafter, the present invention will be specifically described with reference to Examples and Comparative Examples, but the present invention is not limited to these.

[Materials Used]

- Silane coupling agent:
  The following azole silane coupling agents AS-1 and AS-2 were used.

(Azole silane coupling agent AS-1)

An azole silane coupling agent AS-1 was synthesized by the following synthesis method.

The synthesis method was in accordance with WO 2019/058773.

Specifically, to a solution containing 23.4 g (0.275 mol) of 5-amino-1H-tetrazole and 220 mL of dehydrated N,N-dimethylformamide, 93.6 g (0.275 mol) of a 20% sodium ethoxydoethanol solution was added at room temperature, and the mixture was stirred for 30 minutes. Subsequently, 66.3 g (0.275 mol) of 3-chloropropyltriethoxysilane was added dropwise at 70°C over 1 hour, and the mixture was stirred at 98 to 100°C for 20 hours. The suspended reaction solution was cooled to 7°C, and insoluble matter was removed by filtration. Thereafter, the volatiles (solvent and the like) were distilled off under reduced pressure to obtain a concentrate in an amount of 91 g. This concentrate was diluted (dispersed and dissolved) with 220 mL of isopropyl acetate, washed three times with 220 mL of saturated saline, and the organic layer was dried over magnesium sulfate, and then the volatiles (solvent and the like) were distilled off under reduced pressure to obtain a liquid concentrate in an amount of 73.6 g. This concentrate was washed with 220 mL of hexane, and the volatiles (solvent and the like) were distilled off under reduced pressure to obtain a light brown liquid in an amount of 65.8 g (0.227 mol, yield 82.7%).

$^1$H-NMR spectrum data of the obtained light brown liquid was as follows.

$^1$H-NMR (DMSO-$d_6$) $\delta$: 0.52 (t, 2H, J = 8Hz, $-CH_2-Si$), 1.14 (t, 9H, J = 7Hz, $Si-O-CH_2CH_3$), 1.75 (m, 1.2H, $-CH_2CH_2-Si$), 1.88 (m, 0.8H, $-CH_2CH_2-Si$), 3.74 (q, 6H, J = 7Hz, $Si-O-CH_2$), 4.06 (t, 1.2H, J = 7Hz, $NCH_2-$), 4.36 (t, 0.8H, J = 7Hz, $NCH_2-$), 5.97 (s, 0.8H, $NH_2$), 6.65 (s, 1.2H, $NH_2$).

From this $^1$H-NMR spectrum data, the obtained light brown liquid was recognized to be a mixture containing 5-amino-1-[3-(triethoxysilyl)propyl]-1H-tetrazole and 5-amino-2-[3-(triethoxysilyl)propyl]-2H-tetrazole represented by the following structural formula in a ratio (mol%) of 40 : 60.

[Chemical Formula 11]

(AS-1)

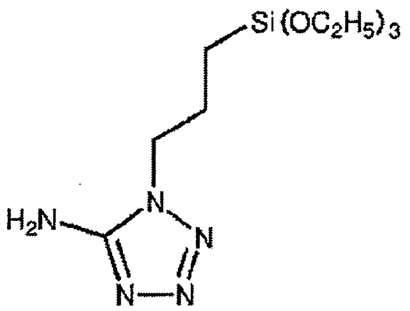

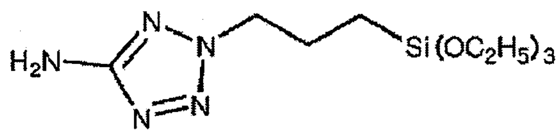

(Azole silane coupling agent AS-2)

An azole silane coupling agent AS-2 was synthesized by the following synthesis method.

To a solution of 17.9 g (0.15 mol) of 1H-benzotriazole and 120 mL of dehydrated N,N-dimethylformamide, 28.8 g (0.15 mol) of a 28% sodium methoxidemethanol solution was added at room temperature, and the mixture was stirred for 20 minutes. Subsequently, 29.7 g (0.15 mol) of 3-chloropropyltrimethoxysilane was added, and the mixture was stirred at 89 to 91 °C for 4 hours. The suspended reaction liquid was concentrated to 90 g under reduced pressure, and the concentrate was diluted (dispersed and dissolved) with 100 mL of ethyl acetate, washed three times with 80 mL of saturated saline, and the organic layer was dried over magnesium sulfate, and then the volatiles (solvent and the like) were distilled off under reduced pressure to obtain a colorless liquid in an amount of 39.3 g (0.14 mol, yield 93.1%).

$^1$H-NMR spectrum data of the obtained colorless liquid was as follows.

$^1$H-NMR (DMSO-$d_6$) $\delta$: 0.60 (m, 2H, $-CH_2-Si$), 2.01 (m, 1.2H, $-CH_2-CH_2-Si$), 2.11 (m, 0.8H, $-CH_2-CH_2-Si$), 3.48 (s, 5.4H, $Si-O-CH_3$), 3.46 (s, 3.6H, $Si-O-CH_3$), 4.73 (m, 2H, $N-CH_2-$), 7.42 to 8.07 (m, 4H in total, aromH).

From this $^1$H-NMR spectrum data, the obtained colorless liquid was recognized to be a mixture of 1-[3-(trimethoxysilyl)propyl]-1H-benzotriazole and 2-[3-(trimethoxysilyl)propyl]-2H-benzotriazole represented by the following structural formula.

[Chemical Formula 12]

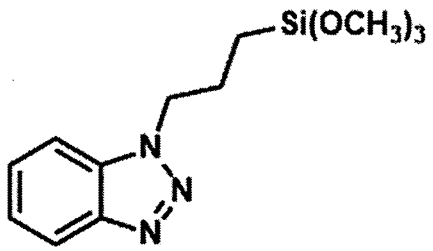

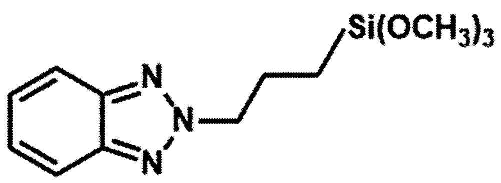

The following acids and bases were used as additive components of the surface treatment liquid.

• Acid:

Tosylic acid, sulfuric acid, methanesulfonic acid, camphorsulfonic acid, acetic acid, or nitric acid was used. At the time of preparation of the surface treatment liquid, tosylic acid/monohydrate (solid) was used as tosylic acid, 70% sulfuric acid was used as sulfuric acid, methanesulfonic acid (liquid) manufactured by FUJIFILM Wako Pure Chemical Corporation was used as methanesulfonic acid, camphorsulfonic acid (solid) manufactured by FUJIFILM Wako Pure Chemical Corporation was used as camphorsulfonic acid, 60% nitric acid was used as nitric acid, and 80% acetic acid was used as acetic acid.

• Base:

NaOH was used. At the time of preparation of the surface treatment liquid, a 48% NaOH aqueous solution was used as NaOH.

• Other components:

Ethylene glycol monobutyl ether (EGBE) was used as an organic solvent. At the time of preparation of the surface treatment liquid, 98% ethylene glycol monobutyl ether was used as ethylene glycol monobutyl ether.
Copper sulfate was used as a copper-based compound. At the time of preparation of the surface treatment liquid, copper sulfate pentahydrate was used as copper sulfate.
Silica ($SiO_2$) particles (model number MFIL-P(S), average particle size 12 μm) manufactured by MADHU SILICA were used as filler particles.

[Examples 1 to 32 and Comparative Examples 1 to 5]

(Method for Preparing Surface Treatment Liquid)

A beaker containing ion-exchanged water was charged with a silane coupling agent, an acid, and the other components in predetermined amounts so that the concentration of each component in the surface treatment liquid was the concentration shown in Table 1A or 1B, and the mixture was stirred until it became uniform. In Examples 5, 8, and 9 and Comparative Examples 1 and 2, the base was then added and stirred until it became uniform to adjust the pH to a predetermined pH, whereby a surface treatment liquid was obtained.
The pH of the surface treatment liquid was as described in Table 1A or Table 1B.

(Surface Treatment Method)

As a copper sample, an electrolytic copper foil (copper thickness: 35 μm) was used for measurement of peel strength, and a copper-clad laminate (copper thickness: 35 μm) subjected to electrolytic copper plating was used for SEM observation. The surface of each copper sample was cleaned using a potassium persulfate-based soft etchant (GB-200: manufactured by Shikoku Chemicals Corporation) as a pretreatment liquid.
The surface of each copper sample was washed with water, and the pretreatment liquid was sufficiently washed away.
Moisture on the surface of each copper sample was removed with an air knife. The surface roughness (Ra and Rz) of the copper surface of each copper sample after the pretreatment was measured using a laser microscope VK-8710 (manufactured by KEYENCE CORPORATION). In the electrolytic copper foil, Ra was 0.15 μm, and Rz was 0.80 μm. In the copper-clad laminate, Ra was 0.05 μm, and Rz was 0.25 μm.
For the measurement of the surface roughness (plane roughness) of the metal and organic film, a copper-clad laminate (copper thickness: 35 μm) subjected to electrolytic copper plating was used, and the surface roughness (surface roughness) of the copper surface was measured using a laser microscope VK-X3000 (manufactured by KEYENCE CORPORATION).
Each copper sample was immersed in a surface treatment liquid (30°C) in a constant temperature state (surface treatment). The treatment time (that is, immersion time) was as described in Table 1A or Table 1B.
Next, each copper sample was washed with water, the surface treatment liquid attached to the surface of each copper sample was washed away, and then dried at 100°C for 1 minute. Each copper sample obtained was subjected to evaluation. The surface roughness (Ra and Rz) of the organic film of the copper sample (copper-clad laminate) after the surface treatment was measured using a laser microscope VK-8710 (manufactured by KEYENCE CORPORATION). The surface roughness (plane roughness) of the organic film of the copper sample (copper-clad laminate) after the surface treatment in Example 11 was measured using a laser microscope VK-X3000 (manufactured by Keyence Corporation).

[Evaluation]

<Measurement of Peel Strength>

(Bonding between Copper Sample and Resin)

A resin for a build-up wiring board (manufactured by Ajinomoto Fine-Techno Co., Inc, product name "GX-T31",

epoxy-based resin, sheet shape) and an FR-4 substrate (thickness: 1 mm) were stacked in this order on the surface-treated surface of the treated copper sample (copper foil). Thereafter, the resin was semi-cured by performing the following pre-curing treatment to bond the copper foil, the resin, and the substrate together, whereby a test substrate was prepared.

• Pre-cure treatment

The following heat treatment (H1) and (H2) were sequentially performed on the test substrate in which the copper foil, the resin, and the substrate were stacked.

(H1) Heating at 100°C for 30 minutes;
(H2) Heating at 180°C for 30 minutes.

(Evaluation of Heat-Resistant Adhesive Properties)

The test substrate after the pre-cure treatment was subjected to the following treatment (full cure treatment or HAST treatment) in accordance with "JIS C6481 (1996)", and then cut into a width of 10 mm to prepare a test piece for measuring the peel strength, and the peel strength (peel strength) (kN/m) of the copper foil was measured. The adhesive properties were evaluated based on the average value of the measured values of the three test pieces according to the following criteria.

• Full cure treatment:

The test substrate after the pre-cure treatment was subjected to the following heat treatment (H3).

(H3) Heating at 200°C for 60 minutes.
⊙: 0.62 ≤ Peel strength (best);
○: 0.55 ≤ Peel strength < 0.62 (excellent);
×: Peel strength < 0.55 (not acceptable);
× ×: Since a surface treatment liquid could not be prepared due to generation of precipitates, evaluation could not be performed (not acceptable).

• HAST treatment (high temperature and high humidity treatment):

The test substrate after the full cure treatment was subjected to a HAST treatment (high temperature and high humidity treatment). The HAST treatment is an accelerated test in a high temperature and high humidity environment, and was performed by holding the test substrate after the full cure treatment at a humidity of 85% and a temperature of 130°C for 50 hours.

⊙: 0.54 ≤ Peel strength (best);
○: 0.45 ≤ Peel strength < 0.54 (excellent);
×: Peel strength < 0.45 (not acceptable);
× ×: Since a surface treatment liquid could not be prepared due to generation of precipitates, evaluation could not be performed (not acceptable).

(Evaluation of Chemical Resistance Properties)

A build-up resin (manufactured by Ajinomoto Fine-Techno Co., Inc., product name "GX-T31", epoxy-based resin, sheet shape) was stacked on the surface-treated surface of the treated copper sample (copper-clad laminate), and the resin was semi-cured by performing a pre-cure treatment to prepare a test piece for a chemical resistance properties test. A via having a diameter of 50 μm was formed using $CO_2$ laser, and then the test piece was subjected to a degreasing treatment, a desmear treatment, a neutralization treatment, and a drying treatment under the following conditions.

(Degreasing Treatment) The test piece after via formation was immersed in a degreasing liquid (manufactured by Okuno Chemical Industries Co., Ltd.) at 60°C for 5 minutes, and then subjected to a water washing treatment.

(Desmear Treatment) The degreased test piece was immersed in a desmear solution (strong basic solution manufactured by Okuno Pharmaceutical Co., Ltd.) at 80°C for 20 minutes, and then subjected to a water washing treatment.

(Neutralization Treatment) The test piece after the desmear treatment was immersed in a neutralizing solution (manufactured by Okuno Chemical Industry Co., Ltd.) at 40°C for 5 minutes, and then subjected to a water washing treatment.

(Drying Treatment) The test piece after the neutralization treatment was dried at 80°C for 5 minutes.

With respect to the test piece after the drying treatment, a haloing width was measured at an observation magnification of 400 times using a laser microscope VK-8710 (manufactured by KEYENCE CORPORATION). When the periphery of the via of the test piece was viewed in a plan view with the laser microscope, the distance from the via end portion to the portion where the desmear liquid permeated was measured as the haloing width.

⊙: Haloing width ≤ 6 μm (best);
○: 6 μm < Haloing width ≤ 10 μm (excellent);
▲: 10 μm < Haloing width ≤ 14 μm (good);
△: 14 μm < Haloing width ≤ 18 μm (acceptable);
×: 18 μm < Haloing width (not acceptable);
× ×: Since a surface treatment liquid could not be prepared due to generation of precipitates, evaluation could not be performed (not acceptable).

(Evaluation of Storage Stability of Surface Treatment Liquid)

During and after the preparation of the surface treatment liquid, the liquid state was visually checked after being left at room temperature (20 to 30°C) for 6 hours, 1 day, and 1 week. When the storage stability of the surface treatment liquid is low, a precipitate due to the silane coupling agent is generated in the surface treatment liquid, and an organic film having a sufficient film thickness cannot be obtained.

⊙: No precipitate was observed after standing for 1 week after preparation of the surface treatment liquid (best);
O: No precipitate was observed after standing for 1 day after preparation of the surface treatment liquid, but precipitates were observed after standing for 1 week (excellent);
▲: No precipitate was observed after standing for 6 hours after the preparation of the surface treatment liquid, but precipitates were observed after standing for 1 day (good);
△: Slight precipitates were observed during the preparation of the surface treatment liquid (acceptable);
×: Almost all the silane coupling agent was precipitated during the preparation of the surface treatment liquid, and the surface treatment liquid could not be adjusted (not acceptable).

(Overall Evaluation)

Adhesive properties, chemical resistance properties, and storage stability were comprehensively evaluated. Specifically, the lowest evaluation result among the evaluation results of the adhesive properties, the evaluation results of the chemical resistance properties, and the evaluation result of the storage stability after the full cure treatment and the HAST treatment was used as the comprehensive evaluation result. The order of the evaluation results decreases in the following order: ⊙, ○, ▲, △, ×, × ×.

<SEM Observation of Cross-sectional Shape and Surface Shape>

Figs. 3A and 4A show examples of secondary electron images (30,000 times) in SEM observation based on a cross-sectional view of the test piece (copper-clad laminate) in Examples 1 and 2, respectively. The secondary electron images based on these cross-sectional views are secondary electron images based on a cross-sectional view of a test piece in which a platinum vapor deposition film and a carbon deposition film are further formed for the purpose of suppressing damage to the organic film at the time of cross-sectional processing with respect to the organic film 2. The platinum vapor deposition film was a platinum vapor deposition film, and was formed using an auto fine coater JEC-3000 FC (manufactured by JEOL Ltd.). The carbon deposition film was a carbon film, and was formed with a focused ion beam machining observation apparatus JIB-4000 (manufactured by JEOL Ltd.).

Figs. 3B, 4B, and 4C show examples of secondary electron images (30,000 times or 50,000 times) in SEM observation based on a plan view of the test pieces in Examples 1 and 2. Figs. 3C and 4D show examples of secondary electron images (5,000 times) in SEM observation based on a plan view of test pieces in Examples 1 and 2, respectively. Figs. 3D and 4E show examples of reflected electron images (5,000 times) in SEM observation based on a plan view of the test pieces in Examples 1 and 2, respectively.

From Figs. 3A to 3D (Example 1), the plurality of protrusions 20 in the organic film 2 had a width-direction cut shape (base portion) and an umbrella open shape (upper portion) in a cross-sectional view. The plurality of protrusions

20 in the organic film 2 were formed by necking (bonding) amorphous particles (primary particles) of about 100 nm in plan view to form aggregates (secondary particles), and the aggregates (secondary particles) were connected to each other at upper portions, and had a network shape or a porous shape including pores as a whole.

From Figs. 4A to 4E (Example 2), the plurality of protrusions 20 in the organic film 2 had a widthwise cut shape (base portion) and a tuft shape (upper portion) in a cross-sectional view. The plurality of protrusions 20 in the organic film 2 were formed by necking (bonding) amorphous particles (primary particles) of about 100 nm in plan view to form aggregates (secondary particles), and the aggregates (secondary particles) were connected to each other at upper portions, and had a network shape or a porous shape including pores as a whole.

<Measurement of Average Height of Protrusion and Recess>

First, an SEM image based on a cross-sectional view was obtained, and then various dimensions were measured from the obtained image. Specifically, the surface-treated test piece was sequentially subjected to the following treatments S1 to S5, and then various dimensions were measured:

(S1) Platinum deposition treatment: Platinum was vapor-deposited on the surface-treated test piece (copper-clad laminate) using an auto fine coater JEC-3000 FC (manufactured by JEOL Ltd.).
(S2) Carbon deposition treatment: A carbon film was formed on the test piece with a focused ion beam machining observation apparatus JIB-4000 (manufactured by JEOL Ltd.).
(S3) Cross-sectional processing: A cross-section parallel to the thickness direction of the test piece was processed with an ion milling apparatus (IM4000 PLUS: manufactured by Hitachi High-Technologies Corporation). The cross-sectional working conditions were 6 kV and 30 minutes.
(S4) SEM observation: The obtained cross-section was observed with an SEM apparatus (S-4800: manufactured by Hitachi High-Technologies Corporation), and an image (secondary electron image) was photographed at an acceleration voltage of 3 kV and the number of pixels of 640 $\times$ 448. The photographing magnification was 30,000 times (for the protrusion) and 100,000 times (for the recess (flat portion)). For each test piece, images of any three fields different for each magnification were taken.
(S5) Measurement: The heights of the protrusion (aggregate) and the recess (flat portion) were measured by the following method using the software attached to an SEM apparatus (S-4800).

• Method for measuring average height of recess (flat portion)

The cross-sectional view image photographed at a magnification of 100,000 was divided into four regions uniform in the width direction, and the height (length (distance) h2 from the copper-foil-side surface 21 of the organic film 2 to any one point on the organic film surface 22 of the recess 25 (see Fig. 2)) of the recess at any one point in each region was measured. Such measurement was performed on images of three fields of view, and the average height of the protrusion (flat portion) was obtained by obtaining the average of 12 points in total.

• Method for measuring average height of protrusions (aggregates)

The cross-sectional view image photographed at a magnification of 30,000 was divided into four regions uniform in the width direction, and the maximum height (length (distance) h1 from the copper-foil-side surface 21 of the organic film 2 to the organic film surface 22 at highest part of the protrusion 20 (see Fig. 2)) of the protrusion in each region was measured. Such measurement was performed for each of the images of three fields of view, and the average height of the protrusion was obtained by obtaining the average of h1 in the measurement region where the protrusion 20 was confirmed among the total of 12 measurement regions. The protrusion having a protrusion length (h1 - average height of recesses) of 20 nm or more was counted as the protrusion 20, and h1 was measured. Specifically, a protrusion having a protrusion length (h1 - average height of recesses) of less than 20 nm was not counted as the protrusion 20.

<Presence or Absence of Protrusion>

When one or more protrusions having a protrusion length (h1 - average height of recesses) of 20 nm or more were confirmed in each of two or more measurement regions among 12 measurement regions in the "method for measuring average height of protrusions (aggregates)" described above, it was evaluated as "protrusion was present". On the other hand, when there was only one or less measurement regions in which one or more protrusions having a protrusion length (h1 - average height of recesses) of 20 nm or more were confirmed, it was evaluated as "protrusion was absent".

In each of the cross-sectional images (30,000 times) taken in Examples 1 to 32, one or more protrusions having

a protrusion length (h1 - average height of recesses) of 20 nm or more were confirmed in each of the 12 measurement regions. At this time, all the protrusions had a porous shape including pores while having a tuft shape in which a plurality of particles were connected.

In particular, in Example 32, it is considered that protrusions were formed from the aggregate containing the silane coupling agent (AS-1) and the silica particles during formation of the organic film.

<Calculation of Protrusion Length and Protrusion Ratio of Protrusion>

Using the average heights of the protrusion and the recess, the protrusion length and the protrusion ratio of the protrusion were obtained based on the following formula.

[Mathematical Formula 1]

$$\text{Protrusion Length of Protrusion (nm)} = \text{Average Height of Protrusion} - \text{Average Height of Recess}$$

$$\text{Protrusion Ratio of Protrusion (\%)} = \{(\text{Average Height of Protrusion} - \text{Average Height of Recess})/\text{Average Height of Recess}\} \times 100$$

<Measurement of Occupancy Ratio of Protrusion>

First, an SEM image based on a plan view was obtained, and then the obtained image was binarized. Specifically, the surface-treated test piece was sequentially subjected to the following treatments T1 to T3, and then various dimensions were measured:

(T1) Photographing: The surface-treated test piece was cut into a size (10 mm × 10 mm) to be put in an SEM apparatus, and a planar view image of the test piece was photographed with the SEM apparatus (JSM-7610F: manufactured by JEOL Ltd.) at an acceleration voltage of 5 kV, a photographing magnification of 5,000 times, and a number of pixels of 1280 × 960 (reflected electron image). Any five fields of view were photographed for one test piece.
(T2) Binarization processing: The image was binarized using image analysis software ImageJ. Specifically, the photographed image was binarized based on a threshold determined by the method of Yen, and an image in which the protrusion (aggregate portion) was black and the recess (flat portion) was white was obtained. When the black and white of the protrusion and the black and white of the recess were opposite to each other after the binarization processing, the image before binarization was inverted, and then binarization was performed.
(T3) Measurement: The number of pixels of the protrusion (aggregate portion or black portion) was calculated by image analysis (Analyze > Measure), and the ratio of the number of pixels of the protrusion (aggregate portion or black portion) to the number of pixels of the entire image (1280 × 960 pixels) was calculated based on the calculated value to obtain the occupancy ratio of the protrusion. Such measurement of the occupancy ratio of the protrusion was performed on images of five fields of view captured in each of the examples and the comparative examples, and an average value of the occupancy ratios of the convex portions in each field of view was used as the occupancy ratio of the protrusion.

<Elemental Analysis of Protrusion and Recess>

Elemental analysis was performed by energy dispersive X-ray spectroscopy (SEM-EDX) using a part of each of the protrusion and the recess in the cross-section of the test piece in Example 1 as a measurement region. The analysis conditions are as follows. In addition, simple quantitative analysis using C, N, O, Si, and Cu as target elements was performed by the ZAF method.

- Analysis of protrusion

    Number of pixels: 512 × 384
    Acceleration voltage: 5.00 kV
    Measurement magnification: × 50,000

Dwell time: 0.10 msec.
Number of sweeps: 10
Irradiation current: 7.47500 nA
Counting rate: 14205 cps
Energy range: 0 to 20 keV

- Analysis of recess

Number of pixels: 512 × 384
Acceleration voltage: 5.00 kV
Measurement magnification: × 50,000
Dwell time: 0.10 msec.
Number of sweeps: 10
Irradiation current: 7.47500 nA
Counting rate: 14205 cps
Energy range: 0 to 20 keV

<Elemental Analysis of Organic Film>

Elemental analysis was performed by energy dispersive X-ray spectroscopy (SEM-EDX) using a surface (that is, the surface of the organic film including the protrusion and the recess) of the test piece in Examples 1 to 11 in plan view as a measurement region. The analysis conditions are as follows. In addition, simple quantitative analysis using C, N, O, Si, and Cu as target elements was performed by the ZAF method.

Number of pixels: 512 × 384
Acceleration voltage: 15.00 kV
Measurement magnification: × 500
Irradiation current: 7.47500 nA
Energy range: 0 to 20 keV

[Table 1A]

| Examples/ Comparative Examples | Composition | | | | | | | | | | | | | | Treatment time (sec) | Adhesive Properties (2) | | Chemical resistance properties (3) | Storage stability (4) | Overall evaluation | Presence or absence of protrusion |
|---|---|---|---|---|---|---|---|---|---|---|---|---|---|---|---|---|---|---|---|---|---|
| | Silane coupling agent | | | Acid | | | | Base | | | Other components | | | pH | | | | | | | |
| | Type | wt% | mol/L | Type | Constant (1) (pKa) | wt% | mol/L | Type | wt% | mol/L | Type | wt% | mol/L | | | After full cure treatment | After HAST treatment | | | | |
| Comparative Example 1 | AS-1 | 0.7 | 0.024 | Tosylic acid | -2.8 | 9.1 | 0.53 | NaOH | 2.1 | 0.53 | None | - | - | 2.00 | 60 | 0.46× | 0.41× | 8○ | ⊙ | × | None |
| Comparative Example 2 | AS-1 | 0.7 | 0.024 | Sulfuric acid | -3 | 10 | 1.02 | NaOH | 7.2 | 1.80 | None | - | - | 2.10 | 60 | ×× | ×× | ×× | × | ×× | None |
| Comparative Example 3 | AS-1 | 0.7 | 0.024 | Tosylic acid | -2.8 | 0.09 | 0.005 | None | - | - | None | - | - | 2.40 | 60 | 0.40× | 0.36× | 20× | △ | × | None |
| Comparative Example 4 | AS-1 | 0.7 | 0.024 | Sulfuric acid | -3 | 0.05 | 0.005 | None | - | - | None | - | - | 2.20 | 60 | 0.43× | 0.38× | 5⊙ | △ | × | None |
| Comparative Example 5 | AS-2 | 0.7 | 0.025 | None | - | - | - | None | - | - | EGBE | 20 | 0.67 | 4.10 | 60 | 0.35× | 0.19× | * | ⊙ | * | None |
| Example 1 | AS-1 | 0.7 | 0.024 | Tosylic acid | -2.8 | 9.1 | 0.53 | None | - | - | None | - | - | 0.40 | 30 | 0.73⊙ | 0.56⊙ | 5⊙ | ⊙ | ⊙ | Present |
| Example 2 | AS-1 | 0.7 | 0.024 | Sulfuric acid | -3 | 10 | 1.02 | None | - | - | None | - | - | 0.00 | 25 | 0.62⊙ | 0.51○ | 7○ | ○ | ○ | Present |
| Example 3 | AS-1 | 0.7 | 0.024 | Methanesulfonic acid | -1.9 | 10 | 1.04 | None | - | - | None | - | - | 0.20 | 10 | 0.69⊙ | 0.53○ | 10○ | ⊙ | ○ | Present |
| Example 4 | AS-1 | 0.7 | 0.024 | Camphorsulfonic acid | 1.2 | 10 | 0.43 | None | - | - | None | - | - | 0.60 | 10 | 0.67⊙ | 0.59⊙ | 12▲ | ▲ | ▲ | Present |
| Example 5 | AS-1 | 0.7 | 0.024 | Acetic acid<br>Nitric acid | 4.7<br>-1.8 | 10<br>1 | 1.66<br>0.16 | NaOH | 0.34 | 0.085 | None | - | - | 0.98 | 60 | 0.56○ | 0.50○ | 11▲ | ▲ | ▲ | Present |
| Example 6 | AS-1 | 0.7 | 0.024 | Tosylic acid | -2.8 | 9.1 | 0.53 | None | - | - | None | - | - | 0.40 | 10 | 0.72⊙ | 0.55⊙ | 7○ | ⊙ | ○ | Present |
| Example 7 | AS-1 | 0.7 | 0.024 | Tosylic acid | -2.8 | 9.1 | 0.53 | None | - | - | None | - | - | 0.40 | 60 | 0.74⊙ | 0.55⊙ | 7○ | ⊙ | ○ | Present |
| Example 8 | AS-1 | 0.7 | 0.024 | Tosylic acid | -2.8 | 9.1 | 0.53 | NaOH | 1.7 | 0.43 | None | - | - | 0.99 | 60 | 0.69⊙ | 0.58⊙ | * | ⊙ | * | Present |
| Example 9 | AS-1 | 0.7 | 0.024 | Tosylic acid | -2.8 | 9.1 | 0.53 | NaOH | 1.9 | 0.48 | None | - | - | 1.50 | 60 | 0.61○ | 0.53○ | 15△ | ⊙ | △ | Present |
| Example 10 | AS-1 | 0.7 | 0.024 | Tosylic acid | -2.8 | 18.1 | 1.05 | None | - | - | None | - | - | -0.20 | 30 | 0.66⊙ | 0.55⊙ | 6⊙ | ⊙ | ⊙ | Present |
| Example 11 | AS-1 | 0.7 | 0.024 | Sulfuric acid | -3 | 20 | 2.04 | None | - | - | None | - | - | -0.30 | 30 | 0.63⊙ | 0.54⊙ | 6⊙ | ⊙ | ⊙ | Present |

(1) Acid dissociation constant, (2) Peel strength (kN/m), (3) Haloing width (μm), (4) Surface treatment liquid, -: Not blended. *: Not evaluated.

[Table 1B]

| Examples/ Comparative Examples | Composition | | | | | | | | | | | | | | Treatment time (sec) | Adhesive Properties (2) | | Chemical resistance properties (3) | Storage stability (4) | Overall evaluation | Presence or absence of protrusion |
|---|---|---|---|---|---|---|---|---|---|---|---|---|---|---|---|---|---|---|---|---|---|
| | Silane coupling agent | | | Acid | | | | Base | | | Other components | | | pH | | | | | | | |
| | Type | wt% | mol/L | Type | Constant (1) (pKa) | wt% | mol/L | Type | wt% | mol/L | Type | wt% | mol/L | | | After full cure treatment | After HAST treatment | | | | |
| Example 12 | AS-2 | 0.7 | 0.025 | Sulfuric acid | -3 | 20 | 2.04 | None | - | - | EGBE | 20 | 0.67 | 0.40 | 60 | 0.76⊙ | 0.46○ | * | ▲ | * | Present |
| Example 13 | AS-1 | 0.35 | 0.012 | Tosylic acid | -2.8 | 4.5 | 0.26 | None | - | - | None | - | - | 0.50 | 30 | * | 0.55⊙ | 5⊙ | ⊙ | * | Present |
| Example 14 | AS-1 | 0.3 | 0.010 | Sulfuric acid | -3 | 10 | 1.02 | None | - | - | None | - | - | 0.07 | 30 | 0.59○ | 0.50○ | 5⊙ | ⊙ | ○ | Present |
| Example 15 | AS-1 | 0.9 | 0.031 | Tosylic acid | -2.8 | 9.1 | 0.53 | None | - | - | None | - | - | 0.40 | 30 | 0.60○ | 0.54⊙ | 16△ | ○ | △ | Present |
| Example 16 | AS-1 | 0.7 | 0.024 | Tosylic acid | -2.8 | 22.8 | 1.32 | None | - | - | None | - | - | 0.08 | 30 | 0.58○ | 0.52○ | 7○ | ⊙ | ○ | Present |
| Example 17 | AS-1 | 0.5 | 0.017 | Tosylic acid | -2.8 | 27.3 | 1.59 | None | - | - | None | - | - | -0.01 | 30 | 0.63⊙ | 0.56⊙ | 7○ | ⊙ | ○ | Present |
| Example 18 | AS-1 | 0.7 | 0.024 | Tosylic acid | -2.8 | 27.3 | 1.59 | None | - | - | None | - | - | -0.01 | 30 | 0.64⊙ | 0.59⊙ | 7○ | ⊙ | ○ | Present |
| Example 19 | AS-1 | 0.9 | 0.031 | Tosylic acid | -2.8 | 27.3 | 1.59 | None | - | - | None | - | - | -0.01 | 30 | 0.59○ | 0.54⊙ | 7○ | ⊙ | ○ | Present |
| Example 20 | AS-1 | 0.35 | 0.012 | Sulfuric acid | -3 | 5 | 0.51 | None | - | - | None | - | - | 0.40 | 30 | * | 0.46○ | 4⊙ | ○ | * | Present |
| Example 21 | AS-1 | 0.18 | 0.006 | Sulfuric acid | -3 | 2.5 | 0.25 | None | - | - | None | - | - | 0.80 | 30 | * | 0.47○ | 5⊙ | ○ | * | Present |
| Example 22 | AS-1 | 0.7 | 0.024 | Sulfuric acid | -3 | 25 | 2.55 | None | - | - | None | - | - | -0.50 | 30 | 0.63⊙ | 0.56⊙ | 7○ | ⊙ | ○ | Present |
| Example 23 | AS-1 | 0.5 | 0.017 | Sulfuric acid | -3 | 30 | 3.06 | None | - | - | None | - | - | -0.70 | 30 | 0.61○ | 0.48○ | 7○ | ⊙ | ○ | Present |
| Example 24 | AS-1 | 0.7 | 0.024 | Sulfuric acid | -3 | 30 | 3.06 | None | - | - | None | - | - | -0.70 | 30 | 0.65⊙ | 0.52○ | 6⊙ | ⊙ | ○ | Present |
| Example 25 | AS-1 | 0.9 | 0.031 | Sulfuric acid | -3 | 30 | 3.06 | None | - | - | None | - | - | -0.70 | 30 | 0.60○ | 0.52○ | 6⊙ | ⊙ | ○ | Present |
| Example 26 | AS-1 | 0.7 | 0.024 | Tosylic acid | -2.8 | 9.1 | 0.53 | None | - | - | Copper sulfate | 0.075 | 0.005 | 0.40 | 30 | 0.64⊙ | 0.58⊙ | 4⊙ | ⊙ | ⊙ | Present |
| Example 27 | AS-1 | 0.7 | 0.024 | Sulfuric acid | -3 | 20 | 2.04 | None | - | - | Copper sulfate | 0.013 | 0.0008 | -0.30 | 30 | 0.63⊙ | 0.55⊙ | 5⊙ | ⊙ | ⊙ | Present |
| Example 28 | AS-1 | 0.7 | 0.024 | Sulfuric acid | -3 | 10 | 1.02 | None | - | - | Copper sulfate | 0.075 | 0.005 | 0.00 | 30 | 0.64⊙ | 0.53○ | 5⊙ | ⊙ | ○ | Present |
| Example 29 | AS-1 | 0.7 | 0.024 | Sulfuric acid | -3 | 20 | 2.04 | None | - | - | Copper sulfate | 0.25 | 0.016 | -0.30 | 30 | 0.58○ | 0.52○ | 5⊙ | ⊙ | ○ | Present |
| Example 30 | AS-1 | 0.7 | 0.024 | Sulfuric acid | -3 | 20 | 2.04 | None | - | - | Copper sulfate | 1.3 | 0.079 | -0.30 | 30 | 0.60○ | 0.53○ | 5⊙ | ⊙ | ○ | Present |
| Example 31 | AS-1 | 0.7 | 0.024 | Sulfuric acid | -3 | 20 | 2.04 | None | - | - | Copper sulfate | 2.5 | 0.16 | -0.30 | 30 | 0.57○ | 0.52○ | 5⊙ | ⊙ | ○ | Present |
| Example 32 | AS-1 | 0.7 | 0.024 | Tosylic acid | -2.8 | 9.1 | 0.53 | None | - | - | Silica particles | 4.8 | ** | 0.40 | 30 | 0.63⊙ | 0.55⊙ | 3⊙ | ○ | ○ | Present |

(1) Acid dissociation constant, (2) Peel strength (kN/m), (3) Haloing width (μm), (4) Surface treatment liquid, -: Not blended. *: Not evaluated. **: Not calculated.

[Table 2]

| | Presence orabsence of protrusion | Average height of protrusion | Average height of recess | Protrusion length of protrusion | Protrusion ratio of protrusion | Occupancy ratio of protrusion | Surface roughness Ra | Surface roughness Rz |
|---|---|---|---|---|---|---|---|---|
| Comparative Example 1 | None | - | 98 nm | - | - | 0% | 0.08 μm | 0.58 μm |
| Comparative Example 2 | None | - | * | - | - | * | * | * |
| Comparative Example 3 | None | - | * | - | - | * | 0.06 μm | 0.24 μm |
| Comparative Example 4 | None | - | * | - | - | * | 0.06 μm | 0.28 μm |
| Comparative Example 5 | None | - | * | - | - | * | 0.07 μm | 0.28 μm |
| Example 1 | Present | 425 nm | 42 nm | 383 nm | 912% | 75% | 0.20 μm | 1.49 μm |
| Example 2 | Present | 524 nm | 45 nm | 479 nm | 1064% | 84% | 0.21 μm | 1.89 μm |
| Example 3 | Present | * | * | * | * | * | 0.21 μm | 7.02 μm |
| Example 4 | Present | * | * | * | * | * | 0.24 μm | 11.12 μm |
| Example 5 | Present | * | * | * | * | * | * | * |
| Example 6 | Present | 417 nm | 33 nm | 384 nm | 1164% | * | 0.21 μm | 1.45 μm |
| Example 7 | Present | 560 nm | 57 nm | 503 nm | 882% | * | 0.20 μm | 1.83 μm |
| Example 8 | Present | * | * | * | * | 83% | 0.25 μm | 2.16 μm |
| Example 9 | Present | * | * | * | * | 87% | 0.21 μm | 1.90 μm |

(continued)

| | Presence orabsence of protrusion | Average height of protrusion | Average height of recess | Protrusion length of protrusion | Protrusion ratio of protrusion | Occupancy ratio of protrusion | Surface roughness Ra | Surface roughness Rz |
|---|---|---|---|---|---|---|---|---|
| Example 10 | Present | 420 nm | 32 nm | 388 nm | 1213% | 76% | 0.18 μm | 1.04 μm |
| Example 11 | Present | 467 nm | 32 nm | 435 nm | 1359% | 66% | 0.19 μm | 1.63 μm |
| Example 12 | Present | * | * | * | * | * | 0.26 μm | 1.56 μm |
| Example 13 | Present | * | * | * | * | * | 0.13 μm | 1.07 μm |
| Example 14 | Present | * | * | * | * | 23% | 0.12 μm | 0.85 μm |
| Example 15 | Present | 1210 nm | 40 nm | 1170 nm | 2925% | * | 0.26 μm | 2.57 μm |
| Example 16 | Present | 425 nm | 30 nm | 395 nm | 1317% | * | 0.16 μm | 0.88 μm |
| Example 17 | Present | 335 nm | 10 nm | 325 nm | 3250% | * | 0.15 μm | 0.91 μm |
| Example 18 | Present | 341 nm | 10 nm | 331 nm | 3310% | * | 0.15 μm | 0.99 μm |
| Example 19 | Present | 423 nm | 10 nm | 413 nm | 4130% | * | 0.19 μm | 1.45 μm |
| Example 20 | Present | * | * | * | * | * | 0.10 μm | 0.79 μm |
| Example 21 | Present | * | * | * | * | * | 0.12 μm | 0.76 μm |
| Example 22 | Present | 468 nm | 32 nm | 436 nm | 1363% | * | 0.16 μm | 1.23 μm |
| Example 23 | Present | 254 nm | 18 nm | 236 nm | 1311% | * | 0.15 μm | 0.88 μm |
| Example 24 | Present | 329 nm | 24 nm | 305 nm | 1271% | * | 0.16 μm | 1.04 μm |
| Example 25 | Present | 337 nm | 39 nm | 298 nm | 764% | * | 0.17 μm | 1.26 μm |
| Example 26 | Present | * | * | * | * | * | 0.22 μm | 1.75 μm |
| Example 27 | Present | 423 nm | 33 nm | 390 nm | 1182% | 69% | 0.18 μm | 1.58 μm |
| Example 28 | Present | * | * | * | * | * | 0.19 μm | 1.24 μm |
| Example 29 | Present | 592 nm | 25 nm | 567 nm | 2268% | * | 0.19 μm | 1.62 μm |
| Example 30 | Present | * | * | * | * | * | 0.23 μm | 1.95 μm |
| Example 31 | Present | * | * | * | * | * | 0.24 μm | 2.01 μm |
| Example 32 | Present | * | * | * | * | * | 0.20 μm | 1.87 μm |
| *: Not evaluated. -: Not able to be measured because of absence of protrusion. | | | | | | | | |

In Comparative Examples 1 to 5 in Table 2, the protrusion defined in the present invention was not formed in the SEM image based on the cross-sectional view, and the occupancy ratio of the protrusion was 0% in the SEM image based on the plan view.

[Table 3]

| Example 1 | | |
|---|---|---|
| Element | Protrusion atom% | Recess atom% |
| C | 45.1 | 51.2 |
| N | 18.6 | 16.2 |
| O | 26.4 | 18.2 |
| Si | 7.5 | 4.1 |
| Cu | 2.3 | 10.3 |

From the comparison between Examples 1 to 32 and Comparative Examples 1 to 5, it is apparent that the surface treatment liquid of Examples 1 to 32 forming an organic film having uneven shape (in particular, protrusion) on the resin side significantly increases the peel strength after the full cure treatment and after the HAST treatment and improves the adhesive force between the metal and the resin as compared with the surface treatment liquid of Comparative Examples 1 to 5 forming an organic having no uneven shape (in particular, protrusion).

From the analysis results of the simple quantitative analysis in Table 3, the components (C, N, Si, O) of the silane coupling agent (AS-1) and the copper ion (Cu) were confirmed in both the protrusion and the recess. From this result, it is clear that the organic film (in particular, the protrusion and the recess) is substantially formed mainly of the silane coupling agent, and it is presumed that the silane coupling agent and the copper ion form a complex to constitute the organic film (in particular, the protrusion and the recess).

[Table 4]

| Element | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|
| | Atom% | Atom% | Atom% | Atom% | Atom% | Atom% | Atom% | Atom% | Atom% | Atom% | Atom% |
| C | 27.6 | 25.9 | 27.1 | 28.4 | 23.8 | 24.2 | 25.4 | 24.7 | 26.8 | 23.2 | 22.2 |
| N | 21.1 | 21.5 | 21.7 | 19.0 | 17.7 | 16.2 | 18.3 | 15.4 | 24.6 | 20.2 | 18.5 |
| O | 7.0 | 5.7 | 6.8 | 6.0 | 5.5 | 4.8 | 5.9 | 4.8 | 7.4 | 5.9 | 5.3 |
| Si | 2.1 | 1.7 | 1.7 | 1.5 | 1.6 | 1.3 | 1.5 | 1.3 | 2.1 | 1.8 | 1.5 |
| Cu | 42.2 | 45.2 | 42.7 | 45.1 | 51.4 | 53.6 | 49.0 | 53.9 | 39.1 | 49.1 | 52.3 |

In addition, from the analysis results of the simple quantitative analysis in Table 4, the components (C, N, Si, O) of the silane coupling agent (AS-1) were confirmed in the organic film of Examples 1 to 11. From this result, it is apparent that the organic film of Examples 1 to 11 is substantially formed of the silane coupling agent as a main component. Cu is detected at a relatively high concentration because metal copper of the copper-clad laminate on which the organic film is formed is detected.

[Table 5A]

| Copper surface (1) of copper-clad laminate | | |
|---|---|---|
| Parameter | Unit | Value |
| Sdr | - | 0.0004 |
| Sdq | - | 0.03 |
| Spd | $\times 10^6/mm^2$ | 3.2 |
| Spc | $\times 10^3/m$ | 0.4 |
| Sa | μm | 0.005 |
| Sq | μm | 0.006 |
| Sz | μm | 0.11 |
| Sp | μm | 0.07 |
| Sv | μm | 0.05 |
| Ssk | - | 0.171 |
| Sku | - | 6.4 |
| Sk | μm | 0.02 |

[Table 5B]

| Copper surface (2) of copper-clad laminate | | |
|---|---|---|
| Parameter | Unit | Value |
| Spk | μm | 0.006 |
| Svk | μm | 0.006 |
| Smr1 | % | 10.2 |
| Smr2 | % | 89 |
| Sxp | μm | 0.01 |
| Vvv | $\mu L/m^2$ | 0.7 |
| Vvc | $\mu L/m^2$ | 7 |
| Vmp | $\mu L/m^2$ | 0.3 |
| Vmc | $\mu L/m^2$ | 5 |
| Sal | μm | 0.78 |
| Str | - | 0.44 |
| Std | ° | 38 |

[Table 6A]

| Organic film (1) of Example 11 | | |
|---|---|---|
| Parameter | Unit | Value |
| Sdr | - | 0.16 |
| Sdq | - | 0.58 |
| Spd | $\times 10^6/mm^2$ | 4.3 |
| Spc | $\times 10^3/m$ | 9.4 |
| Sa | μm | 0.056 |
| Sq | μm | 0.072 |
| Sz | μm | 0.60 |
| Sp | μm | 0.30 |
| Sv | pm | 0.30 |
| Ssk | - | -0.072 |
| Sku | - | 2.7 |
| Sk | μm | 0.20 |

[Table 6B]

| Organic film (2) of Example 11 | | |
|---|---|---|
| Parameter | Unit | Value |
| Spk | μm | 0.056 |
| Svk | μm | 0.062 |
| Smr1 | % | 8.3 |
| Smr2 | % | 90 |
| Sxp | μm | 0.13 |
| Vvv | $\mu L/m^2$ | 7.9 |
| Vvc | $\mu L/m^2$ | 88 |
| Vmp | $\mu L/m^2$ | 2.9 |
| Vmc | $\mu L/m^2$ | 68 |
| Sal | μm | 0.37 |
| Str | - | 0.57 |
| Std | ° | 50 |

Tables 5A and 5B show measurement results of parameters of surface roughness (plane roughness) of the copper surface of the copper-clad laminate.

Table 6A and Table 6B are the measurement results of the parameter of the surface roughness (plane roughness) of the organic film of Example 11.

INDUSTRIAL APPLICABILITY

The surface treatment liquid of the present invention is useful as a surface treatment liquid for improving adhesive properties between a metal such as a metal circuit of a printed wiring board and a metal core material of an electric wire or a tire and a resin layer (for example, an insulating resin layer) formed on a surface of the metal.

## Claims

1. A metal surface treatment liquid for forming an organic film on a metal surface, wherein the metal surface treatment liquid contains a silane coupling agent and an acid and has a pH of 1.9 or less.

2. The metal surface treatment liquid according to claim 1, wherein the acid includes an acid having an acid dissociation constant of 4.8 or less.

3. The metal surface treatment liquid according to claim 2, wherein the surface treatment liquid contains 0.010 to 10.0 mol/L of an acid having the acid dissociation constant.

4. The metal surface treatment liquid according to claim 2 or 3, wherein the acid having the acid dissociation constant is selected from sulfonic acids and sulfuric acid.

5. The metal surface treatment liquid according to any one of claims 1 to 4, wherein the surface treatment liquid contains the silane coupling agent at 0.001 to 1.000 mol/L.

6. The metal surface treatment liquid according to any one of claims 1 to 5, wherein the organic film has a protrusion protruding to a side opposite to the metal.

7. The metal surface treatment liquid according to claim 6, wherein the protrusion has a porous shape while protruding to the side opposite to the metal.

8. The surface treatment liquid according to claim 6 or 7, wherein the protrusion has a protrusion length of 20 to 5000 nm.

9. The surface treatment liquid according to any one of claims 6 to 8, wherein the protrusion has a protrusion ratio of 10 to 5000%.

10. The surface treatment liquid according to any one of claims 6 to 9, wherein the organic film has the protrusion at an occupancy ratio of 10 to 95% on the side opposite to the metal.

11. The surface treatment liquid according to any one of claims 6 to 10, wherein

    the organic film includes a flat portion and the protrusion, and
    the flat portion and the protrusion contain a silane coupling agent, and the protrusion is formed of an aggregate containing the silane coupling agent.

12. The surface treatment liquid according to claim 11, wherein the flat portion of the organic film has a thickness of 10 to 300 nm.

13. The metal surface treatment liquid according any one of claims 1 to 12, wherein a surface of the organic film has a surface roughness of 0.08 μm or more in Ra (arithmetic average roughness).

14. The metal surface treatment liquid according to any one of claims 1 to 13, wherein a surface of the organic film has a surface roughness of 0.70 μm or more in Rz (maximum height roughness).

15. The surface treatment liquid according to any one of claims 1 to 14, wherein a resin is disposed on the side opposite to the metal in the organic film.

16. The surface treatment liquid according to any one of claims 1 to 15, wherein the metal is copper or a copper alloy.

17. The surface treatment liquid according to any one of claims 1 to 16, wherein the metal is a metal circuit of a printed wiring board.

[Fig. 1]

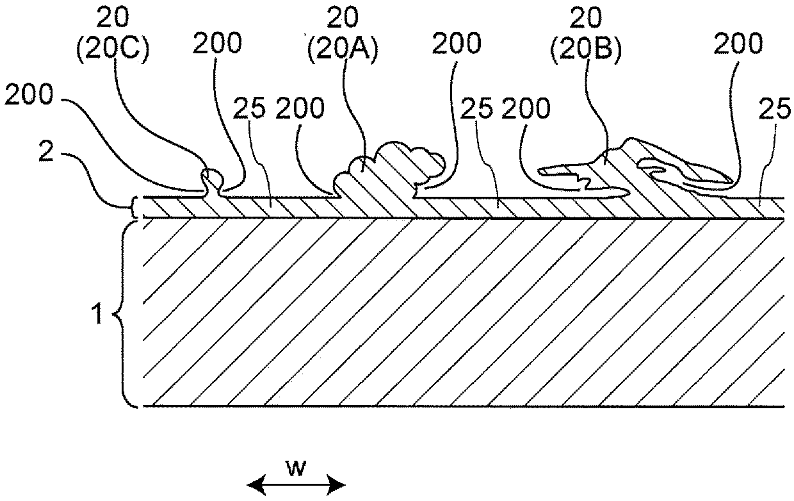
20
(20C)
200
20
(20A)
200
20
(20B)
200
200
25 200
25 200
25
2
1
w

[Fig. 2]

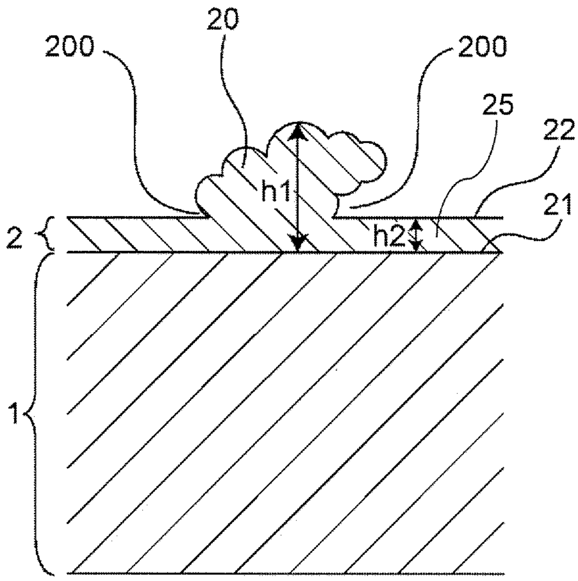
200
20
200
25
22
h1
h2
21
2
1

[Fig. 3A]

Example 1 (photograph of cross-section, secondary electron image)

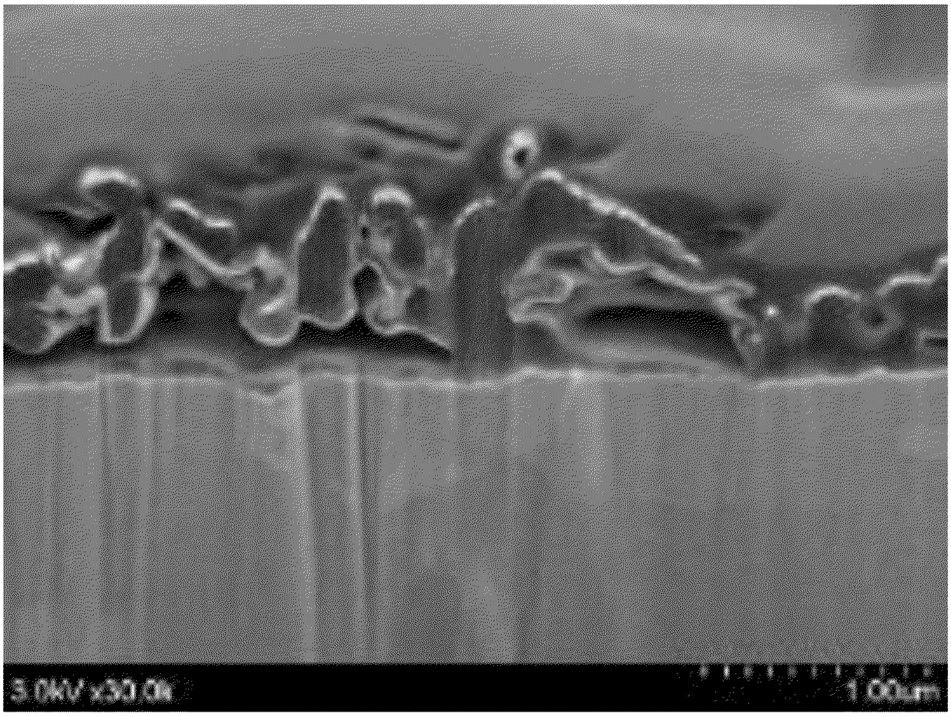


[Fig. 3B]

Example 1 (photograph of plane, secondary electron image) (30,000 times)

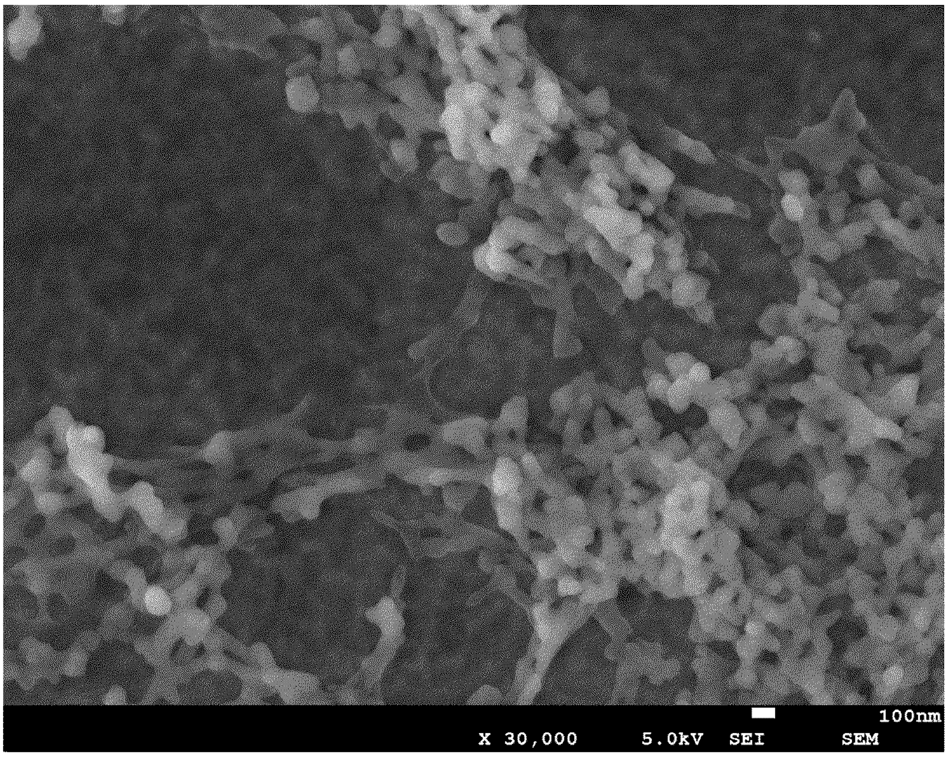

[Fig. 3C]

Example 1 (photograph of plane, secondary electron image) (5,000 times)

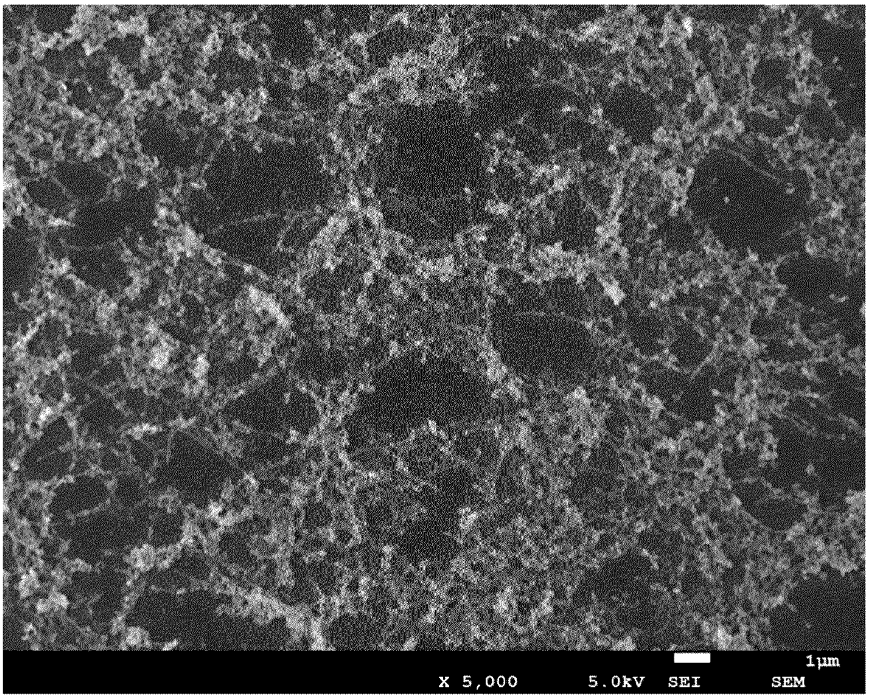


[Fig. 3D]

Example 1 (photograph of plane, reflected electron image) (5,000 times)

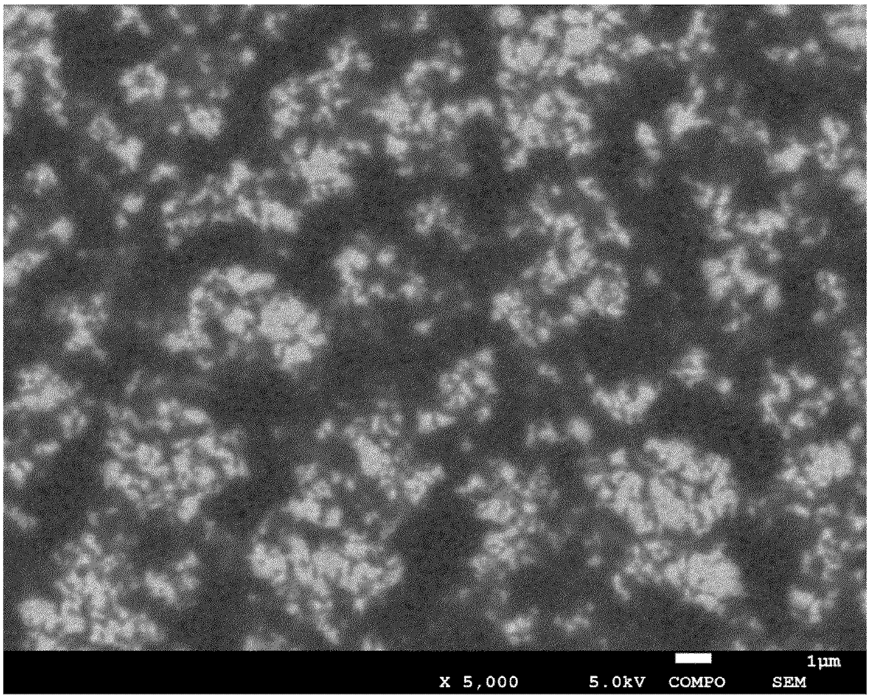

[Fig. 4A]

Example 2 (photograph of cross-section, secondary electron image)

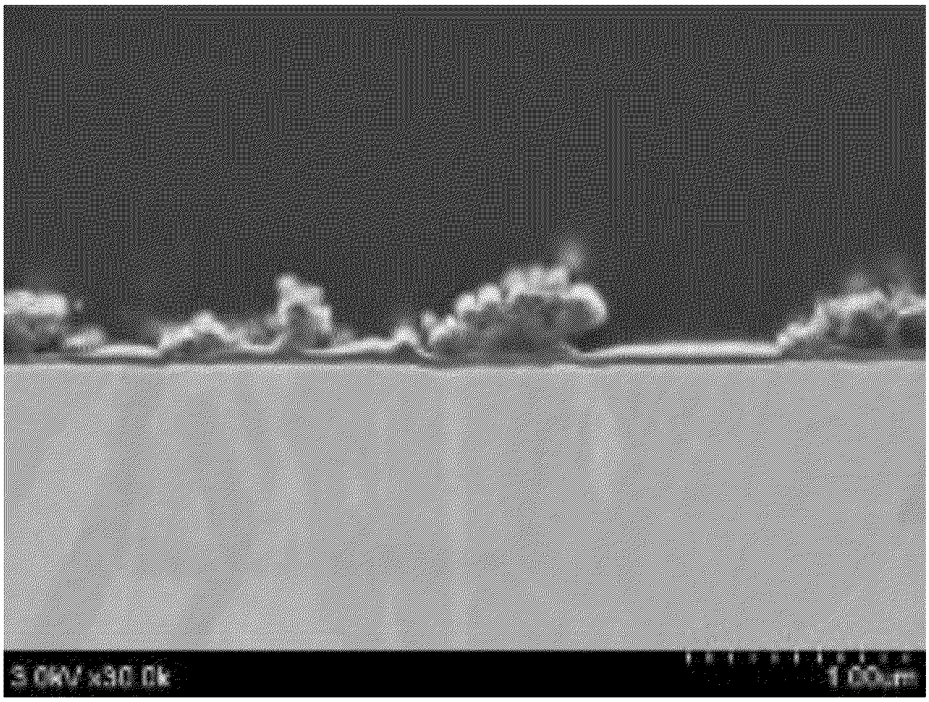

[Fig. 4B]

Example 2 (photograph of plane, secondary electron image) (50,000 times)

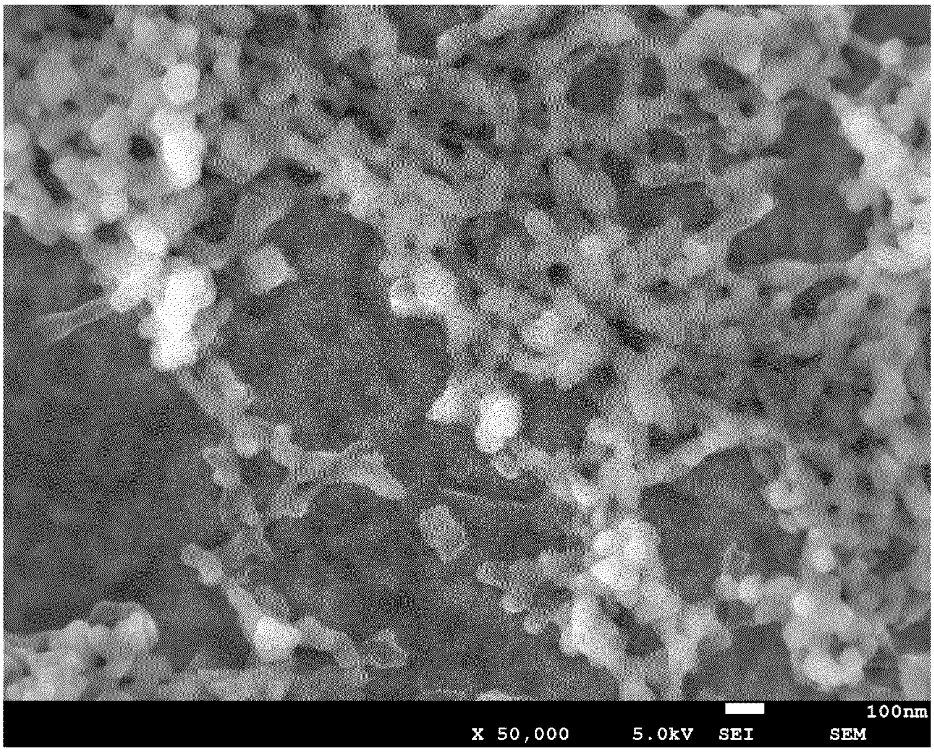

[Fig. 4C]

Example 2 (photograph of plane, secondary electron image) (30,000 times)

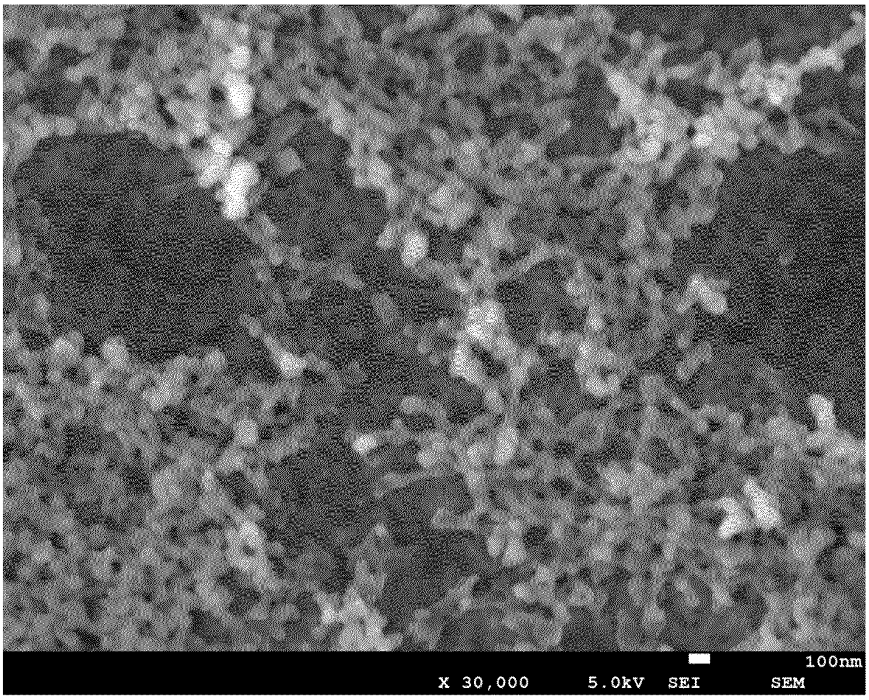


[Fig. 4D]

Example 2 (photograph of plane, secondary electron image) (5,000 times)

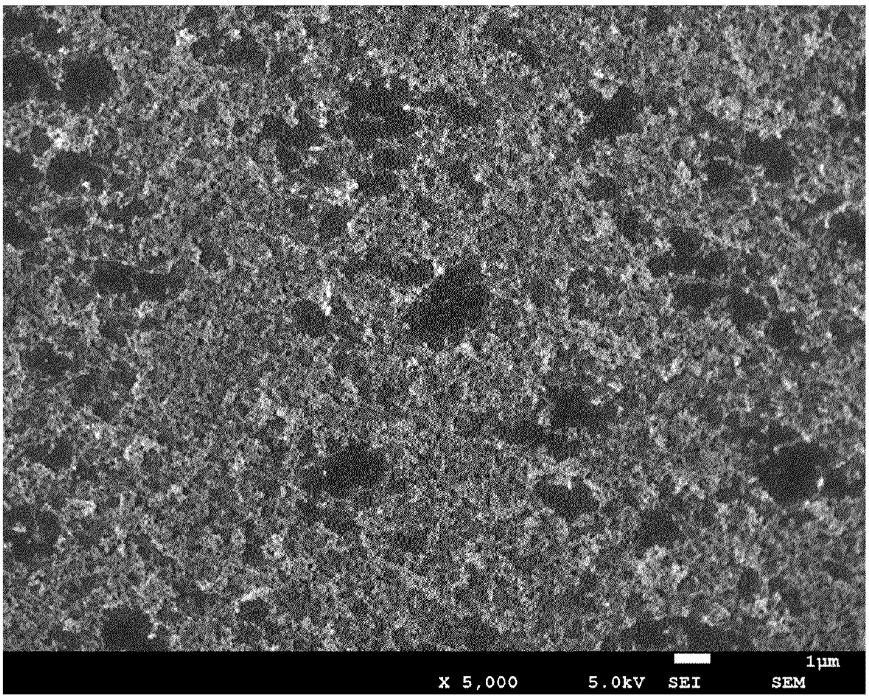

[Fig. 4E]

Example 2 (photograph of plane, reflected electron image) (5,000 times)

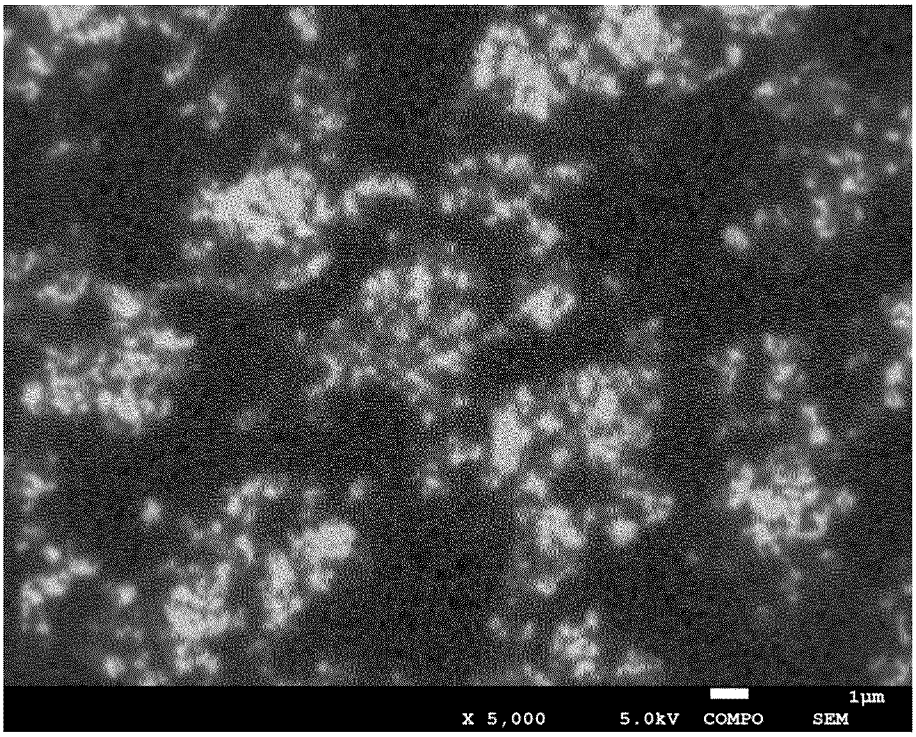

**INTERNATIONAL SEARCH REPORT**

International application No. **PCT/JP2022/047292**

**A. CLASSIFICATION OF SUBJECT MATTER**

***C23C 26/00***(2006.01)i; ***B32B 15/04***(2006.01)i; ***B32B 15/08***(2006.01)i; ***C09D 5/00***(2006.01)i; ***C09D 7/61***(2018.01)i; ***C09D 7/63***(2018.01)i; ***C09D 201/00***(2006.01)i; ***H05K 3/38***(2006.01)i
FI: C23C26/00 A; B32B15/08; B32B15/04 A; C09D5/00 D; C09D7/63; C09D7/61; C09D201/00; H05K3/38 B; B32B15/04

According to International Patent Classification (IPC) or to both national classification and IPC

**B. FIELDS SEARCHED**

Minimum documentation searched (classification system followed by classification symbols)

C23C26/00; B32B15/04; B32B15/08; C09D5/00; C09D7/61; C09D7/63; C09D201/00; H05K3/38

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br>Y | WO 2009/110364 A1 (NIPPON PAINT CO LTD) 11 September 2009 (2009-09-11)<br>claims, paragraphs [0069], [0070], [0086]-[0095], [0108], [0109] | 1-5, 15-17<br><br>6-14 |
| Y | JP 2013-534054 A (ESIONIC 3000 INC) 29 August 2013 (2013-08-29)<br>claim 1, paragraphs [0041]-[0043], [0066], [0071]-[0074], fig. 3, 4 | 6-14 |
| Y | WO 2014/119648 A1 (TOYOBO CO., LTD.) 07 August 2014 (2014-08-07)<br>claims, paragraphs [0017]-[0023], [0091]-[0095] | 6-14 |
| A | WO 2010/010716 A1 (NIPPON PAINT CO LTD) 28 January 2010 (2010-01-28)<br>paragraphs [0051]-[0075] | 1-17 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 March 2023** | **20 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/047292**

| Patent document cited in search report | Publication date (day/month/year) | Patent family member(s) | Publication date (day/month/year) |
|---|---|---|---|
| WO 2009/110364 A1 | 11 September 2009 | TW 200938657 A | |
| JP 2013-534054 A | 29 August 2013 | US 2012/0125514 A1<br>claim1, paragraphs [0052]-[0054], [0077], [0082]-[0085], fig. 3, 4<br>WO 2012/005723 A1<br>EP 2591645 A1<br>CN 103120037 A<br>KR 10-2013-0052608 A | |
| WO 2014/119648 A1 | 07 August 2014 | TW 201434629 A | |
| WO 2010/010716 A1 | 28 January 2010 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6779557 B
- WO 2009110364 A1
- WO 2021045055 A1
- WO 2018186476 A
- US 20120021232 A
- WO 2019058773 A